# EUROPEAN PATENT APPLICATION

(11) **EP 4 730 315 A1**
(43) Date of publication of application: **22.04.2026**
(21) Application number: 25210030.0
(22) Date of filing: 21.10.2025
(51) Int. Cl.: G09G 3/3233, H10K 59/121, H10K 59/131

(54) **DISPLAY PANEL AND ELECTRONIC APPARATUS INCLUDING THE SAME**

(30) Priority: 21.10.2024 KR 20240144315
(71) Applicant: Samsung Display Co., Ltd., Yongin-si, Gyeonggi-do 17113 (KR)
(72) Inventor: Kim, Sunghwan, 17113 Giheung-gu, Yongin-si, Gyeonggi-do (KR); Bae, Hansung, 17113 Giheung-gu, Yongin-si, Gyeonggi-do (KR); Jeong, Keukjin, 17113 Giheung-gu, Yongin-si, Gyeonggi-do (KR)
(74) Representative: Dr. Weitzel & Partner

(57) **Abstract**

Provided is a display panel that displays high-quality images, and an electronic apparatus including the same, wherein the display panel includes first driving voltage lines (PL1) and second driving voltage lines (PL2) alternately arranged in a first direction in a display area and extending in a second direction intersecting the first direction, first-color pixel circuits (PXA1) and third-color pixel circuits (PXA3) alternately arranged in the second driving voltage lines, and second-color pixel circuits (PXA2) arranged in the first driving voltage lines, wherein the first-color pixel circuits and the second-color pixel circuits are electrically connected to the first driving voltage lines, and the third-color pixel circuits are electrically connected to the second driving voltage lines.

## Description

The present invention relates to a display panel and an electronic apparatus including the display panel, and more particularly, to a display panel capable of displaying high-quality images and an electronic apparatus including the display panel.

Display panels have been used in various electronic apparatuses. To display higher-quality images at higher resolutions, pixel sizes have been reduced, and thus, it is required to dispose a variety of electronic elements in a small area.

In a display panel and an electronic apparatus including the display panel according to the related art, as the size of a pixel is reduced, an area of a pixel of a specific color cannot be sufficiently secured.

One or more embodiments include a display panel capable of displaying high-quality images and an electronic apparatus including the display panel. However, such a technical objective is just an example, and the invention is not limited thereto.

The invention is defined by the features of the independent claims. The dependent claims describe preferred embodiments. Additional aspects will be set forth in part in the description which follows and, in part, will be apparent from the description, or may be learned by practice of the presented embodiments of the invention.

According to one or more embodiments, a display panel may include first driving voltage lines and second driving voltage lines alternately arranged in a first direction in a display area and extending in a second direction intersecting the first direction, first-color pixel circuits and third-color pixel circuits alternately arranged along the second driving voltage lines, and second-color pixel circuits arranged along the first driving voltage lines, wherein the first-color pixel circuits and the second-color pixel circuits are electrically connected to the first driving voltage lines, and the third-color pixel circuits are electrically connected to the second driving voltage lines.

An electrical potential of a second driving voltage supplied through the second driving voltage lines may be different from an electrical potential of a first driving voltage supplied through the first driving voltage lines.

An electrical potential of a second driving voltage supplied through the second driving voltage lines may be greater than an electrical potential of a first driving voltage supplied through the first driving voltage lines.

Each of the first-color pixel circuits may be electrically connected to a corresponding one of the first driving voltage lines through an adjacent one of the second-color pixel circuits disposed in a same row.

A set including pixel circuits arranged in the first direction in an order of a third-color pixel circuit, a second-color pixel circuit, a first-color pixel circuit, and a second-color pixel circuit may be repeatedly arranged in the first direction, wherein the first-color pixel circuit in the set may be electrically connected to a corresponding one of the first driving voltage lines through the second-color pixel circuit disposed in an opposite side of the third-color pixel circuit with respect to the first-color pixel circuit in the set.

Emission control transistors of the first-color pixel circuits and emission control transistors of the second-color pixel circuits may be electrically connected to the first driving voltage lines, and emission control transistors of the third-color pixel circuits may be electrically connected to the second driving voltage lines.

An emission control transistor of each of the first-color pixel circuits may be electrically connected to an adjacent one of the second-color pixel circuits disposed in a same row, and accordingly, electrically connected to a corresponding one of the first driving voltage lines.

A set including pixel circuits arranged in the first direction in an order of a third-color pixel circuit, a second-color pixel circuit, a first-color pixel circuit, and a second-color pixel circuit may be repeatedly arranged in the first direction, wherein an emission control transistor of the first-color pixel circuit in the set may be electrically connected to an emission control transistor of the second-color pixel circuit disposed in an opposite side of the third-color pixel circuit with respect to the first-color pixel circuit in the set, and accordingly, electrically connected to a corresponding one of the first driving voltage lines.

Driving transistors of the first-color pixel circuits and driving transistors of the second-color pixel circuits may be electrically connected to the first driving voltage lines, and driving transistors of the third-color pixel circuits may be electrically connected to the second driving voltage lines.

A driving transistor of each of the first-color pixel circuits may be electrically connected to a driving transistor of an adjacent one of the second-color pixel circuits disposed in a same row, and accordingly, electrically connected to a corresponding one of the first driving voltage lines.

A set including pixel circuits arranged in the first direction in an order of a third-color pixel circuit, a second-color pixel circuit, a first-color pixel circuit, and a second-color pixel circuit may be repeatedly arranged in the first direction, wherein a driving transistor of the first-color pixel circuit in the set may be electrically connected to a driving transistor of the second-color pixel circuit disposed in an opposite side of the third-color pixel circuit with respect to the first-color pixel circuit in the set, and accordingly, electrically connected to a corresponding one of the first driving voltage lines.

The display panel may further include first connection lines and second connection lines alternately arranged in the second direction and extending in the first direction, wherein each of the first connection lines may be electrically connected to the first driving voltage lines, and each of the second connection lines may be electrically connected to the second driving voltage lines, and the first connection lines and the second connection lines may be disposed over the first driving voltage lines and the second driving voltage lines.

The first connection lines and the second connection lines may be disposed over the first driving voltage lines and the second driving voltage lines.

Each of the first connection lines may have sets repeatedly arranged in the first direction, wherein each of the sets includes extension portions arranged in the first direction in an order of a first extension portion corresponding to a first-color pixel electrode, a second extension portion corresponding to a second-color pixel electrode, a third extension portion corresponding to a third-color pixel electrode, and a second extension portion corresponding to a second-color pixel electrode, and each of the second connection lines may have sets repeatedly arranged in the first direction, wherein each of the sets includes extension portions disposed in the first direction in an order of a third extension portion corresponding to a third-color pixel electrode, a second extension portion corresponding to a second-color pixel electrode, a first extension portion corresponding to a first-color pixel electrode, and a second extension portion corresponding to a second-color pixel electrode.

The first connection lines and the second connection lines may be disposed below the first driving voltage lines and the second driving voltage lines.

Each of the third-color pixel circuits may include an initialization transistor having one end electrically connected to a pixel electrode, and a connection electrode electrically connecting another end of the initialization transistor to an initialization voltage line and disposed below the first connection lines and the second connection lines.

Each of the first-color pixel circuits may be electrically connected to a corresponding one of the first connection lines.

Each of the first-color pixel circuits may include an emission control transistor and a connection electrode electrically connecting the emission control transistor to a corresponding one of the first connection lines, and the connection electrode, the first driving voltage lines, and the second driving voltage lines are disposed on a same layer.

The display panel may further include a first-color pixel electrode electrically connected to each of the first-color pixel circuits, a second-color pixel electrode electrically connected to each of the second-color pixel circuits, a third-color pixel electrode electrically connected to each of the third-color pixel circuits, and a common electrode disposed over the first-color electrode, the second-color electrode, and the third-color electrode, the common electrode being integrally formed as a single body, wherein a first-color emission layer may be disposed between the first-color pixel electrode and the common electrode, a second-color emission layer may be disposed between the second-color pixel electrode and the common electrode, and a plurality of third-color emission layers and a charge generation layer disposed between the plurality of third-color emission layers may be disposed between the third-color pixel electrode and the common layer.

According to one or more embodiments, an electronic apparatus may include a display panel, and a lower cover forming an exterior of the electronic apparatus and having an opening exposing a portion of the display panel, wherein the display panel includes first driving voltage lines and second driving voltage lines alternately arranged in a first direction in a display area and extending in a second direction intersecting the first direction, first-color pixel circuits and third-color pixel circuits alternately arranged along the second driving voltage lines, and second-color pixel circuits arranged along the first driving voltage lines, wherein the first-color pixel circuits and the second-color pixel circuits are electrically connected to the first driving voltage lines, and the third-color pixel circuits are electrically connected to the second driving voltage lines.

An electrical potential of a second driving voltage supplied through the second driving voltage lines may be different from an electrical potential of a first driving voltage supplied through the first driving voltage lines.

These and/or other aspects will become apparent and more readily appreciated from the following description of the embodiments, the accompanying drawings, and claims.

The above and other aspects, features, and advantages of certain embodiments of the invention will be more apparent from the following description taken in conjunction with the accompanying drawings, in which:
FIG. 1 is a schematic perspective view of an electronic apparatus according to an embodiment;
FIG. 2 is an exploded schematic perspective view of the electronic apparatus of FIG. 1;
FIG. 3 is a schematic diagram of the electronic apparatus of FIG. 1;
FIG. 4 is a schematic plan view of a display panel according to an embodiment;
FIG. 5 is a schematic side view of the display panel of FIG. 4;
FIG. 6 is a schematic plan view of the display panel of FIG. 4;
FIG. 7 is an enlarged schematic view of a region A of the display panel of FIG. 6;
FIG. 8 is an enlarged schematic view of a portion of a display panel according to an embodiment;
FIG. 9 is a schematic arrangement view of emission areas of a plurality of pixels included in a display panel according to an embodiment;
FIG. 10 is a schematic view of a configuration of a light-emitting element of the display panel of FIG. 9;
FIG. 11 is a schematic view of a configuration of another light-emitting element of the display panel of FIG. 9;
FIG. 12 is a schematic diagram of an equivalent circuit that may be electrically connected to the light-emitting element of FIG. 10;
FIG. 13 is a schematic diagram of an equivalent circuit that may be electrically connected to the light-emitting element of FIG. 11;
FIG. 14 is a schematic arrangement view showing positions of transistors, capacitors, and the like in pixels included in the display panel of FIG. 9;
FIGS. 15 to 22 are schematic arrangement views of elements such as transistors and capacitors, for each layer, of the display panel shown in FIG. 14;
FIG. 23 is a schematic arrangement view of pixel electrodes of the display panel of FIG. 9;
FIG. 24 is a schematic cross-sectional view of the display panel, taken along lines A-A' and B-B' of FIG. 14;
FIGS. 25 to 29 are schematic arrangement views of elements such as transistors and capacitors, for each layer, of a display panel according to an embodiment;
FIG. 30 is a schematic arrangement view of a second source-drain layer of a display panel according to an embodiment;
FIGS. 31 and 32 are schematic diagrams of equivalent circuits that may be electrically connected to light-emitting elements of a display panel according to an embodiment;
FIG. 33 is a schematic arrangement view showing positions of transistors, capacitors and the like in pixels included in the display panel having the pixel circuits of FIGS. 31 and 32;
FIGS. 34 to 37 are schematic arrangement views of elements such as transistors and capacitors, for each layer, of the display panel shown in FIG. 33;
FIG. 38 is a schematic arrangement view of pixel electrodes of the display panel having the arrangement view of FIG. 33;
FIGS. 39 and 40 are schematic diagrams of equivalent circuits that may be electrically connected to light-emitting elements of a display panel according to an embodiment; and
FIGS. 41 and 42 are schematic diagrams of equivalent circuits that may be electrically connected to light-emitting elements of a display panel according to an embodiment.

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the invention. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. For the purposes of this invention, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the invention.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art. For example, "about" may mean within one or more standard deviations, or within ±20%, ±10%, or ±5% of the stated value.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

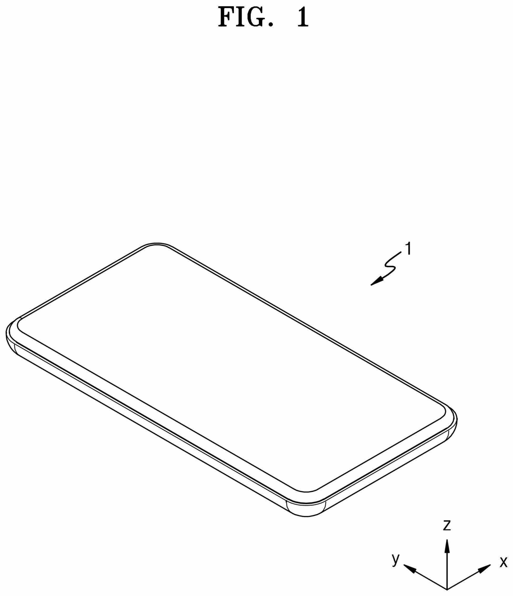

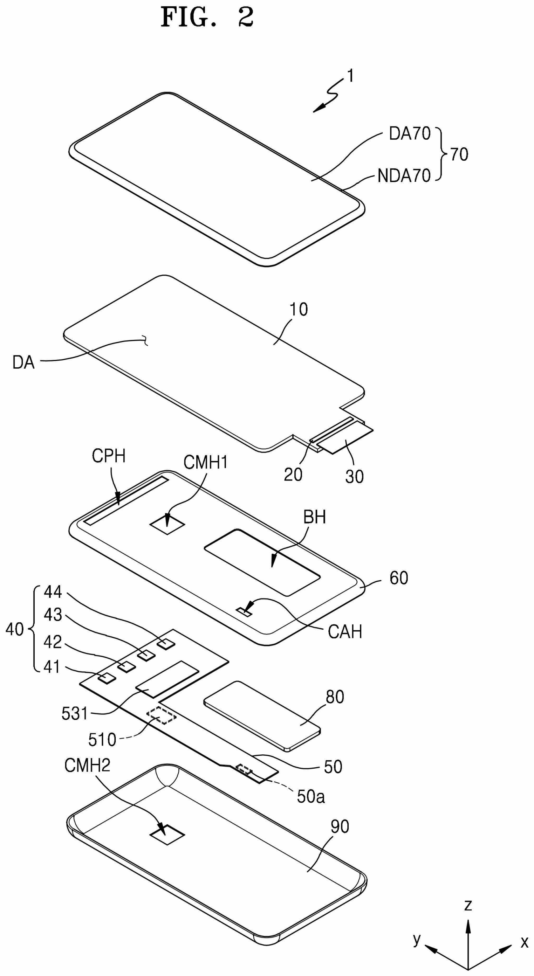

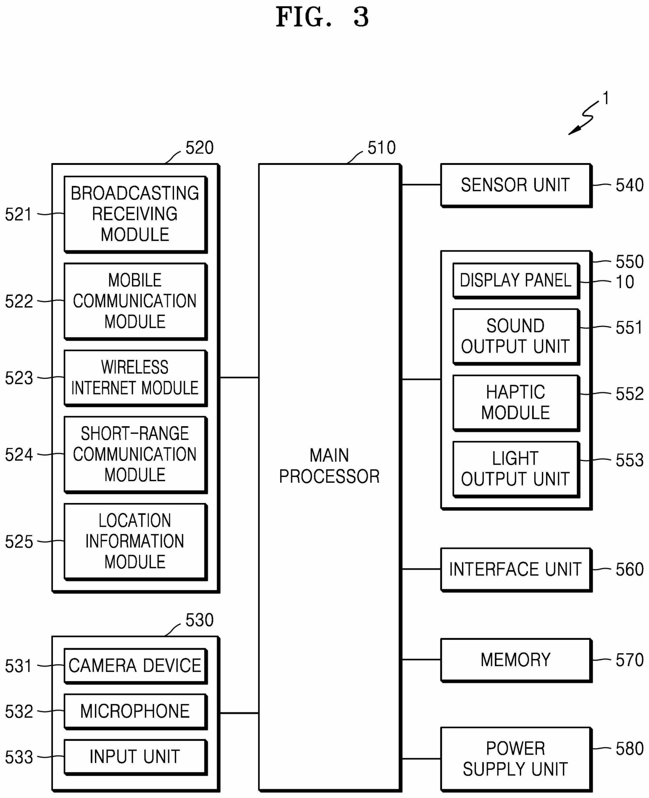

FIG. 1 is a schematic perspective view of an electronic apparatus 1 according to an embodiment, FIG. 2 is an exploded schematic perspective view of the electronic apparatus 1 of FIG. 1, and FIG. 3 is a schematic diagram of the electronic apparatus 1 of FIG. 1.

Referring to FIGS. 1 and 2, the electronic apparatus 1 may include an apparatus for displaying moving images or still images and may be a television, notebook computer, monitor, advertisement board, Internet of Things (IoT) device as well as a portable electronic apparatus such as a mobile phone, smart phone, tablet personal computer (PC), mobile communication terminal, electronic organizer, electronic book, portable multimedia player (PMP), navigation device, or ultra mobile personal computer (UMPC). The electronic apparatus 1 may be a wearable device such as a smartwatch, watchphone, glasses-type display, or head-mounted display (HMD). The electronic apparatus 1 may be an instrument panel for automobiles, center fascia for automobiles, or center information display (CID) arranged on a dashboard, a room mirror display that replaces side mirrors of automobiles, and a display arranged on the backside of front seats as an entertainment for back seats of automobiles.

For convenience of description, it is shown in FIGS. 1 and 2 that the electronic apparatus 1 according to an embodiment may be a smartphone. The electronic apparatus 1 may include a cover window 70, a display panel 10, a data driver 20, a display circuit board 30, a component 40, a bracket 60, a main circuit board 50, a battery 80, and/or a lower cover 90.

The electronic apparatus 1 may include a computing system providing an image display function, such as a smart watch, a mobile phone, a smart phone, a portable computer, a tablet personal computer (PC), a watch phone, an automotive display, smart glasses, a portable multimedia player (PMP), a navigation device, and an ultra mobile personal computer (UMPC). The display system 1000 may include at least one of a head mounted display (HMD) device, a virtual reality (VR) device, a mixed reality (MR) device, and an augmented reality (AR) device.

In a plan view, "left", "right", "up", and "down" denote directions when the display panel 10 is viewed in a direction perpendicular to the display panel 10 (or in a plan view). For example, "left" denotes a -x direction, "right" denotes a +x direction, "up" denotes a +y direction, and "down" denotes a -y direction.

The electronic apparatus 1 may have a roughly rectangular shape in a plan view. For example, as shown in FIG. 1, the electronic apparatus 1 may have a roughly rectangular shape having short sides in an x-axis direction and long sides in a y-axis direction in an xy-plane. For example, an edge where a short side in the x-axis direction meets a long side in the y-axis direction may form a right angle or have a round shape with a preset curvature. In a plan view, the shape of the electronic apparatus 1 is not limited to a rectangle and may include other polygonal, elliptical, or irregular shapes.

The cover window 70 may be disposed over the display panel 10 to cover the upper surface of the display panel 10. The cover window 70 may protect the upper surface of the display panel 10.

The cover window 70 may include a transparent cover unit DA70 corresponding to the display panel 10 and a light-shielding cover unit NDA70 surrounding the transparent cover unit DA70. The light-shielding cover unit NDA70 may include an opaque material (e.g., a colored opaque material) that blocks light. The light-shielding cover unit NDA70 may include a pattern that is visible to a user in case that no image is displayed.

The display panel 10 may be disposed under the cover window 70. The display panel 10 may overlap the transparent cover unit DA70 of the cover window 70. The display panel 10 may include a display area DA. The display area DA, which is an area where images are displayed, may include an area (hereinafter, referred to as "a component area") through which light emitted from the component 40 disposed below the display panel 10 passes. The component 40 may include a sensor that uses visible light, an infrared ray, sound, and the like, and a camera.

The display panel 10 may be a light-emitting display panel including a light-emitting diode. The light-emitting diode may be an organic light-emitting diode including an organic light-emitting layer or an inorganic light-emitting diode including an inorganic material. The inorganic light-emitting diode may include a PN diode including inorganic material semiconductor-based materials. In case that a forward voltage is applied to a PN-junction diode, holes and electrons are injected and energy created by recombination of the holes and the electrons is converted into light energy, and thus, light of a preset color may be emitted. The inorganic light-emitting diode may have a width of several micrometers to hundreds of micrometers. The inorganic light-emitting diodes may be referred to as micro light-emitting diodes (LEDs).

The display panel 10 may be a rigid display panel that has rigidity and thus is not readily bent, or a flexible display panel that has flexible and thus is readily bendable, foldable, or rollable. For example, the display panel 10 may include a foldable display panel that is foldable and unfoldable, a curved display panel that has a curved display surface, a bended display panel in which a region except a display surface is bent, a rollable display panel that is rollable and unrollable, and a stretchable display panel that is stretchable.

The display panel 10 may be implemented transparent and be a transparent display panel such that an object or background disposed below the display panel 10 is viewable from the upper surface of the display panel 10. In another embodiment, the display panel 10 may be a reflective display panel that may reflect an object or background over the upper surface of the display panel 10.

The data driver 20 may be mounted on the display panel 10 in the form of an integrated circuit (IC). However, the invention is not limited thereto. For example, the data driver 20 may be mounted on the display circuit board 30.

The display circuit board 30 may be attached to one side of the display panel 10. The display circuit board 30 may be a flexible printed circuit board (FPCB) that may be bent, a rigid printed circuit board (PCB) that is rigid and is not readily bendable, or a composite printed circuit board including both an FPCB and a rigid PCB. A touch sensor driver may be mounted on the display circuit board 30. The touch sensor driver may include an IC. The touch sensor driver may be electrically connected to touch electrodes of a touchscreen layer of the display panel 10 through the display circuit board 30.

The touchscreen layer of the display panel 10 may sense a user's touch input by using at least one of various touch methods such as a resistance layer method, a capacitance method and the like. For example, in the case where the touchscreen layer of the display panel 10 senses a user's touch input by using a capacitance method, the touch sensor driver may determine whether a user touches the touchscreen layer by applying driving signals to driving electrodes among touch electrodes, and sensing voltages charged in a mutual capacitance between the driving electrodes and the sensing electrodes through the sensing electrodes among the touch electrodes.

A user's touch may include a contact touch and a proximity touch. A contact touch may denote that an object such as a user's finger or a pen is in direct contact with the cover window 70 disposed on the touchscreen layer. A proximity touch, like hovering, denotes that an object such as a user's finger or a pen is disposed near over the cover window 70, away from the cover window 70. The touch sensor driver may transfer sensor data to a main processor 510 according to sensed voltages, and the main processor 510 may calculate touch coordinates at which a touch input occurs by analyzing the sensor data.

A controller may be disposed on the display circuit board 30, where the controller may supply driving voltages for driving pixels of the display panel 10, a gate driver, and/or the data driver 20.

The bracket 60 for supporting the display panel 10 may be disposed under the display panel 10. The bracket 60 may include plastic, metal, or both plastic and metal. The bracket 60 may have a first camera hole CMH1 into which a camera device 531 is inserted, a battery hole BH in which the battery 80 is disposed, a cable hole CAH through which a cable connected to the display circuit board 30 passes, and a component hole CPH corresponding to the components 40. The component hole CPH may overlap the components 40 of the main circuit board 50 in a plan view. For reference, the display area DA of the display panel 10 may overlap the components 40 of the main circuit board 50 in a plan view. When needed, the bracket 60 may not have the component hole CPH.

The components 40 of the electronic apparatus 1 may include a first component 41, a second component 42, a third component 43, and a fourth component 44 which overlap the display panel 10. Each of the first component 41, the second component 42, the third component 43, and the fourth component 44 may include at least one of a proximity sensor, an illumination sensor, an iris sensor, a face recognition sensor, and a camera (or image sensor). A proximity sensor that uses an infrared ray may detect an object disposed close to the upper surface of the electronic apparatus 1, and an illumination sensor may detect brightness of light incident to the upper surface of the electronic apparatus 1. An iris sensor may capture a person's iris disposed over the upper surface of the electronic apparatus 1, and a camera may receive image data of an object disposed on the upper surface of the electronic apparatus 1. The components 40 are not limited to the proximity sensor, the illumination sensor, the iris sensor, the face recognition sensor, and the camera, and may include other sensors.

The main circuit board 50 and the battery 80 may be disposed under the bracket 60. The main circuit board 50 may be a printed circuit board or a flexible printed circuit board.

The main circuit board 50 may include the main processor 510, the camera device 531, a main connector 50a, and the components 40. The main processor 510 may include an integrated circuit. When needed, the electronic apparatus 1 may include not only the camera device 531 disposed on the upper surface of the main circuit board 50 but also a camera device disposed on the lower surface of the main circuit board 50. Each of the main processor 510 and the main connector 50a may be disposed on one of the upper surface and lower surface of the main circuit board 50. The main circuit board 50 may be electrically connected to the display circuit board 30 through the main connector 50a and the like.

The main processor 510 may control all functions of the electronic apparatus 1. For example, the main processor 510 may output digital video data to the data driver 20 through the display circuit board 30 such that the display panel 10 displays images. The main processor 510 may receive sensed data from the touch sensor driver. The main processor 510 may determine whether a user directly touches the touchscreen according to sensed data, and execute an operation corresponding to a user's direct touch or proximity touch. The main processor 510 may be an application processor including an integrated circuit, a central processing unit, or a system chip.

The camera device 531 processes image frames such as still images or moving images obtained by an image sensor in a camera mode, and outputs the image frames to the main processor 510. The camera device 531 may include at least one of a camera sensor (e.g., a charge-coupled device (CCD), a complementary metal oxide semiconductor (CMOS), and the like), a photo sensor (or an image sensor), and a laser sensor.

The cable passing through the cable hole CAH of the bracket 60 may be connected to the main connector 50a, and the main circuit board 50 may be electrically connected to the display circuit board 30 through this cable.

The electronic apparatus 1 may be represented by a block diagram as shown in FIG. 3. The electronic apparatus 1 may be represented as including, in addition to the main processor 510, a wireless communication unit 520, an input unit 530, a sensor unit 540, an output unit 550, an interface unit 560, a memory 570, and/or a power supply unit 580 shown in FIG. 3.

The wireless communication unit 520 may include at least one of a broadcasting receiving module 521, a mobile communication module 522, a wireless Internet module 523, a short-range communication module 524, and a location information module 525.

The broadcasting receiving module 521 may receive broadcasting signals and/or broadcasting-related information from an external broadcasting management server through a broadcasting channel. The broadcasting channel may include satellite channels or groundwave channels.

The mobile communication module 522 may transmit/receive wireless signals to/from at least one of a base station, an external terminal, and a server on a mobile communication network established according to technology standards for mobile communication or communication schemes (e.g., Global System for Mobile communication (GSM), Code Division Multi Access (CDMA), Code Division Multi Access 2000 (CDMA2000), Enhanced Voice-Data Optimized or Enhanced Voice-Data Only (EV-DO), Wideband CDMA (WCDMA), High Speed Downlink Packet Access (HSDPA), High Speed Uplink Packet Access(HSUPA), Long Term Evolution (LTE), Long Term Evolution-Advanced (LTE-A), and the like). Wireless signals may include voice call signals, image communication call signals, or various types of data corresponding to text/multimedia message transmission/reception.

The wireless Internet module 523 denotes a module for wireless Internet access. The wireless Internet module 523 may transmit/receive wireless signals on a communication network according to wireless Internet technologies. Examples of wireless Internet technologies may include wireless local area network (WLAN), wireless-fidelity (Wi-Fi), Wi-Fi Direct, and/or digital living network alliance (DLNA).

The short-range communication module 524 is for short-range communication, and may support short range communication by using at least one of Bluetooth^{®}, Radio Frequency Identification (RFID), Infrared Data Association; IrDA (IrDA), Ultra Wideband (UWB), ZigBee, Near Field Communication (NFC), Wi-Fi, Wi-Fi Direct, and Wireless Universal Serial Bus (Wireless USB) technologies. The short-range communication module 524 may support wireless communication between the electronic apparatus 1 and a wireless communication system, between the electronic apparatus 1 and another electronic apparatus, or between the electronic apparatus 1 and a network in which another electronic apparatus (or an external server) is disposed, through a short-distance wireless area network. The short-distance wireless area network may be a wireless personal area network. The other electronic apparatus may be a wearable device that may exchange data, or operate with the electronic apparatus 1.

The location information module 525, which is a module for obtaining a location of the electronic apparatus 1, may include a global positioning system (GPS) module or a Wi-Fi module.

The input unit 530 may include an image input unit such as the camera device 531 for inputting image signals, a sound input unit such as a microphone 532 for inputting sound signals, and an input unit 533 for receiving information from a user. The camera device 531 processes image frames such as still images or moving images obtained by an image sensor in an image communication mode or a capturing mode. The processed image frames may be displayed on the display panel 10 or stored in the memory 570. The microphone 532 processes external sound signals as electrical voice data. The processed voice data may be variously utilized according to a function (or an application in execution) being performed in the electronic apparatus 1.

The main processor 510 may control an operation of the electronic apparatus 1 to correspond to information input through the input unit 533. The input unit 533 may include a mechanical input means such as buttons, a dome switch, a jog wheel, a jog switch, and the like, or a touch input means disposed on the lower surface or the lateral surface of the electronic apparatus 1. The touch input means may include the touchscreen layer of the display panel 10.

The sensor unit 540 may include at least one sensor that senses at least one of information inside the electronic apparatus 1, peripheral environmental information surrounding the electronic apparatus 1, and user information, and generates sensing signals corresponding thereto. The main processor 510 may control driving or an operation of the electronic apparatus 1 based on the sensing signals, or perform data processing, a function, or an operation related to an application installed in the electronic apparatus 1. The sensor unit 540 may be a proximity sensor, an illumination sensor, or a face recognition sensor as described above with regard to the component 40. The sensor unit 540 may include an acceleration sensor, a magnetic sensor, a G-sensor, a gyroscope sensor, a motion sensor, an RGB sensor, an infrared (IR) sensor, a finger scan sensor, an ultrasonic sensor, an optical sensor, and/or a battery gauge. The sensor unit 540 may include an environmental sensor or a chemical sensor. The environmental sensors may include, for example, a barometer, a hygrometer, a thermometer, a radiation detection sensor, a heat detection sensor, and/or a gas detection sensor. Chemical sensors may include, for example, an electronic nose, a healthcare sensor, and/or a biometric recognition sensor.

The output unit 550 is for generating an output related to a visual sense, an auditory sense, or a tactile sense, and may include at least one of the display panel 10, a sound output unit 551, a haptic module 552, and a light output unit 553.

The display panel 10 displays (outputs) information processed by the electronic apparatus 1. For example, the display panel 10 may display execution screen information of an application driven by the electronic apparatus 1, user interface (UI), or graphic user interface (GUI) information corresponding to the execution screen information. The display panel 10 may include a display layer and the touchscreen layer, where the display layer displays images, and the touchscreen layer senses a user's touch input. Accordingly, the display panel 10 may serve as one of the input units 533 that provide an input interface between the electronic apparatus 1 and a user, and simultaneously, serve as one of the output units 550 that provide an output interface between the electronic apparatus 1 and a user.

The sound output unit 551 may output sound data received by the wireless communication unit 520 or stored in the memory 570 in a call reception mode, a communication mode or recording mode, a voice recognition mode, a broadcasting reception mode, and the like. The sound output unit 551 may output sound signals related to a function (e.g., a call signal reception tone, a message reception tone, and the like) performed by the electronic apparatus 1. The sound output unit 551 may include a receiver and a speaker. At least one of the receiver and the speaker may be a sound generator that is attached under the display panel 10 and vibrates the display panel 10 to output sounds. The sound generator may be a piezoelectric element or a piezoelectric actuator that contacts and expands according to electrical signals, or an exciter that generates magnetic force by using a voice coil to vibrate the display panel 10.

The haptic module 552 generates various haptic effects that may be felt by a user. The haptic module 552 may provide vibrations to a user as a haptic effect. The haptic module 552 may not only transfer a tactile effect through a direct contact but implement a tactile effect such that a user may feel the tactile effect through a muscle sense in fingers or arms.

The light output unit 553 outputs signals for informing occurrence of an event by using light of a light source. Examples of an event generated in the electronic apparatus 1 may include message reception, call signal reception, a missed call, alarm, schedule notification, e-mail reception, and/or information reception through an application, and the like. Signals output by the light output unit 553 are implemented in case that the electronic apparatus 1 emits light of a single color or multiple colors to the front surface or the rear surface. The signal output may end in case that the electronic apparatus 1 detects that a user confirms an event.

The interface unit 560 serves as a path with various kinds of external apparatuses connected to the electronic apparatus 1. The interface unit 560 may include at least one of a wired/wireless headset port, an external charger port, a wired/wireless data port, a memory card part, a port for connecting an apparatus having an identification module, an audio input/output (I/O) port, a video I/O port, and an earphone port. In case that an external apparatus is connected to the interface unit 560, the electronic apparatus 1 may perform an appropriate control related to the external apparatus connected.

The memory 570 stores data that support various functions of the electronic apparatus 1. The memory 570 may store multiple application programs driven in the electronic apparatus 1, data and/or commands for operations of the electronic apparatus 1. At least some of the plurality of application programs may be downloaded from an external server through wireless communication. The memory 570 may store an application program for operations of the main processor 510, and temporarily store data input/output, for example, data such as a phone book, messages, still images, and/or moving images. The memory 570 may store haptic data for various patterns of vibrations provided to the haptic module 552, and sound data regarding various sounds provided to the sound output unit 551.

The memory 570 may include at least one type of storing medium among a flash memory type, a hard disk type, a solid state disk (SSD) type, a silicon disk drive (SDD) type, a multimedia card micro type, a card type memory (e.g., secure digital (SD) or extreme digital (XD) memory), a random access memory (RAM), a static random access memory (SRAM), a read-only memory (ROM), an electrically erasable programmable read-only memory (EEPROM), a programmable read-only memory (PROM), a magnetic memory, a magnetic disk, and an optical disk.

The power supply unit 580 receives an external power and/or an internal power under control of the main processor 510, and supplies power to respective elements included in the electronic apparatus 1. The power supply unit 580 may include the battery 80. The power supply unit 580 may include a connection port. The connection port may be an example of the interface unit 560 to which an external charger is electrically connected, where the external charger supplies power to charge the battery 80. In another embodiment, the power supply unit 580 may charge the battery 80 wirelessly. As shown in in FIG. 2, the battery 80 may be disposed not to overlap the main circuit board 50 in the third direction (e.g., z-axis direction). The battery 80 may overlap the battery hole BH of the bracket 60.

**As** shown in FIG. 2, the lower cover 90 may form the exterior of the electronic apparatus 1, and may have an opening exposing a portion of the display panel 10. The lower cover 90 may be fastened to the display panel 10 such that a surface thereof corresponding to the display panel 10 is exposed. The lower cover 90 may be disposed on the opposite side of the cover window 70 with the display panel 10 therebetween. The lower cover 90 may be disposed under the main circuit board 50 and the battery 80. The lower cover 90 may be fastened and fixed to the bracket 60. The lower cover 90 may form the lower exterior of the electronic apparatus 1. The lower cover 90 may include plastic, metal, or both plastic and metal.

A second camera hole CMH2 through which the lower surface of the camera device 531 is exposed may be formed in the lower cover 90. The positions of the camera device 531 and the first and second camera holes CMH1 and CMH2 corresponding to the camera device 531 are not limited to the embodiment shown in FIGS. 1 and 2, but may be variously modified.

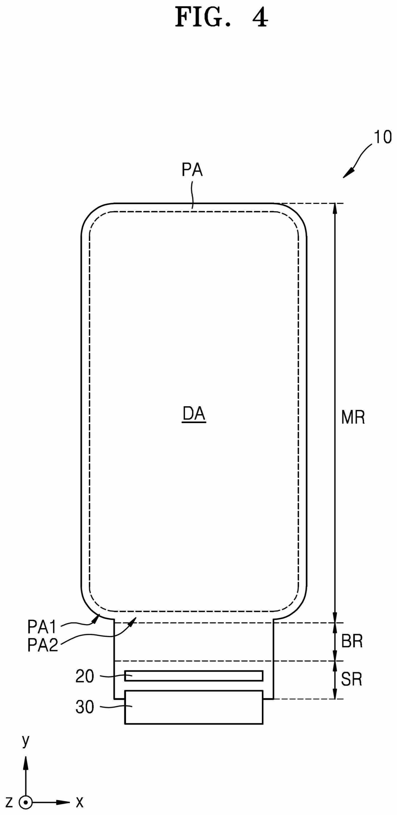

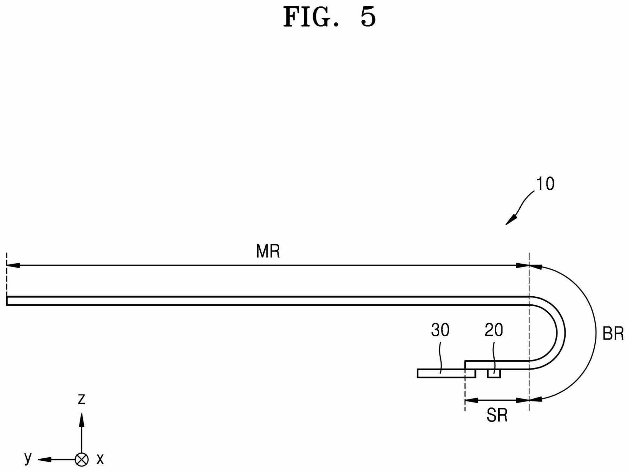

FIG. 4 is a schematic plan view of the display panel 10 according to an embodiment, and FIG. 5 is a schematic side view of the display panel 10 of FIG. 4. The electronic apparatus 1 may include the display panel 10 shown in FIGS. 4 and 5.

The display panel 10 may include the display area DA and a peripheral area PA outside the display area DA. The display area DA is a region in which images are displayed and multiple pixels may be disposed. The display area DA may have various shapes, for example, circular shapes, elliptical shapes, polygonal shapes, or shapes of specific figures. It is shown in FIG. 4 that the display area DA has a roughly rectangular shape having round corners.

The peripheral area PA may be disposed outside (or around) the display area DA. The peripheral area PA may include a first peripheral area PA1 and a second peripheral area PA2, where the first peripheral area PA1 may surround at least a portion of the display area DA, and the second peripheral area PA2 is disposed at the lower end of the display area DA and extends in a first direction (e.g., x-axis direction). The width of the second peripheral area PA2 in the first direction (e.g., x-axis direction) may be less than the width of the display area DA. At least a portion of the second peripheral area PA2 may be easy to bend through this structure.

**A** planar shape of the display panel 10 shown in FIG. 4 may be substantially equal to the shape of a substrate 100 included in the display panel 10. In case that the display panel 10 includes the display area DA and the peripheral area PA disposed outside the display area DA, it may represent the substrate 100 includes the display area DA and the peripheral area PA outside the display area DA. Hereinafter, for convenience, description is made on the assumption that the substrate 100 includes the display area DA and the peripheral area PA.

The display panel 10 may include a main region MR, a bent region BR outside the main region MR, and a sub-region SR apart from the main region MR with the bent region BR therebetween. The main region MR may be disposed on one side of the bent region BR, and the sub-region SR may be disposed on another side of the bent region BR. The display panel 10 may be bent in the bent region BR, as shown in FIG. 5, and in a plan view, at least portion of the sub-region SR may overlap the main region MR. Although it is shown in FIG. 5 that the display panel 10 is bent, the invention is not limited thereto. For example, the display panel 10 may be a foldable display panel, and for example, the display panel 10 may be bent inside the display area DA around a bending axis crossing the display area DA. When needed, the display panel 10 may not be bent. The sub-region SR may be a non-display area.

The data driver 20 may be arranged in the sub-region SR of the display panel 10. The data driver 20 may be disposed on the display panel 10 in the form of an integrated circuit (IC). For example, the data driver 20 may be a data driving integrated circuit generating data signals.

The display circuit board 30 may be attached to an end of the sub-region SR of the display panel 10. The display circuit board 30 may be electrically connected to the data driver 20 or the like through a pad of the sub-region SR of the display panel 10.

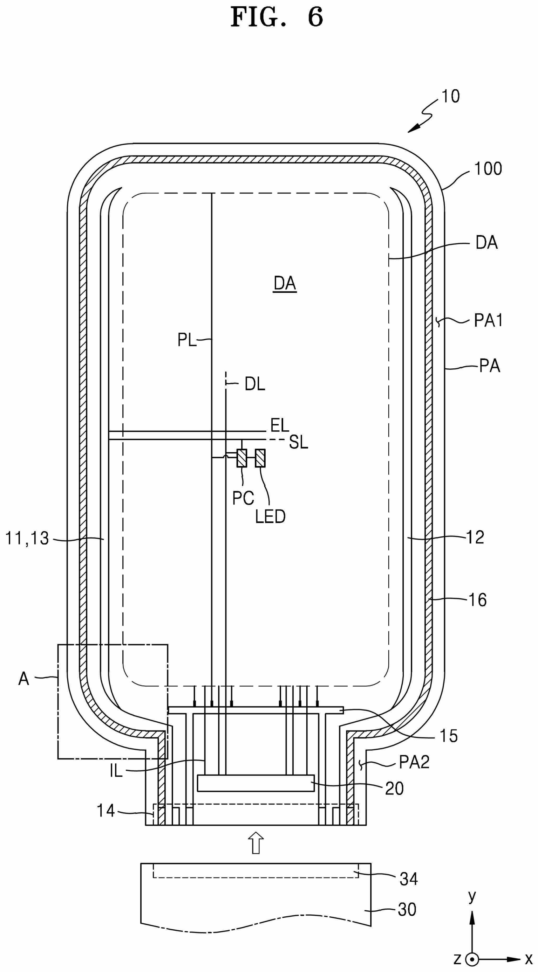

FIG. 6 is a schematic plan view of the display panel 10 of FIG. 4. Referring to FIG. 6, the display panel 10 may include the substrate 100. Various elements forming the display panel 10 may be disposed on the substrate 100.

The substrate 100 may include glass, ceramic, metal, or polymer resin. The substrate 100 may include polymer resin such as polyethersulphone, polyacrylate, polyetherimide, polyethylene naphthalate, polyethylene terephthalate, polyphenylene sulfide, polyarylate, polyimide, polycarbonate, or cellulose acetate propionate. The substrate 100 may have a multi-layered structure including two layers including the above-described polymer resin, and an inorganic material layer disposed therebetween. In another embodiment, the substrate 100 may have a structure in which a layer including the polymer resin and an inorganic material layer are alternately stacked. The inorganic material layer may include silicon oxide, silicon nitride, or silicon oxynitride.

The pixels may be disposed in the display area DA, and the display area DA may display images using light emitted from the pixels. Each pixel may include a light-emitting diode LED, and the light-emitting diode LED may be electrically connected to a pixel circuit PC. The pixel circuit PC and the light-emitting diode LED may be disposed in the display area DA. For convenience, although it is shown in FIG. 6 that the pixel circuit PC and the light-emitting diode LED are disposed side-by-side, the pixel circuit PC may actually at least partially overlap the light-emitting diode LED. For example, the light-emitting diode LED may be disposed on the pixel circuit PC.

**A** gate driving circuit, a pad 14, a power supply line 15, and a common voltage supply line 16 may be disposed in the peripheral area PA. The gate driving circuit may include, for example, a first scan driving circuit 11, a second scan driving circuit 12, and/or an emission control driving circuit 13.

The first scan driving circuit 11 may provide scan signals to the pixel circuit PC through a gate line SL. The second scan driving circuit 12 may be disposed opposite the first scan driving circuit 11 with the display area DA therebetween. Some of the pixel circuits PC disposed in the display area DA may be electrically connected to the first scan driving circuit 11, and the others may be electrically connected to the second scan driving circuit 12. Depending on cases, the second scan driving circuit 12 may be omitted.

Like the first scan driving circuit 11, the emission control driving circuit 13 may be disposed on one side of the display area DA. The emission control driving circuit 13 may provide emission control signals to the pixel circuit PC through an emission control line EL. Although it is shown in FIG. 6 that the emission control driving circuit 13 is disposed on only one side of the display area DA, the invention is not limited thereto. For example, the display panel 10 may include the emission control driving circuits 13 disposed on one side and another side of the display area DA. In another embodiment, the display panel 10 may include the first scan driving circuit 11 disposed on one side of the display area DA, and the emission control driving circuit 13 disposed on another side of the display area DA.

The pad 14 may be disposed in the second peripheral area PA2 of the substrate 100. The pad 14 may be exposed by not being covered by an insulating layer, and may be electrically connected to the display circuit board 30. A pad 34 of the display circuit board 30 may be electrically connected to the pad 14 of the display panel 10.

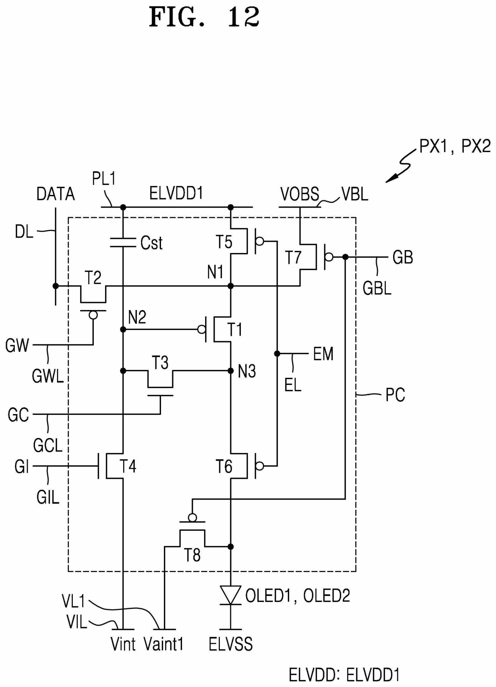

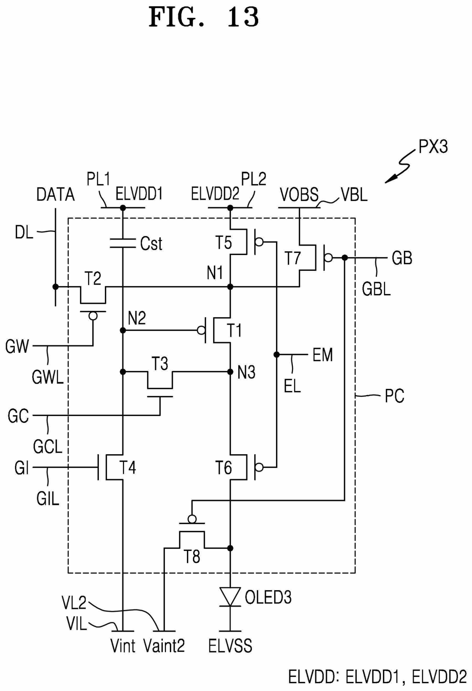

The display circuit board 30 may transfer signals of a controller or power to the display panel 10. Control signals generated by the controller may be transferred to the gate driving circuit through the display circuit board 30. The controller may provide a driving voltage ELVDD (shown in FIGS. 12 and 13) and a common voltage ELVSS (shown in FIGS. 12 and 13) to the power supply line 15 and the common voltage supply line 16, respectively. The driving voltage ELVDD may be provided to each pixel circuit PC through a driving voltage line PL electrically connected to the power supply line 15, and the common voltage ELVSS may be provided to a common electrode of the light-emitting diode LED electrically connected to the common voltage supply line 16. The power supply line 15 may extend in the first direction (x-axis direction). The common voltage supply line 16 may have a loop shape having one open side and partially surround the display area DA.

Data signals of the data driver 20 may be transferred to the pixel circuit PC through the data line DL electrically connected to an input line IL through the input line IL.

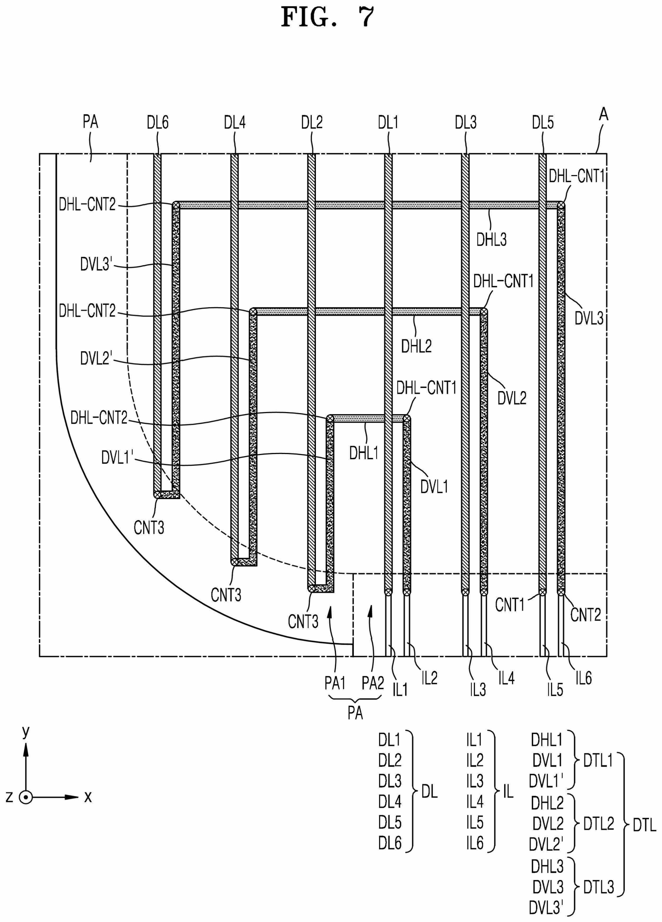

FIG. 7 is an enlarged schematic view of a region A of the display panel 10 of FIG. 6. As shown in FIG. 7, the data line DL extending in the second direction (e.g., y-axis direction) may be disposed in the display area DA, and the input line IL may be disposed in the peripheral area PA. The input line IL may transfer data signals of the data driver 20 to the data line DL. For convenience of illustration, although FIG. 7 shows that the data line DL includes a first data line DL1, a second data line DL2, a third data line DL3, a fourth data line DL4, a fifth data line DL5, and a sixth data line DL6, and the input line IL includes a first input line IL1, a second input line IL2, a third input line IL3, a fourth input line IL4, a fifth input line IL5, and a sixth input line IL6, the number of the data lines DL and the number of the input lines IL may be variously changed.

Some of the data lines DL may be directly connected to a corresponding input line IL, but other of the data lines DL may be electrically connected to a corresponding input line IL through a data transfer line DTL.

The first data line DL1, the third data line DL3, and the fifth data line DL5 may receive data signals from the first input line IL1, the third input line IL3, and the fifth input line IL5. For example, the first data line DL1, the third data line DL3, and the fifth data line DL5 may be electrically connected to the first input line IL1, the third input line IL3, and the fifth input line IL5. Each of the first data line DL1, the third data line DL3, and the fifth data line DL5 may be integrally formed as a single body with a corresponding one of the first input line IL1, the third input line IL3, and the fifth input line IL5. In another embodiment, each of the first data line DL1, the third data line DL3, and the fifth data line DL5 may be electrically connected to a corresponding one of the first input line IL1, the third input line IL3, and the fifth input line IL5 through a first contact hole CNT1, as shown in FIG. 7.

The second data line DL2, the fourth data line DL4, and the sixth data line DL6 may be electrically connected to the second input line IL2, the fourth input line IL4, and the sixth input line IL6 through a first data transfer line DTL1, a second data transfer line DTL2, and a third data transfer line DTL3. For example, the second input line IL2 may be electrically connected to the second data line DL2 through the first data transfer line DTL1, the fourth input line IL4 may be electrically connected to the fourth data line DL4 through the second data transfer line DTL2, and the sixth input line IL6 may be electrically connected to the sixth data line DL6 through the third data transfer line DTL3.

Most of each of the first data transfer line DTL1, the second data transfer line DTL2, and the third data transfer line DTL3 may be disposed in the display area DA. One end of each of the first data transfer line DTL1, the second data transfer line DTL2, and the third data transfer line DTL3 may be electrically connected to a corresponding one of the second input line IL2, the fourth input line IL4, and the sixth input line IL6 through a second contact hole CNT2. Another end of each of the first data transfer line DTL1, the second data transfer line DTL2, and the third data transfer line DTL3 may be electrically connected to a corresponding one of the second data line DL2, the fourth data line DL4, and the sixth data line DL6 through a third contact hole CNT3. For reference, although it is shown in FIG. 7 that the second contact hole CNT2 and the third contact hole CNT3 are disposed in the peripheral area PA, the invention is not limited thereto. For example, the second contact hole CNT2 and/or the third contact hole CNT3 may be disposed in the display area DA.

The first data transfer line DTL1 may include a first horizontal connection line DHL1, a first vertical connection line DVL1, and a first additional vertical connection line DVL1', the second data transfer line DTL2 may include a second horizontal connection line DHL2, a second vertical connection line DVL2, and a second additional vertical connection line DVL2', and the third data transfer line DTL3 may include a third horizontal connection line DHL3, a third vertical connection line DVL3, and a third additional vertical connection line DVL3'. The first horizontal connecting line DHL1, the second horizontal connecting line DHL2, and the third horizontal connecting line DHL3 may extend in the first direction (x-axis direction). The first vertical connection line DVL1, the second vertical connection line DVL2, the third vertical connection line DVL3, the first additional vertical connection line DVL1', the second additional vertical connection line DVL2', and the third additional vertical connection line DVL3' may extend in the second direction (e.g., y-axis direction) and may be substantially parallel to the data line DL.

Each of the second input line IL2, the fourth input line IL4, and the sixth input line IL6 may be electrically connected to a corresponding one of the first vertical connection line DVL1, the second vertical connection line DVL2, and the third vertical connection line DVL3 through the second contact hole CNT2, and each of the second data line DL2, the fourth data line DL4, and the sixth data line DL6 may be electrically connected to a corresponding one of the first additional vertical connection line DVL1', the second additional vertical connection line DVL2', and the third additional vertical connection line DVL3' through the third contact hole CNT3. Each of the first horizontal connecting line DHL1, the second horizontal connecting line DHL2, and the third horizontal connecting line DHL3 may be electrically connected to a corresponding one of the first vertical connecting line DVL1, the second vertical connecting line DVL2, and the third vertical connecting line DVL3 through a first connecting contact hole DHL-CNT1, and may be electrically connected to a corresponding one of the first additional vertical connecting line DVL1', the second additional vertical connecting line DVL2', and the third additional vertical connecting line DVL3' through a second connecting contact hole DHL-CNT2.

The first vertical connecting line DVL1, the second vertical connecting line DVL2, the third vertical connecting line DVL3, the first additional vertical connecting line DVL1', the second additional vertical connecting line DVL2', and the third additional vertical connecting line DVL3' may be disposed on the same first layer, and the first horizontal connecting line DHL1, the second horizontal connecting line DHL2, and the third horizontal connecting line DHL3 may be disposed on a second layer which is different from the first layer. For reference, in case that certain components are disposed on the same layer, those components may be simultaneously formed using the same material through the same mask process.

As described above, FIG. 7 shows that the first data transfer line DTL1 includes a first horizontal connection line DHL1, a first vertical connection line DVL1, and a first additional vertical connection line DVL1', the second data transfer line DTL2 includes a second horizontal connection line DHL2, a second vertical connection line DVL2, and a second additional vertical connection line DVL2', and the third data transfer line DTL3 includes a third horizontal connection line DHL3, a third vertical connection line DVL3, and a third additional vertical connection line DVL3'. However, the invention is not limited thereto.

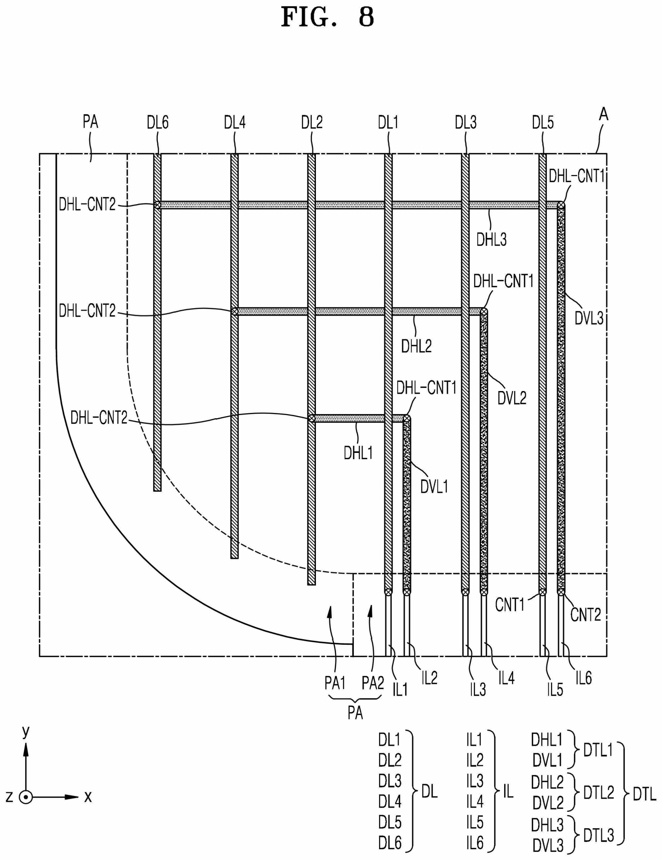

For example, as shown in FIG. 8, which is an enlarged schematic diagram of a portion of the display panel 10 according to an embodiment, a first data transfer line DTL1 may include a first horizontal connection line DHL1 and a first vertical connection line DVL1, a second data transfer line DTL2 may include a second horizontal connection line DHL2 and a second vertical connection line DVL2, and a third data transfer line DTL3 may include a third horizontal connection line DHL3 and a third vertical connection line DVL3. For example, each of the first horizontal connection line DHL1, the second horizontal connection line DHL2, and the third horizontal connection line DHL3 may be electrically connected to a corresponding one of the first vertical connection line DVL1, the second vertical connection line DVL2, and the third vertical connection line DVL3 through the first connection contact hole DHL-CNT1, and may be electrically connected to a corresponding one of the second data line DL2, the fourth data line DL4, and the sixth data line DL6 through the second connection contact hole DHL-CNT2.

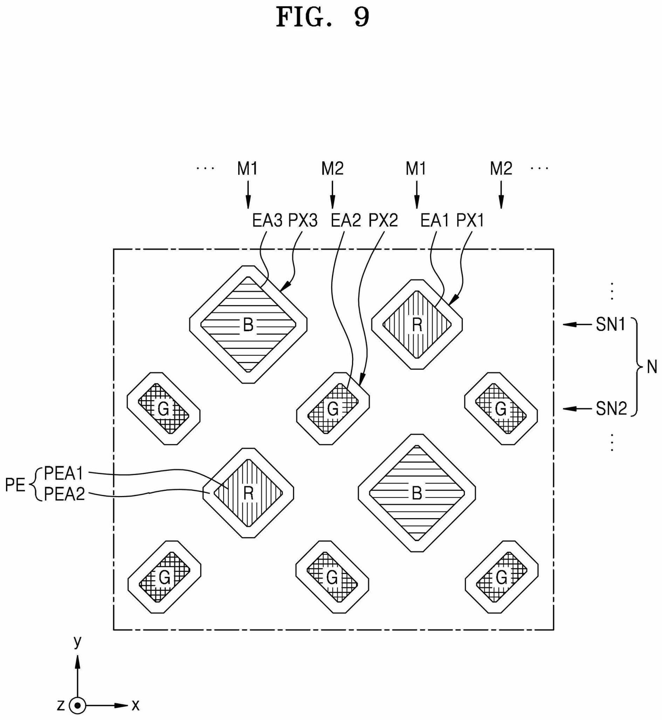

FIG. 9 is a schematic arrangement view of emission areas of multiple pixels included in the display panel 10 and the electronic apparatus 1 including the display panel 10 according to an embodiment.

Multiple pixels disposed in the display area DA may include a first pixel PX1, a second pixel PX2, and a third pixel PX3. The first pixel PX1, the second pixel PX2, and the third pixel PX3 may be repeatedly arranged according a preset pattern in the x-axis direction and the y-axis direction. Each of the first pixel PX1, the second pixel PX2, and the third pixel PX3 may include the pixel circuit and the light-emitting element electrically connected to the pixel circuit. The light-emitting element of each pixel may be disposed on the pixel circuit. For example, the light-emitting element including an organic light-emitting diode may be disposed directly above the pixel circuit to overlap the pixel circuit, or disposed to partially overlap a pixel circuit of another pixel disposed in an adjacent row and/or column offset from the pixel circuit.

FIG. 9 shows an approximate shape of a pixel electrode PE and an emission area of each of the first pixel PX1, the second pixel PX2, and the third pixel PX3. The emission area may be defined as a pixel-defining layer having an opening corresponding to the central portion of the pixel electrode PE. Each pixel electrode PE may include a first area PEA1 corresponding to the emission area and a second area PEA2 surrounding the first area PEA1. The first area PEA1 may correspond to the opening of the pixel-defining layer, and the second area PEA2 may be a region covered by the pixel-defining layer.

A first emission area EA1 of the first pixel PX1, and a third emission area EA3 of the third pixel PX3 may be alternately arranged in the second direction (e.g., y-axis direction), in a first column M1. A second emission area EA2 of the second pixel PX2 may be repeatedly arranged in the second direction (e.g., y-axis direction), in a second column M2. The first column M1 and the second column M2 are alternately disposed in the first direction (e.g., x-axis direction).

The arrangement of the first emission area EA1 of the first pixel PX1 and the third emission area EA3 of the third pixel PX3 in the first column M1 disposed adjacent to a +x direction of the second column M2, may be opposite to the arrangement of the first emission area EA1 of the first pixel PX1 and the third emission area EA3 of the third pixel PX3 in the first column M1 disposed adjacent to a -x direction of the second column M2. Accordingly, the first emission area EA1 of the first pixel PX1 and the third emission area EA3 of the third pixel PX3 may be alternately arranged in the first direction (e.g., x-axis direction) in a first sub-row SN1 of each row N. The second emission area EA2 of the second pixel PX2 may be repeatedly arranged in the first direction (e.g., x-axis direction) in a second sub-row SN2 of each row N. For example, in each row N, the first emission area EA1 of the first pixel PX1, the second emission area EA2 of the second pixel PX2, the third emission area EA3 of the third pixel PX3, and the second emission area EA2 of the second pixel PX2 may be repeatedly arranged in a zigzag shape.

The first emission area EA1 of the first pixel PX1, the second emission area EA2 of the second pixel PX2, the third emission area EA3 of the third pixel PX3 may have different areas, respectively, in a plan view. For example, the third emission area EA3 of the third pixel PX3 may be greater than the first emission area EA1 of the first pixel PX1. The area of the third emission area EA3 of the third pixel PX3 may be greater than the area of the second emission area EA2 of the second pixel PX2. The area of the first emission area EA1 of the first pixel PX1 may be greater than the area of the second emission area EA2 of the second pixel PX2.

The first emission area EA1, the second emission area EA2, and the third emission area EA3 may have a polygonal shape such as a quadrangle or octagon, a circular shape, or an elliptical shape. The polygonal shape may have rounded corners (vertexes).

The first pixel PX1 may be a red pixel R that emits red light, the second pixel PX2 may be a green pixel G that emits green light, and the third pixel PX3 may be a blue pixel B that emits red light.

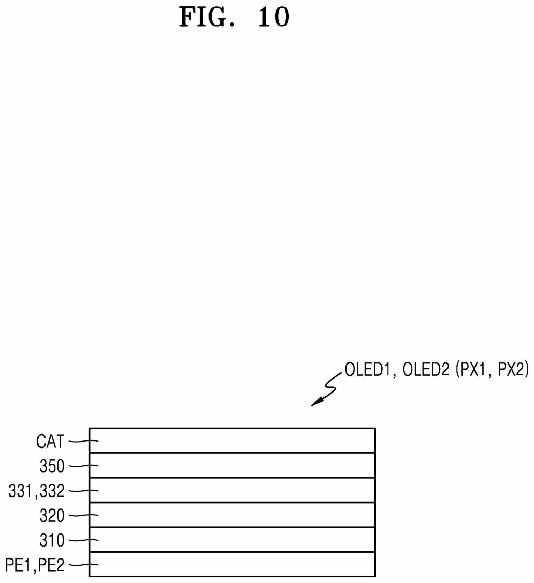

FIG. 10 is a schematic view of a configuration of a light-emitting element of the display panel 10 of FIG. 9. For example, FIG. 10 is a schematic view of a configuration of a first light-emitting element OLED1 or a second light-emitting element OLED2 included in the first pixel PX1 or second pixel PX2 of the display panel 10 of FIG. 9. The first light-emitting element OLED1 may emit red light, and the second light-emitting element OLED2 may emit green light.

**As** shown in FIG. 10, the first light-emitting element OLED1 may have a structure in which various layers including a first emission layer, which may be a first-color emission layer, are disposed between a first pixel electrode PE1, which may be a first-color pixel electrode, and a common electrode CAT, and the second light-emitting element OLED2 may also have a structure in which various layers including a second emission layer, which may be a second-color emission layer, are disposed between a second pixel electrode PE2, which may be a second-color pixel electrode, and the common electrode CAT. Because the layer structure of the first light-emitting element OLED1 may be equal or similar to the layer structure of the second light-emitting element OLED2, the layer structure of the first light-emitting element OLED1 is described below, for convenience.

A hole injection layer 310 and a hole transport layer 320 may be disposed on the first pixel electrode PE1. A first emission layer 331, which is the first-color emission layer corresponding to the first pixel electrode PE1, may be disposed on the hole transport layer 320. When needed, an auxiliary hole transport layer may be disposed between the first emission layer 331 that emits red light and the hole transport layer 320. Because the auxiliary hole transport layer has a preset thickness determined according to a resonance period of light emitted from the first emission layer 331, the auxiliary hole transport layer may improve color purity of light emitted from the first emission layer 331, or improve an emission efficiency from the first pixel PX1. Even in case of the second light-emitting element OLED2 including a second emission layer 332 corresponding to the second pixel electrode PE2, an auxiliary hole transport layer may be disposed between the second emission layer 332 and the hole transport layer 320. Because the auxiliary hole transport layer has a preset thickness determined according to a resonance period of light emitted from the second emission layer 332, the auxiliary hole transport layer may improve color purity of light emitted from the second emission layer 332, or improve an emission efficiency from the second pixel PX2.

An electron transport layer 350 may be disposed on the first emission layer 331 and the second emission layer 332. A buffer layer may be disposed between the first emission layer 331 and the electron transport layer 350 and/or between the second emission layer 332 and the electron transport layer 350. The common electrode CAT which is integrally formed as a single body throughout the light-emitting elements may be disposed on the electron transport layer 350.

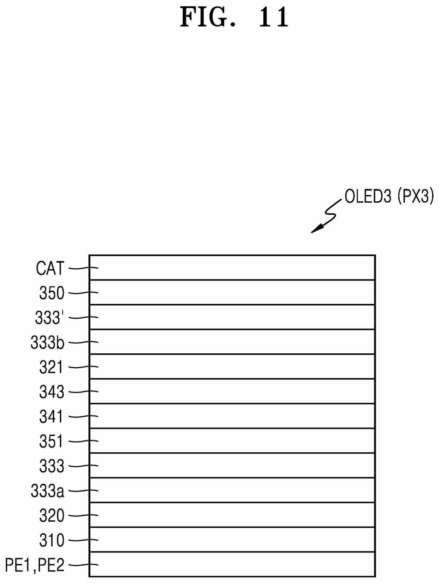

FIG. 11 is a schematic view of a configuration of another light-emitting element of the display panel 10 of FIG. 9. For example, FIG. 11 is a schematic view of a configuration of a third light-emitting element OLED3 included the third pixel PX3 of the display panel 10 of FIG. 9. The third light-emitting element OLED3 may be a light-emitting element emitting blue light.

The hole injection layer 310 and the hole transport layer 320 may be disposed on a third pixel electrode PE3 which is a third-color pixel electrode. A third emission layer 333, which is a third-color emission layer that emits blue light corresponding to the third pixel electrode PE3, may be disposed on the hole transport layer 320. A blue auxiliary layer 333a may be disposed between the hole transport layer 320 and the third emission layer 333. The blue auxiliary layer 333a may improve a light generation efficiency of the third emission layer 333 by adjusting a hole charge balance.

For reference, a portion of the hole injection layer 310 disposed on the first pixel electrode PE1, a portion of the hole injection layer 310 disposed on the second pixel electrode PE2, and a portion of the hole injection layer 310 disposed on the third pixel electrode PE3 may be electrically connected to each other. This also applies to the hole transport layer 320.

An electron transport layer 351, an electron generation layer 341, a hole generation layer 343, and a hole transport layer 321 may be sequentially disposed on the third emission layer 333. A second emission layer 333' that may emit blue light and correspond to the third pixel electrode PE3 may be disposed on the hole transport layer 321. A blue auxiliary layer 333b may be disposed between the second emission layer 333' and the hole transport layer 321. The description of the blue auxiliary layer 333a is likewise applicable to the blue auxiliary layer 333b. The electron generation layer 341 and the hole generation layer 343 may be charge generation layers. When needed, the electron generation layer 341 may be integrally formed as a single body with the hole generation layer 343.

The electron transport layer 350 may be disposed on the second emission layer 333'. When needed, the buffer layer may be disposed between the second emission layer 333' and the electron transport layer 350. The common electrode CAT may be disposed on the electron transport layer 350. In the electron transport layer 350 and/or the common electrode CAT, a portion on the first pixel electrode PE1, a portion on the second pixel electrode PE2, and a portion on the third pixel electrode PE3 may be electrically connected to each other.

**As** described above, in the display panel 10 and the electronic apparatus 1 including the same according to an embodiment, the third light-emitting element OLED3 of the third pixel PX3 emitting blue light may include multiple emission layers 333 and 333'. Compared to the emission layer emitting red light, and the emission layer emitting green light, the emission layer emitting blue light has much power consumption, low brightness, and a short lifespan. In contrast, in the display panel 10 and the electronic apparatus 1 including the same according to an embodiment, because the third light-emitting element OLED3 of the third pixel PX3 emitting blue light may include multiple emission layers 333 and 333', and the electron generation layer 341, the hole generation layer 343, and the like are disposed therebetween, such issues may be resolved.

The first light-emitting element OLED1 of the first pixel PX1 may include the first emission layer 331, and the second light-emitting element OLED2 of the second pixel PX2 may include the second emission layer 332. In contrast, the third light-emitting element OLED3 of the third pixel PX3 may include the third emission layer 333, the electron generation layer 341, the hole generation layer 343, the second emission layer 333', and the like. Accordingly, an electrical potential between the third pixel electrode PE3 of the third light-emitting element OLED3 and the common electrode CAT needs to be adjusted to be different from an electrical potential between the first pixel electrode PE1 of the first light-emitting element OLED1 and the common electrode CAT, and an electrical potential between the second pixel electrode PE2 of the second light-emitting element OLED2 and the common electrode CAT. This is described below.

FIG. 12 is a schematic diagram of an equivalent circuit PC that may be electrically connected to the first light-emitting element OLED1 or the second light-emitting element OLED2 of FIG. 10, and FIG. 13 is a schematic diagram of an equivalent circuit PC that may be electrically connected to the third light-emitting element OLED3 of FIG. 11. First, the pixel circuit PC represented as the equivalent circuit diagram shown in FIG. 12 is described, and a portion represented as the equivalent circuit diagram shown in FIG. 13 having different points from those of FIG. 12 is described.

As shown in FIG. 12, the pixel circuit PC may include multiple thin-film transistors T1, T2, T3, T4, T5, T6, T7, and T8, and a storage capacitor Cst. Multiple thin-film transistors T1, T2, T3, T4, T5, T6, T7, and T8, and the storage capacitor Cst may be connected to signal lines GWL, GCL, GIL, GBL, EL, and DL, an initialization voltage line VIL, a first electrode initialization voltage line VL1, and a first driving voltage line PL1, and a bias voltage line VBL. At least one of the lines, for example, the first driving voltage line PL1 may be shared by pixels disposed adjacent to each other.

Multiple thin-film transistors T1, T2, T3, T4, T5, T6, T7, and T8 may include a driving transistor T1, a switching transistor T2, a compensation transistor T3, an initialization transistor T4, an operation control transistor T5, an emission control transistor T6, a bias transistor T7, and an electrode initialization transistor T8.

The first light-emitting element OLED1 and/or the second light-emitting element OLED2 may include a pixel electrode and a common electrode. The pixel electrode may be connected to the driving transistor T1 through the emission control transistor T6, and the common electrode may receive the common voltage ELVSS. The first light-emitting element OLED1 and/or the second light-emitting element OLED2 may generate light of a brightness corresponding to a driving current.

Some of multiple thin-film transistors T1, T2, T3, T4, T5, T6, T7, and T8 may be n-channel metal oxide semiconductor (NMOS) field-effect transistors (n-channel MOSFETs), and the rest may be p-channel metal oxide semiconductor (PMOS) field-effect transistors (p-channel MOSFETs). For example, among multiple thin-film transistors T1, T2, T3, T4, T5, T6, T7, and T8, the compensation transistor T3 and the initialization transistor T4 may be n-channel MOSFETs (NMOS), and the rest may be p-channel MOSFETs (PMOS). In another embodiment, among multiple thin-film transistors T1, T2, T3, T4, T5, T6, T7, and T8, the compensation transistor T3, the initialization transistor T4, and the electrode initialization transistor T8 may be n-channel MOSFETs (NMOSs), and the rest may be p-channel MOSFETs (PMOSs). In another embodiment, all of multiple thin-film transistors T1, T2, T3, T4, T5, T6, T7, and T8 may be NMOSs or PMOSs. Multiple thin-film transistors T1, T2, T3, T4, T5, T6, T7, and T8 may each include amorphous silicon or polycrystalline silicon. When needed, a thin-film transistor, which is an NMOS, may include an oxide semiconductor. Hereinafter, for convenience of description, the case where the compensation transistor T3 and the initialization transistor T4 are NMOSs including an oxide semiconductor, and the rest are PMOSs, is described.

The signal lines may include a first scan line GWL, a second scan line GCL, a third scan line GIL, a fourth scan line GBL, an emission control line EL, and a data line DL, where the first scan line GWL may transfer a first scan signal GW, the second scan line GCL may transfer a second scan signal GC, the third scan line GIL may transfer an initialization scan signal GI to the initialization transistor T4, the fourth scan line GBL may transfer a bias scan signal GB to the electrode initialization transistor T7, the emission control line EL may transfer an emission control signal EM to the operation control transistor T5 and the emission control transistor T6, and the data line DL crosses the first scan line GWL and may transfer a data signal DATA.

The first driving voltage line PL1 may transfer a first driving voltage ELVDD1 to the driving transistor T1, the initialization voltage line VIL may transfer an initialization voltage Vint initializing the driving transistor T1, and the first electrode initialization voltage line VL1 may transfer a first electrode initialization voltage Vaint1 initializing a pixel electrode of the first light-emitting element OLED1 and/or the second light-emitting element OLED2.

A driving gate electrode of the driving transistor T1 may be connected to the storage capacitor Cst through a second node N2, one of a source region and a drain region of the driving transistor T1 may be connected to the first driving voltage line PL1 through the operation control transistor T5 via a first node N1, and the other of the source region and the drain region of the driving transistor T1 may be electrically connected to the pixel electrode of the first light-emitting element OLED1 and/or the second light-emitting element OLED2 through the emission control transistor T6 via a third node N3. The driving transistor T1 may receive a data signal DATA and supply the driving current to the first light-emitting element OLED1 and/or the second light-emitting element OLED2 according to a switching operation of the switching transistor T2.

A switching gate electrode of the switching transistor T2 may be connected to the first scan line GWL which transfers a first scan signal GW, one of a source region and a drain region of the switching transistor T2 may be connected to the data line DL, and the other of the source region and the drain region of the switching transistor T2 may be connected to the driving transistor T1 through the first node N1 and connected to the first driving voltage line PL1 through the operation control transistor T5. The switching transistor T2 may transfer a data signal DATA from the data line DL to the first node N1 in response to a voltage applied to the first scan line GWL. For example, the switching transistor T2 may perform a switching operation of being turned on according to a first scan signal GW transferred through the first scan line GWL and transferring a data signal DATA to the driving transistor T1 through the first node N1, the data signal DATA being transferred through the data line DL.

A compensation gate electrode of the compensation transistor T3 may be connected to the second scan line GCL. One of a source region and a drain region of the compensation transistor T3 may be connected to the pixel electrode of the first light-emitting element OLED1 and/or the second light-emitting element OLED2 through the emission control transistor T6 via the third node N3. The other of the source region and the drain region of the compensation transistor T3 may be connected to a first capacitor electrode of the storage capacitor Cst, and the driving gate electrode of the driving transistor T1 through the second node N2. The compensation transistor T3 may diode-connect the driving transistor T1 by being turned on according to a second scan signal GC received through the second scan line GCL.

An initialization gate electrode of the initialization transistor T4 may be connected to the third scan line GIL. One of a source region and a drain region of the initialization transistor T4 may be connected to the initialization voltage line VIL. The other of the source region and the drain region of the initialization transistor T4 may be connected to the first capacitor electrode of the storage capacitor Cst, and the driving gate electrode of the driving transistor T1 through the second node N2. The initialization transistor T4 may apply the initialization voltage Vint from the initialization voltage line VIL to the second node N2 according to a voltage applied to the third scan line GIL. For example, the initialization transistor T4 may be turned on according to an initialization scan signal GI received through the third scan line GIL and may perform an initialization operation of initializing the voltage of the driving gate voltage of the driving transistor T1 by transferring the initialization voltage Vint to the driving gate electrode of the driving transistor T1.

An operation control gate electrode of the operation control transistor T5 may be connected to the emission control line EL, one of a source region and a drain region of the operation control transistor T5 may be connected to the first driving voltage line PL1, and the other of the source region and the drain region of the operation control transistor T5 may be connected to the driving transistor T1 and the switching transistor T2 through the first node N1.

An emission control gate electrode of the emission control transistor T6 may be connected to the emission control line EL, one of a source region and a drain region of the emission control transistor T6 may be connected to the driving transistor T1 and the compensation transistor T3 through the third node N3, and the other of the source region and the drain region of the emission control transistor T6 may be electrically connected to the pixel electrode of the first light-emitting element OLED1 and/or the second light-emitting element OLED2.

The operation control transistor T5 and the emission control transistor T6 may be simultaneously turned on according to an emission control signal EM transferred through the emission control line EL to allow an electrical signal from the first driving voltage line PL1 to be transferred to the first light-emitting element OLED1 and/or the second light-emitting element OLED2, thereby allowing the driving current to flow from the first node N1 to the first light-emitting element OLED1 and/or the second light-emitting element OLED2.

The bias transistor T7 may be connected between the first node N1 and the bias voltage line VBL. The bias transistor T7 may be turned on according to a bias scan signal GB transferred through the fourth scan line GBL, and may apply a bias voltage VOBS to the first node N1 to set in advance a voltage suitable for a subsequent operation of the driving transistor T1 to the first node N1. In this viewpoint, the fourth scan line GBL may be a bias gate line.

The first electrode initialization gate electrode of the electrode initialization transistor T8 may be connected to the fourth scan line GBL, one of a source region and a drain region of the electrode initialization transistor T8 may be connected to the first light-emitting element OLED1 and/or the second light-emitting element OLED2, and the other of the source region and the drain region of the electrode initialization transistor T8 may be connected to the first electrode initialization voltage line VL1 to receive the first electrode initialization voltage Vaint1. The electrode initialization transistor T8 may be turned on according to a bias scan signal GB transferred through the fourth scan line GBL, and may initialize the pixel electrodes of the first light-emitting element OLED1 and/or the second light-emitting element OLED2.

The storage capacitor Cst may include the first capacitor electrode and a second capacitor electrode. The first capacitor electrode of the storage capacitor Cst may be connected to the driving gate electrode of the driving transistor T1 through the second node N2, and the second capacitor electrode of the storage capacitor Cst is connected to the first driving voltage line PL1. The storage capacitor Cst may store charge corresponding to a difference between a voltage of the driving gate electrode of the driving transistor T1 and the first driving voltage ELVDD1.

A specific operation of each pixel according to an embodiment is described below.

In case that an initialization scan signal GI is supplied through the third scan line GIL during an initialization period, the initialization transistor T4 is turned on according to the initialization scan signal GI, and the driving transistor T1 is initialized by the initialization voltage Vint supplied from the initialization voltage line VIL. In case that a bias scan signal GB is supplied through the fourth scan line GBL, the electrode initialization transistor T8 may be turned on in response to the bias scan signal GB, and the pixel electrodes of the first light-emitting element OLED1 and/or the second light-emitting element OLED2 may be initialized by the first electrode initialization voltage Vaint1 supplied from the first electrode initialization voltage line VL1. The bias transistor T7 may be also turned on according to a bias scan signal GB, and may apply the bias voltage VOBS to the first node N1 to set in advance a voltage suitable for a subsequent operation of the driving transistor T1 to the first node N1.

In case that a first scan signal GW and a second scan signal GC are supplied through the first scan line GWL and the second scan line GCL during a data programming period, the switching transistor T2 and the compensation transistor T3 may be turned on according to the first scan signal GW and the second scan signal GC. For example, the driving transistor T1 may be diode-connected and forward-biased by the compensation transistor T3 that is turned on. Then, a compensation voltage DATA+Vth (Vth has a (-) value) may be applied to the driving gate electrode of the driving transistor T1, where the compensation voltage DATA+Vth is a voltage reduced by a threshold voltage (Vth) of the driving transistor T1 from a data signal DATA supplied from the data line DL. The first driving voltage ELVDD1 and the compensation voltage DATA+Vth may be respectively applied to two opposite ends of the storage capacitor Cst, and charge corresponding to a difference between voltages of the two opposite ends may be stored in the storage capacitor Cst.

During an emission period, the operation control transistor T5 and the emission control transistor T6 may be turned on according to an emission control signal EM supplied from the emission control line EL. The driving current corresponding to a voltage difference between the voltage of the driving gate electrode of the driving transistor T1 and the first driving voltage ELVDD1 may occur, and the driving current may be supplied to the first light-emitting element OLED1 and/or the second light-emitting element OLED2 through the emission control transistor T6.

**As** described above, some of multiple thin-film transistors T1, T2, T3, T4, T5, T6, T7, and T8 may include an oxide semiconductor. For example, the compensation transistor T3 and the initialization transistor T4 may include an oxide semiconductor.

Because polycrystalline silicon has high reliability, it is possible to accurately control the flow of an intended current. Accordingly, the driving transistor T1 directly influencing the brightness of the display apparatus may include a semiconductor layer including polycrystalline silicon having high reliability, and thus, a high-resolution display apparatus may be implemented through this configuration. Because an oxide semiconductor has high carrier mobility and a low leakage current, a voltage drop is not large in case that a driving time is long. For example, in the oxide semiconductor, because a color change of an image according to a voltage drop is not large even while the display apparatus is driven in low frequencies, the display apparatus may be driven in low frequencies. Accordingly, by allowing the compensation transistor T3 and the initialization transistor T4 to include an oxide semiconductor, a display apparatus in which the occurrence of a leakage current is prevented, and simultaneously, with a reduced power consumption may be implemented.

Because the oxide semiconductor is sensitive to light, a change in the amount of current may occur due to externa light. Accordingly, external light may be absorbed or reflected by disposing a metal layer under the oxide semiconductor. For example, each of the compensation transistor T3 and the initialization transistor T4 including an oxide semiconductor may have a gate electrode on and under the oxide semiconductor layer. For example, in a direction (z axis direction) perpendicular to the upper surface of the substrate 100 (in a plan view) a metal layer disposed under the oxide semiconductor may overlap the oxide semiconductor.

Unlike the pixel circuit described above with reference to FIG. 12, the pixel circuit PC shown in FIG. 13 that may be electrically connected to the third light-emitting element OLED3 included in the third pixel PX3 may include a second driving voltage line PL2 in addition to the first driving voltage line PL1. When needed, the pixel circuit PC may include a second electrode initialization voltage line VL2 instead of the first electrode initialization voltage line VL1.

Even in case of the pixel circuit electrically connected to the third light-emitting element OLED3, the first capacitor electrode of the storage capacitor Cst may be electrically connected to the driving gate electrode of the driving transistor T1 through the second node N2, and the second capacitor electrode of the storage capacitor Cst may be electrically connected to the first driving voltage line PL1. Accordingly, In case that the same data signal as a data signal applied to the pixel circuit electrically connected to the first light-emitting element OLED1 is applied to the pixel circuit electrically connected to the third light-emitting element OLED3, the same electrical potential as an electrical potential between the source electrode and the gate electrode of the driving transistor T1 of the pixel circuit electrically connected to the first light-emitting element OLED1 may be applied between the source electrode and the gate electrode of the driving transistor T1 of the pixel circuit electrically connected to the third light-emitting element OLED3. Accordingly, in case that the same brightness data is applied, the driving transistor T1 of the pixel circuit electrically connected to the first light-emitting element OLED1, and the driving transistor T1 of the pixel circuit electrically connected to the third light-emitting element OLED3 may operate in the same manner.

However, in the pixel circuit electrically connected to the third light-emitting element OLED3, the driving transistor T1 may receive a second driving voltage ELVDD2 through the second driving voltage line PL2 instead of the first driving voltage line PL1. For example, the driving gate electrode of the driving transistor T1 may be electrically connected to the storage capacitor Cst through the second node N2, one of the source region and the drain region of the driving transistor T1 may be connected to the second driving voltage line PL2 through the operation control transistor T5 via the first node N1, and the other of the source region and the drain region of the driving transistor T1 may be electrically connected to the pixel electrode of the third light-emitting element OLED3 through the emission control transistor T6 via the third node N3. The driving transistor T1 may receive a data signal DATA and supply the driving current from the first node to the third light-emitting element OLED3 according to a switching operation of the switching transistor T2, in response to the voltage applied to the second node.

As described above, unlike the first light-emitting element OLED1 and/or the second light-emitting element OLED2, because the third light-emitting element OLED3 includes the electron generation layer 341, the hole generation layer 343, multiple emission layers 333 and 333, and the like, an electrical potential between the third pixel electrode PE3 of the third light-emitting element OLED3 and the common electrode CAT may be adjusted to be different from an electrical potential between the first pixel electrode PE1 of the first light-emitting element OLED1 and the common electrode CAT, or an electrical potential between the second pixel electrode PE2 of the second light-emitting element OLED2 and the common electrode CAT. In the display panel 10 and the electronic apparatus 1 including the display panel 10 according to the embodiment, as shown in FIGS. 12 and 13, an electrical potential between the first pixel electrode PE1 of the first light-emitting element OLED1 and the common electrode CAT, or an electrical potential between the second pixel electrode PE2 of the second light-emitting element OLED2 and the common electrode CAT may be maintained at about a difference between the first driving voltage ELVDD1 and the common voltage ELVSS, while an electrical potential between the third pixel electrode PE3 of the third light-emitting element OLED3 and the common electrode CAT may be maintained at about a difference between the second driving voltage ELVDD2 and the common voltage ELVSS. Accordingly, the display panel 10 displaying high-quality images, and the electronic apparatus 1 including the same may be implemented.

An electrical potential of the second driving voltage ELVDD2 may be different from an electrical potential of the first driving voltage ELVDD1. For example, an electrical potential of the second driving voltage ELVDD2 may be greater than an electrical potential of the first driving voltage ELVDD1. For example, the common voltage ELVSS may be about -6 V, the first driving voltage ELVDD1 may be about 5 V, and the second driving voltage ELVDD2 may be about 7 V.

The first pixel electrode PE1 of the first light-emitting element OLED1 and the second pixel electrode PE2 of the second light-emitting element OLED2 may be initialized to the first electrode initialization voltage Vaint1 from the first electrode initialization voltage line VL1 by the electrode initialization transistor T8, and the third pixel electrode PE3 of the third light-emitting element OLED3 may be initialized to a second electrode initialization voltage Vaint2 from the second electrode initialization voltage line VL2 by the electrode initialization transistor T8.

Because parasitic capacitances between the pixel electrodes PE1, PE2, and PE3 of the first light-emitting element OLED1, the second light-emitting element OLED2, and the third light-emitting element OLED3, threshold voltages for light emission, or the like are different from each other, electrode initialization voltages applied to the pixel electrodes PE1, PE2, and PE3 of the first light-emitting element OLED1, the second light-emitting element OLED2, and the third light-emitting element OLED3 need to be different from each other. For this purpose, an electrode initialization voltage line for the first light-emitting element OLED1, an electrode initialization voltage line for the second light-emitting element OLED2, and an electrode initialization voltage line for the third light-emitting element OLED3 may be separately disposed inside the display area DA. However, in the display panel 10 of a high resolution and the electronic apparatus 1 including the same, it may not be easy to separately dispose an electrode initialization voltage line for the first light-emitting element OLED1, an electrode initialization voltage line for the second light-emitting element OLED2, and an electrode initialization voltage line for the third light-emitting element OLED3.

In the display panel 10 and the electronic apparatus 1 including the same according to the embodiment, the second electrode initialization voltage Vaint2 different from the first electrode initialization voltage Vaint1 applied to at least the third light-emitting element OLED3, and accordingly, the display panel 10 displaying high-quality images and the electronic apparatus 1 including the same may be implemented.

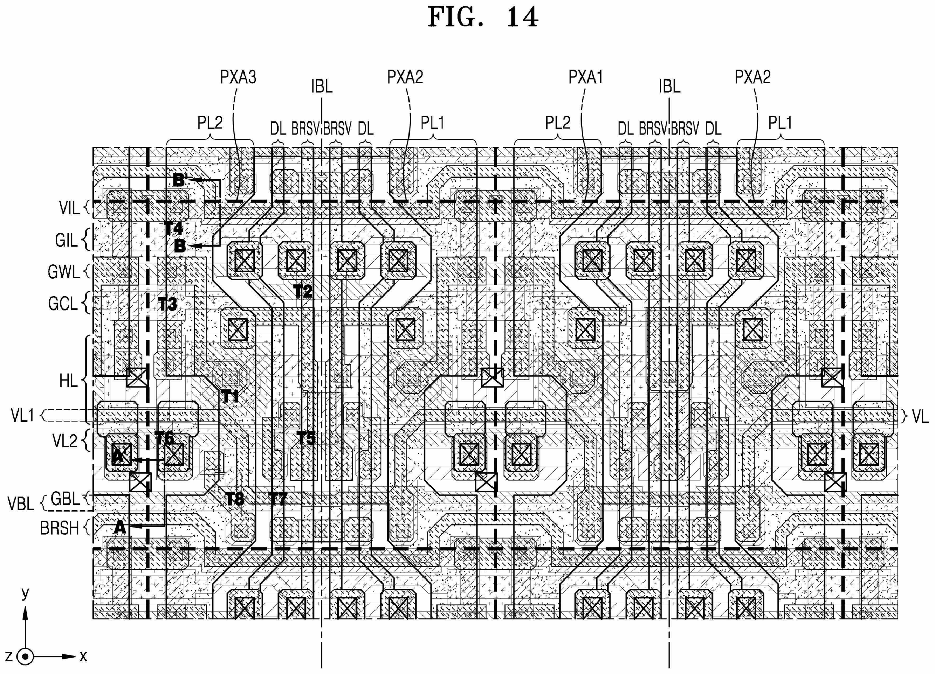

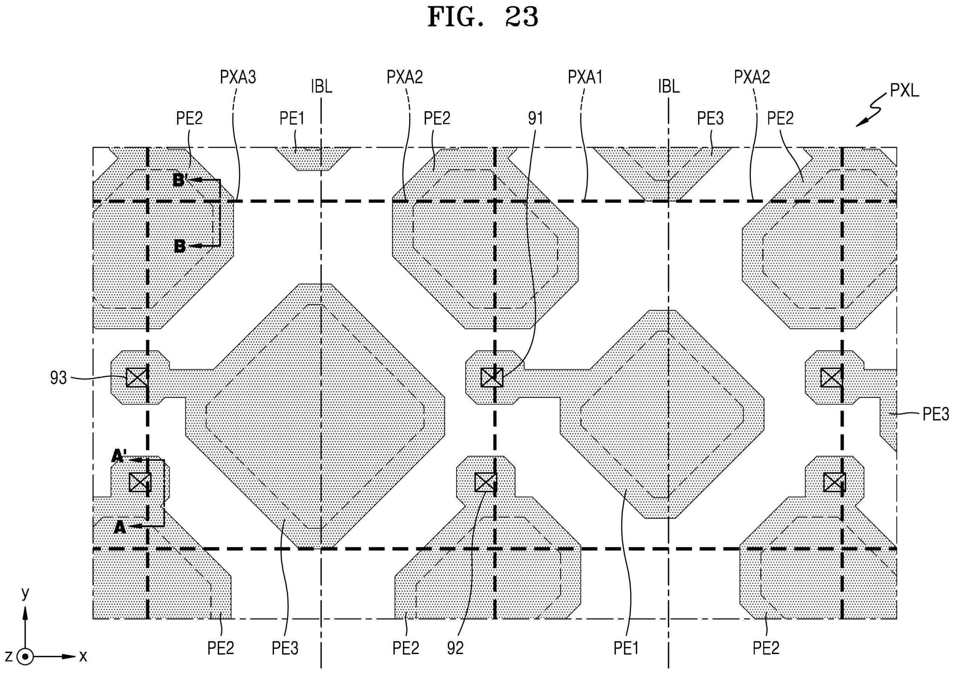

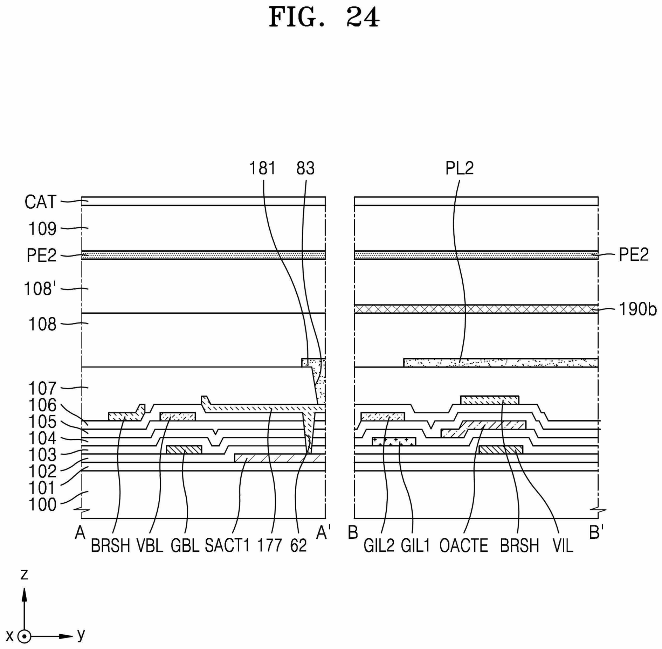

FIG. 14 is a schematic arrangement view showing positions of transistors, capacitors and the like in pixels included in the display panel 10 of FIG. 9, FIGS. 15 to 22 are schematic arrangement views of elements such as transistors and capacitors, for each layer, of the display panel 10 shown in FIG. 14, FIG. 23 is a schematic arrangement view of pixel electrodes PE1, PE2, and PE3 of the display panel 10 of FIG. 9, and FIG. 24 is a schematic cross-sectional view of the display panel 10, taken along lines A-A' and B-B' of FIG. 14.

The display panel 10 and the electronic apparatus 1 including the same may have a structure in which a set of a third pixel area PXA3, a second pixel area PXA2, a first pixel area PXA1, and a second pixel area PXA2 sequentially arranged in the first direction (e.g., x-axis direction) is repeatedly arranged in the first direction (e.g., x-axis direction). For reference, a region disposed adjacent to each of a +y direction and -y direction of the third pixel area PXA3 may be the first pixel area PXA1, a region disposed adjacent to each of a +y direction and -y direction of the first pixel area PXA1 may be the third pixel area PXA3, and a region disposed adjacent to each of a +y direction and -y direction of the second pixel area PXA2 may be the second pixel area PXA2.

The pixel circuit of the first pixel PX1 may be disposed in the first pixel area PXA1, the pixel circuit of the second pixel PX2 may be disposed in the second pixel area PXA2, and the pixel circuit of the third pixel PX3 may be disposed in the third pixel area PXA3. The pixel circuit of the first pixel PX1 may be a first-color pixel circuit, the pixel circuit of the second pixel PX2 may be a second-color pixel circuit, and the pixel circuit of the third pixel PX3 may be a third-color pixel circuit. A first color may denote a red color, a second color may denote a green color, and a third color may denote a blue color. However, it is not limited thereto. For example, the first color may be a green color, the second color may be a blue color, the third color may be a red color. For another example, the first color may be a blue color, the second color may be a red color, the third color may be a green color.

The third pixel area PXA3 and second pixel area PXA2 disposed adjacent to each other may be symmetrical with respect to an imaginary boundary line IBL as shown in FIG. 14 and the like. This also applies to the case of the first pixel area PXA1 and second pixel area PXA2. Unlike this, the pixel areas may have the same structure instead of the symmetrical structure.

Hereinafter, for convenience of description, although some conductive patterns are described based on the pixel circuit disposed in the third pixel area PXA3, these conductive patterns may be symmetrically or equally disposed in also the first pixel area PXA1 and/or second pixel area PXA2.

**A** buffer layer 101 (see FIG. 24) may be disposed on the substrate 100, where the buffer layer 101 may include silicon oxide, silicon nitride, or silicon oxynitride. The buffer layer 101 may prevent metal atoms or impurities and the like from the substrate 100 from diffusing to a first semiconductor layer SACT disposed thereon. The buffer layer 101 may allow the first semiconductor layer SACT to be uniformly crystallized by adjusting a providing speed of heat during a crystallization process for forming the first semiconductor layer SACT.

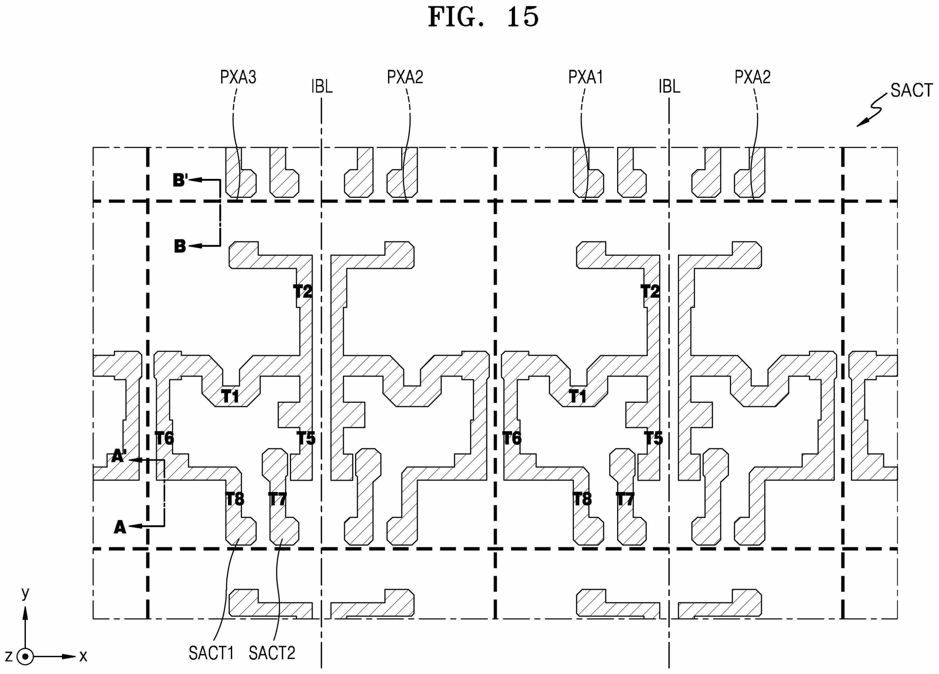

The first semiconductor layer SACT shown in FIG. 15 may be disposed on the buffer layer 101. The first semiconductor layer SACT may include a silicon semiconductor. For example, the first semiconductor layer SACT may include amorphous silicon or polycrystalline silicon. For example, the first semiconductor layer SACT may include polycrystalline silicon crystallized at low temperature. When needed, ions may be implanted in at least a portion of the first semiconductor layer SACT. In case that needed, a lower metal layer corresponding to the shape of the first semiconductor layer SACT may be disposed under the first semiconductor layer SACT to protect the first semiconductor layer SACT. For example, an insulating layer may be disposed between the lower metal layer and the first semiconductor layer SACT.

The first semiconductor layer SACT may include a first sub-semiconductor layer SACT1 and a second sub-semiconductor layer SACT2 separated from the first sub-semiconductor layer SACT1. A first sub-semiconductor layer SACT1 of the third pixel area PXA3 and a first sub-semiconductor layer SACT1 of the second pixel area PXA2 disposed adjacent thereto in the +x direction may be spaced apart from each other. However, a first sub-semiconductor layer SACT1 of the first pixel area PXA1 and the first sub-semiconductor layer SACT1 of the second pixel area PXA2 disposed adjacent thereto in the +x direction may be integrally formed as a single body. The second sub-semiconductor layer SACT2 may be electrically connected to the first sub-semiconductor layer SACT1 by a connection electrode 176 included in a first source-drain layer SD1 as described below.

The first sub-semiconductor layer SACT1 may have a shape curved in various shapes. The driving transistor T1, the switching transistor T2, the operation control transistor T5, the emission control transistor T6, and the electrode initialization transistor T8 may be disposed in the first sub-semiconductor layer SACT1. For example, the first sub-semiconductor layer SACT1 may include a channel region, and a source region and a drain region on two opposite sides of the channel region of each of the driving transistor T1, the switching transistor T2, the operation control transistor T5, the emission control transistor T6, and the electrode initialization transistor T8. The second sub-semiconductor layer SACT2 may include a channel region, a source region, and a drain region of the bias transistor T7. In FIG. 15, the positions of the channel regions of the transistors T1, T2, T5, T6, T7, and T8 are denoted by reference symbols of the transistors T1, T2, T5, T6, T7, and T8. A source region and a drain region are disposed on one side and another side of a channel region.

A first gate insulating layer 102 (see FIG. 24) may be disposed on the substrate 100 to cover the first semiconductor layer SACT. The first gate insulating layer 102 may include an insulating material. For example, the first gate insulating layer 102 may include silicon oxide, silicon nitride, silicon oxynitride, or aluminum oxide.

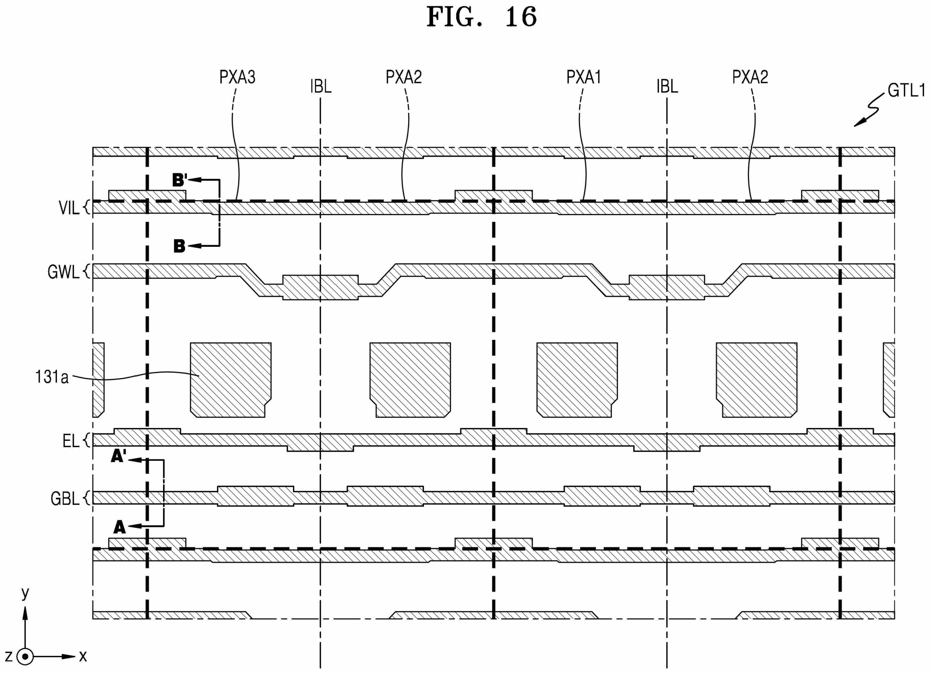

As shown in FIG. 16, a first gate layer GTL1 may be disposed on the first gate insulating layer 102. The first gate layer GTL1 may include the first scan line GWL transferring a first scan signal GW, the fourth scan line GBL transferring a bias scan signal GB to the electrode initialization transistor T8, the emission control line EL transferring an emission control signal EM to the operation control transistor T5 and the emission control transistor T6, the initialization voltage line VIL transferring the initialization voltage Vint initializing the driving transistor T1, and a driving gate electrode 131a of the driving transistor T1 having an isolated shape. The driving gate electrode 131a may also serve as a lower electrode, which is a first electrode of a capacitor Cst.

The first scan line GWL, the fourth scan line GBL, the emission control line EL, and the initialization voltage line VIL may have a shape extending in the first direction (e.g., x-axis direction). Portions of the first semiconductor layer SACT overlapping the first scan line GWL, the fourth scan line GBL, and the emission control line EL may serve as gate electrodes of the transistors. For example, a portion of the first scan line GWL overlapping the first semiconductor layer SACT may be a switching gate electrode of the switching transistor T2, a portion of the fourth scan line GBL overlapping the first semiconductor layer SACT may be a bias gate electrode of the bias transistor T7, and portions of the emission control line EL overlapping the first semiconductor layer SACT may be an operation control gate electrode of the operation control transistor T5 and an emission control gate electrode of the emission control transistor T6.

The first gate layer GTL1 may include metal, an alloy, a conductive metal oxide, or a transparent conductive material and the like. For example, the first gate layer GTL1 may include silver (Ag), an alloy containing silver, molybdenum (Mo), an alloy containing molybdenum, aluminum (Al), an alloy containing aluminum, aluminum nitride (AIN), and tungsten (W), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The first gate layer GTL1 may have a multi-layered structure. For example, the first gate layer GTL1 may have a two-layered structure of Mo/Al or a three-layered structure of Mo/Al/Mo.

A second gate insulating layer 103 (see FIG. 24) may cover the first gate layer GTL1 and be disposed on the first gate insulating layer 102. The second gate insulating layer 103 may include an insulating material equal/similar to an insulating material of the first gate insulating layer 102.

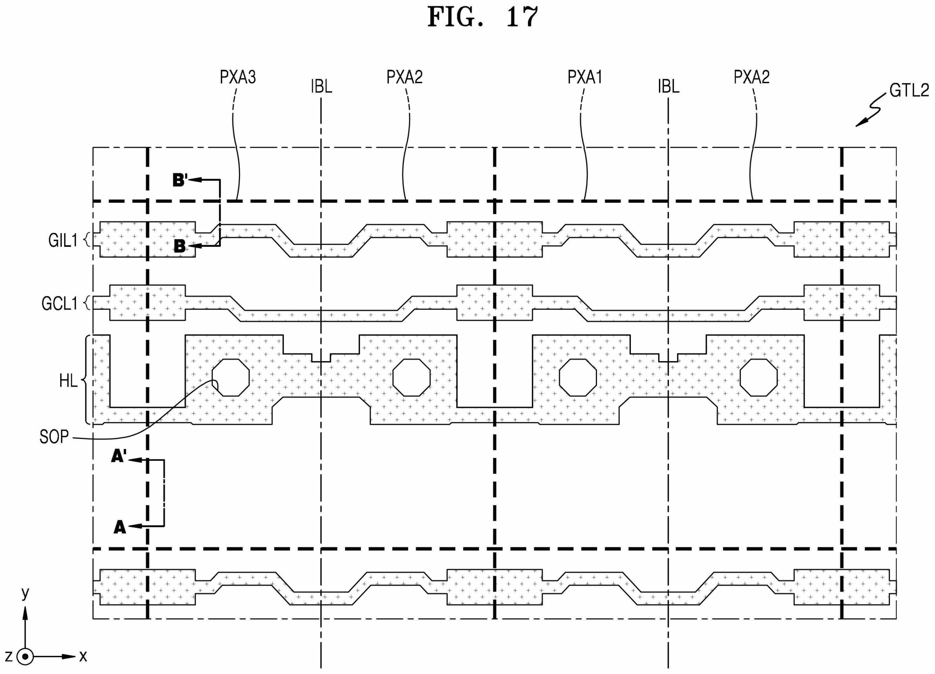

As shown in FIG. 17, a second gate layer GTL2 may be disposed on the second gate insulating layer 103. The second gate layer GTL2 may include an electrode voltage line HL, a lower gate line GCL1 of the second scan line GCL, and a lower gate line GIL1 of the third scan line GIL. The electrode voltage line HL, the lower gate line GCL1 of the second scan line GCL, and the lower gate line GIL1 of the third scan line GIL may extend in the first direction (e.g., x-axis direction).

A portion of the electrode voltage line HL may be an upper electrode, which is a second electrode of the capacitor Cst, and may overlap the driving gate electrode 131a, which is the lower electrode of the capacitor Cst. Upper electrodes of the capacitors Cst of the pixel circuits in the same row may be integrally formed as a single body extending in the first direction (e.g., x-axis direction) by the electrode voltage line HL. The first driving voltage ELVDD1 may be applied to the upper electrode of the capacitor Cst. An opening SOP may be formed in the upper electrode of the storage capacitor Cst, and at least a portion of the driving gate electrode 131a may overlap the opening.

A portion of the lower gate line GCL1 of the second scan line GCL overlapping a second semiconductor layer OACT described below may be a compensation lower gate electrode of the compensation transistor T3, and a portion of the lower gate line GIL1 of the third scan line GIL overlapping the second semiconductor layer OACT may be a first initialization lower gate electrode of the initialization transistor T4.

The second gate layer GTL2 may include metal, an alloy, a conductive metal oxide, or a transparent conductive material and the like. For example, the second gate layer GTL2 may include silver (Ag), an alloy containing silver, molybdenum (Mo), an alloy containing molybdenum, aluminum (Al), an alloy containing aluminum, aluminum nitride (AIN), and tungsten (W), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The second gate layer GTL2 may have a multi-layered structure. For example, the second gate layer GTL2 may have a two-layered structure of Mo/Al or a three-layered structure of Mo/Al/Mo.

A first interlayer insulating layer 104 (see FIG. 24) may cover the second gate layer GTL2 and be disposed on the second gate insulating layer 103. The first interlayer insulating layer 104 may include an insulating material. For example, the first interlayer insulating layer 104 may include silicon oxide, silicon nitride, silicon oxynitride, or aluminum oxide.

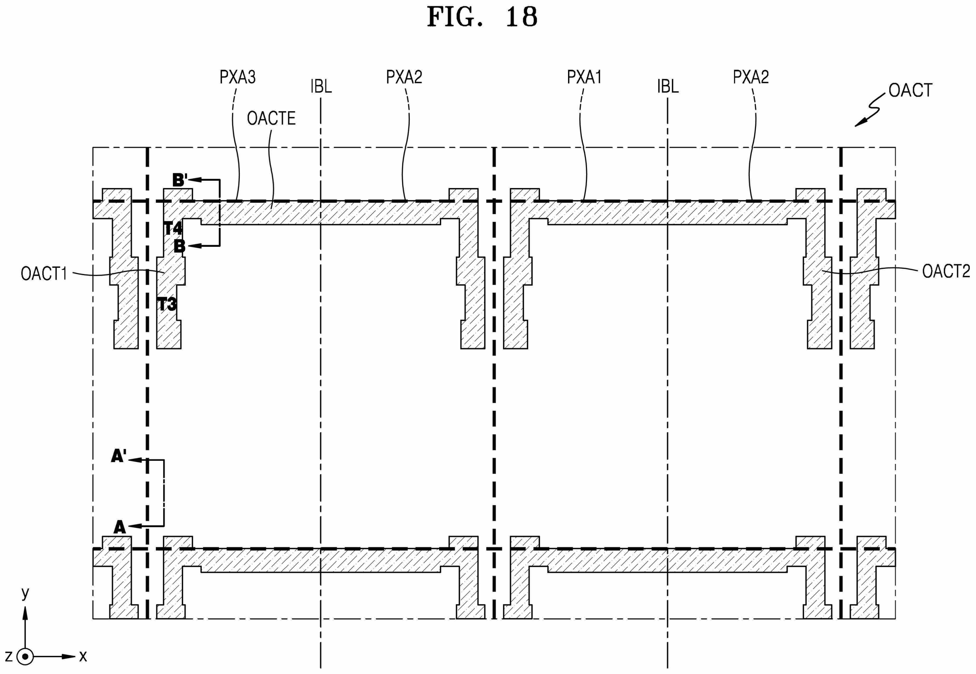

The second semiconductor layer OACT shown in FIG. 18 may be disposed on the first interlayer insulating layer 104. As described above, the second semiconductor layer OACT may include an oxide semiconductor. The second semiconductor layer OACT may be disposed on a layer different from the first semiconductor layer SACT. When viewed in a direction (z axis direction) perpendicular to the substrate 100 (or in a plan view), the second semiconductor layer OACT may not overlap the first semiconductor layer SACT. The second semiconductor layer OACT may form the compensation transistor T3 and the initialization transistor T4. In FIG. 18, the positions of the channel regions of the transistors T3 and T4 are denoted by reference symbols of the transistors T3 and T4. A source region may be disposed on one side of a channel region, and a drain region may be disposed on another side of the channel region.

The second semiconductor layer OACT may include a first vertical semiconductor layer OACT1 disposed in the third pixel area PXA3 and extending in the second direction (e.g., y-axis direction), and a semiconductor extension layer OACTE extending in the first direction (e.g., x-axis direction) from the first vertical semiconductor layer OACT1. Because a second vertical semiconductor layer OACT2 extending in the second direction (e.g., y-axis direction) may be disposed also in the second pixel area PXA2, one end of the semiconductor extension layer OACTE may be connected to the first vertical semiconductor layer OACT1, and another end may be connected to the second vertical semiconductor layer OACT2. For example, the first vertical semiconductor layer OACT1, the second vertical semiconductor layer OACT2, and the semiconductor extension layer OACTE disposed in the third pixel area PXA3 may be integrally formed as a single body. This also applies to the first pixel area PXA1 and second pixel area PXA2.

A third gate insulating layer 105 (see FIG. 24) may be disposed on the first interlayer insulating layer 104 to cover the second semiconductor layer OACT. The third gate insulating layer 105 may include an insulating material. The third gate insulating layer 105 may include silicon oxide, silicon nitride, silicon oxynitride, or aluminum oxide.

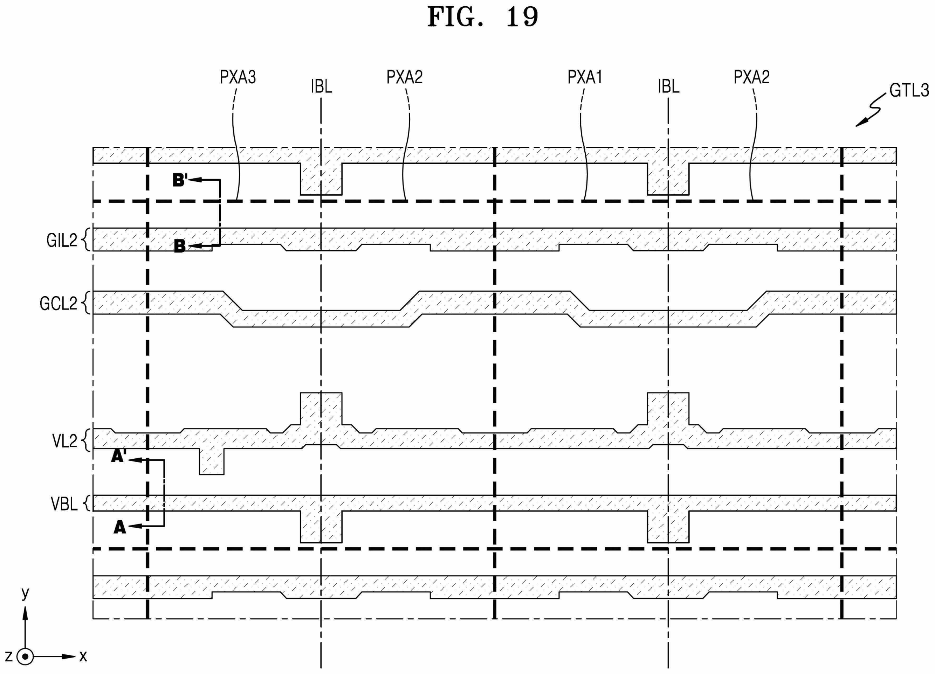

As shown in FIG. 19, a third gate layer GTL3 may be disposed on the third gate insulating layer 105. The third gate layer GTL3 may include an upper gate line GCL2 of the second scan line GCL, an upper gate line GIL2 of the third scan line GIL, the second electrode initialization voltage line VL2, and the bias voltage line VBL. The upper gate line GCL2 of the second scan line GCL, the upper gate line GIL2 of the third scan line GIL, the second electrode initialization voltage line VL2, and the bias voltage line VBL may extend in the first direction (e.g., x-axis direction).

A portion of the upper gate line GCL2 of the second scan line GCL overlapping the second semiconductor layer OACT may be a compensation upper gate electrode of the compensation transistor T3, and a portion of the upper gate line GIL2 of the third scan line GIL overlapping the second semiconductor layer OACT may be a first initialization upper gate electrode of the initialization transistor T4. For example, the compensation transistor T3 and the initialization transistor T4 may have a double gate structure respectively having gate electrodes on and under the second semiconductor layer OACT.

The third gate layer GTL3 may include metal, an alloy, a conductive metal oxide, or a transparent conductive material and the like. For example, the third gate layer GTL3 may include silver (Ag), an alloy containing silver, molybdenum (Mo), an alloy containing molybdenum, aluminum (Al), an alloy containing aluminum, aluminum nitride (AIN), and tungsten (W), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The third gate layer GTL3 may have a multi-layered structure. For example, the third gate layer GTL3 may have a two-layered structure of Mo/Al or a three-layered structure of Mo/Al/Mo.

For reference, although it is shown in FIG. 24 that the third gate insulating layer 105 has a shape corresponding to the entire surface of the substrate 100, and the third gate layer GTL3 is disposed on the third gate insulating layer 105, the invention is not limited thereto. For example, In case that forming the third gate insulating layer 105, forming, on the third gate insulating layer 105, a conductive layer for forming the third gate layer GTL3, and then forming the third gate layer GTL3 shown in FIG. 19 by patterning the conductive layer, the third gate insulating layer 105 thereunder may be simultaneously patterned. For example, in a plan view, the shape of the third gate insulating layer 105 may be represented to correspond to the shape of the third gate layer GTL3. For example, the third gate insulating layer 105 may be disposed under only the third gate layer GTL3.

A second interlayer insulating layer 106 (see FIG. 24) may cover at least a portion of the third gate layer GTL3 of FIG. 19. The second interlayer insulating layer 106 may include an insulating material. For example, the second interlayer insulating layer 106 may include silicon oxide, silicon nitride, silicon oxynitride, or aluminum oxide.

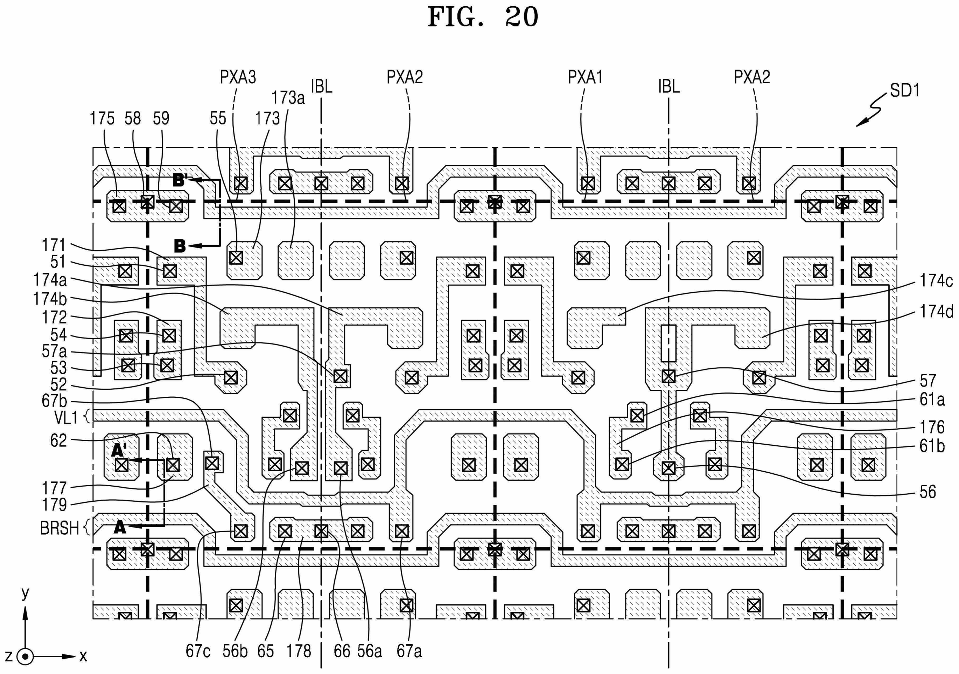

The first source-drain layer SD1 shown in FIG. 20 may be disposed on the second interlayer insulating layer 106. The first source-drain layer SD1 may include the first electrode initialization voltage line VL1, a horizontal connection line BRSH, and connection electrodes 171 to 179. The first electrode initialization voltage line VL1 and the horizontal connection line BRSH may have a shape extending in the first direction (e.g., x-axis direction) . The connection electrodes 171 to 178 may have an isolated shape.

The first electrode initialization voltage line VL1 may be electrically connected to the first semiconductor layer SACT through a contact hole 67a passing through an insulating layer in the lower portion in each of the second pixel area PXA2 in which the pixel circuit of the second pixel PX2 is disposed, and the first pixel area PXA1 in which the pixel circuit of the first pixel PX1 is disposed, and accordingly, may be electrically connected to a drain region of the electrode initialization transistor T8 of the second pixel PX2 and a drain region of the electrode initialization transistor T8 of the first pixel PX1. The first electrode initialization voltage line VL1 may have a curve and extend in the first direction (e.g., x-axis direction) in a zigzag shape.

Because the second electrode initialization voltage line VL2 is disposed on the third gate layer GTL3 as described above, one end of the connection electrode 179 may be electrically connected to the second electrode initialization voltage line VL2 by being in contact with the second electrode initialization voltage line VL2 through a contact hole 67b. For example, one end of the connection electrode 179 may be electrically connected to the second electrode initialization voltage line VL2 through the contact hole 67b passing through the insulating layers thereunder. Another end of the connection electrode 179 may be electrically connected to a drain region of the electrode initialization transistor T8 of the third pixel PX3 through a contact hole 67c passing through the insulating layers thereunder. Accordingly, the second electrode initialization voltage line VL2 may be electrically connected to the drain region of the electrode initialization transistor T8 of the third pixel PX3. The connection electrode 179 may be disposed in only the third pixel area PXA3.

Through this configuration, the first electrode initialization voltage Vaint1 may be applied to the electrode initialization transistor T8 of the first pixel PX1 and the electrode initialization transistor T8 of the second pixel PX2 through the first electrode initialization voltage line VL1, and the second electrode initialization voltage Vaint2 may be applied to the electrode initialization transistor T8 of the third pixel PX3 through the second electrode initialization voltage line VL2.

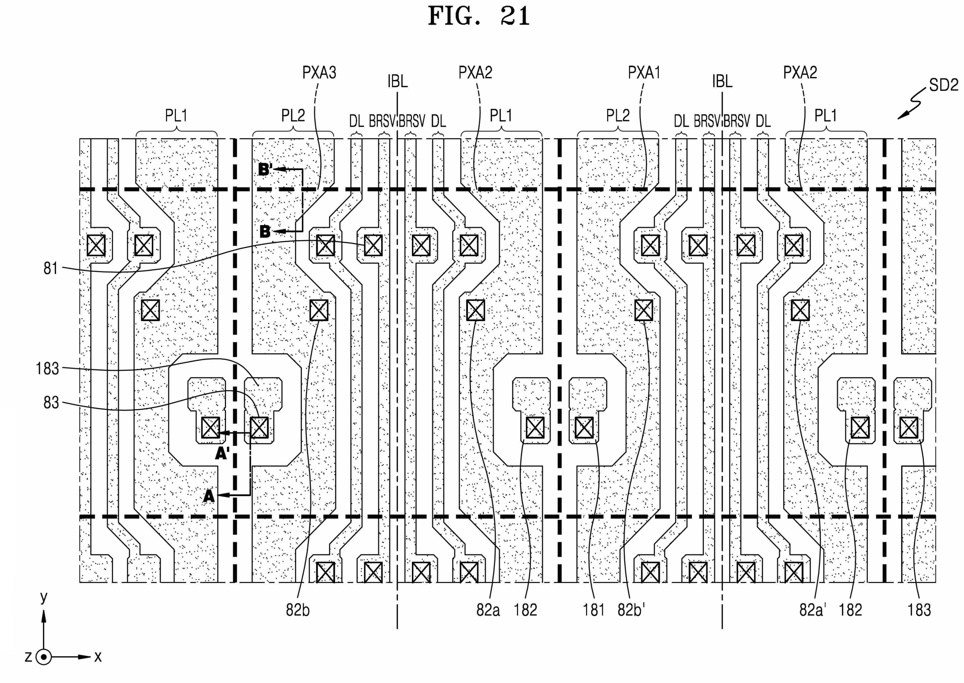

The horizontal connection line BRSH extending in the first direction (e.g., x-axis direction) may correspond to a portion of the data transfer line DTL described with reference to FIG. 7 or 8, for example, one of the first horizontal connection line DHL1, the second horizontal connection line DHL2, and the third horizontal connection line DHL3. When needed, the horizontal connection line BRSH may be electrically connected to a dummy electrode 173a disposed near in a -y direction. In the case where the horizontal connection line BRSH needs to be electrically connected to a vertical connection line BRSV (see FIG. 21), the horizontal connection line BRSH may be electrically connected to the vertical connection line BRSV at such a dummy electrode 173a. Through this, the horizontal connection line BRSH together with the vertical connection line BRSV may be electrically connected to a data line DL of a pixel circuit disposed in another column not shown in FIG. 20 to transfer data signals to pixel circuits in another column. As shown in FIG. 20, In case that the third pixel area PXA3 and the like are not disposed near a corner of the display area DA but are disposed in the center and the like of the display area DA, the horizontal connection line BRSH may be a dummy line to which electrical signals are not applied, or a dummy line to which preset electrical signals are applied when needed.

One end of the connection electrode 171 may be electrically connected to the second semiconductor layer OACT by being in contact with the second semiconductor layer OACT through a contact hole 51. For example, one end of the connection electrode 171 may be electrically connected to the compensation transistor T3 and the initialization transistor T4 through the contact hole 51 passing through the insulating layers thereunder. Another end of the connection electrode 171 may be electrically connected to the driving gate electrode 131a of the driving transistor T1 also serving as the lower electrode of the storage capacitor Cst through a contact hole 52 passing through the insulating layers thereunder. The contact hole 52 may pass through the opening SOP of the upper electrode of the storage capacitor Cst.

The connection electrode 172 may be electrically connected to a drain region of the driving transistor T1 and a source region of the emission control transistor T6 through a contact hole 53 passing through the insulating layers thereunder. The connection electrode 172 may be electrically connected to a drain region of the compensation transistor T3 through a contact hole 54 passing through the insulating layers thereunder.

The connection electrode 173 may be electrically connected to a source region of the switching transistor T2 through a contact hole 55 passing through the insulating layers thereunder.

In the second pixel area PXA2 of a second area among the third pixel area PXA3, the second pixel area PXA2, the first pixel area PXA1, and the second pixel area PXA2 sequentially disposed in the first direction (e.g., x-axis direction), a connection electrode 174a may be electrically connected to a source region of the operation control transistor T5 in the second pixel area PXA2 through a contact hole 56a passing through the insulating layers thereunder. The connection electrode 174a in the second pixel area PXA2 may be electrically connected to an electrode voltage line HL also serving as the upper electrode of the storage capacitor Cst through a contact hole 57a passing through the insulating layers thereunder, and consequently, be electrically connected to the first driving voltage line PL1. Through this, the first driving voltage ELVDD1 of the first driving voltage line PL1 may be transferred to the operation control transistor T5 in the second pixel PX2, and accordingly, be applied to the second pixel electrode PE2 of the second light-emitting element OLED2 through the driving transistor T1 and the like. Consequently, this may be understood that the second-color pixel circuit, which is the pixel circuit of the second pixel PX2, is electrically connected to the first driving voltage line PL1.

A connection electrode 174b of the third pixel area PXA3 may be electrically connected to a source region of the operation control transistor T5 of the third pixel area PXA3 through a contact hole 56b passing through the insulating layers thereunder. The connection electrode 174b of the third pixel area PXA3 may be electrically connected to the second driving voltage line PL2 thereabove as described below. Accordingly, the second driving voltage ELVDD2 of the second driving voltage line PL2 may be transferred to the operation control transistor T5 in the third pixel PX3, and accordingly, be applied to the third pixel electrode PE3 of the third light-emitting element OLED3 through the driving transistor T1 and the like. This may be understood that the third-color pixel circuit, which is the pixel circuit of the third pixel PX3, is electrically connected to the second driving voltage line PL2.

In the second pixel area PXA2 in a fourth area among the third pixel area PXA3, the second pixel area PXA2, the first pixel area PXA1, and the second pixel area PXA2 sequentially disposed in the first direction (e.g., x-axis direction), the first pixel PX1 and the second pixel PX2 may share a connection electrode 174d. The connection electrode 174d may be electrically connected to a first sub-semiconductor layer SACT1, which is integrally formed as a single body in the first pixel area PXA1 and the second pixel area PXA2, through a contact hole 56 passing through the insulating layers thereunder, and consequently, be electrically connected to a source region of the operation control transistor T5 in the first pixel area PXA1 and a source region of the operation control transistor T5 in the second pixel area PXA2. The connection electrode 174d may be electrically connected to the electrode voltage line HL also serving as the upper electrode of the storage capacitor Cst, through a contact hole 57 passing through the insulating layers thereunder, and consequently, be electrically connected to the first driving voltage line PL1. Through this, the first driving voltage ELVDD1 of the first driving voltage line PL1 may be transferred to the operation control transistor T5 in the first pixel PX1 and the operation control transistor T5 in the second pixel PX2, and accordingly, be transferred the first pixel electrode PE1 of the first light-emitting element OLED1 and the second pixel electrode PE2 of the second light-emitting element OLED2 through the driving transistor T1 and the like.

Consequently, this may be understood that the first-color pixel circuit, which is the pixel circuit of the first pixel PX1, is electrically connected to the first driving voltage line PL1. Furthermore, it may be understood that the first-color pixel circuit, which is the pixel circuit in the first pixel PX1, is electrically connected to a corresponding one of the first driving voltage lines PL1 through a second-color pixel circuit disposed in the same row and disposed adjacent to the +x direction among the second-color pixel circuits. This is because the operation control transistor T5 in the first pixel area PXA1 is electrically connected to the connection electrode 174d disposed in the second pixel area PXA2 disposed adjacent to the +x direction through the contact hole 56, and the connection electrode 174d is electrically connected to the first driving voltage line PL1 passing through the second pixel area PXA2 through a contact hole 82a'.

In case that the first-color pixel circuit, which is the pixel circuit in the first pixel PX1, is electrically connected to a corresponding one of the first driving voltage lines PL1 through a corresponding one among the second-color pixel circuits which is disposed in the same row and disposed adjacent to the +x direction, it may mean that the first-color pixel circuit is electrically connected to the corresponding one of the first driving voltage lines PL1 through a second-color pixel circuit disposed to face away from the third-color pixel circuit with respect to the first-color pixel circuit.

The above description may be understood that the emission control transistor T5 of the first-color pixel circuit, which is the pixel circuit in the first pixel PX1, is electrically connected to the emission control transistor T5 of a second-color pixel circuit disposed in the same row and disposed adjacent to the +x direction among the second-color pixel circuits, and accordingly, is electrically connected to a corresponding one of the first driving voltage lines PL1. This is because a semiconductor layer of the emission control transistor T5 in the first pixel area PXA1 is integrally formed with a semiconductor layer of the emission control transistor T5 in the second pixel area PXA2.

In case that the emission control transistor T5 of the first-color pixel circuit, which is the pixel circuit in the first pixel PX1, is electrically connected to the emission control transistor T5 of a second-color pixel circuit among the second-color pixel circuits which is disposed in the same row and disposed adjacent to the +x direction, it may mean that the emission control transistor T5 of the first-color pixel circuit is electrically connected to a corresponding one of the first driving voltage lines PL1 through the emission control transistor T5 of the second-color pixel circuit disposed to face away from the third-color pixel circuit with respect to the first-color pixel circuit.

Because the driving transistor T1 is electrically connected to the driving voltage line through the emission control transistor T5, it may be understood that the driving transistors T1 of the first-color pixel circuits and the driving transistors T1 of the second-color pixel circuits are electrically connected to the first driving voltage lines PL1, and the driving transistors T1 of the third-color pixel circuits are electrically connected to the second driving voltage lines PL2. Because there may not be the emission control transistor T5 depending on the pixel circuit, for example, particularly, it may be understood that the driving transistors T1 of the first-color pixel circuits and the driving transistors T1 of the second-color pixel circuits are electrically connected to the first driving voltage lines PL1, and the driving transistors T1 of the third-color pixel circuits are electrically connected to the second driving voltage lines PL2.

It may be understood that the driving transistor T1 of the first-color pixel circuit, which is the pixel circuit in the first pixel PX1, is electrically connected to the driving transistor T1 of a second-color pixel circuit disposed in the same row and disposed adjacent to the +x direction among the second-color pixel circuits, and accordingly, is electrically connected to a corresponding one of the first driving voltage lines PL1. In case that the driving transistor T1 of the first-color pixel circuit, which is the pixel circuit in the first pixel PX1, is electrically connected to the driving transistor T1 of a second-color pixel circuit among the second-color pixel circuits which is disposed in the same row and disposed adjacent to the +x direction, it may mean that the driving transistor T1 of the first-color pixel circuit is electrically connected to a corresponding one of the first driving voltage lines PL1 through the driving transistor T1 of the second-color pixel circuit disposed to face away from the third-color pixel circuit with respect to the first-color pixel circuit.

For reference, a connection electrode 174c having an isolated shape may be disposed in the first pixel area PXA1. As described below, the connection electrode 174c may be connected to the second driving voltage line PL2 to allow approximate shapes to be similar over the pixel areas.

A connection electrode 175 may be electrically connected to the initialization voltage line VIL through a contact hole 58 passing through the insulating layers thereunder. The connection electrode 175 may be electrically connected to the initialization transistor T4 through a contact hole 59 passing through the insulating layers thereunder. Accordingly, an initialization voltage, which is a constant voltage, may be applied to a semiconductor extension layer OACTE of the second semiconductor layer OACT.

The connection electrode 176 may electrically connect the first sub-semiconductor layer SACT1 to the second sub-semiconductor layer SACT2. For example, the connection electrode 176 may be electrically connected to a source region of the driving transistor T1, a drain region of the operation control transistor T5, and a drain region of the switching transistor T2 through a contact hole 61a passing through the insulating layers thereunder. The connection electrode 176 may be electrically connected to a drain region of the bias transistor T7 through a contact hole 61b passing through the insulating layers thereunder.

A connection electrode 177 may be electrically connected to a drain region of the emission control transistor T6 through a contact hole 62 passing through the insulating layers thereunder.

A connection electrode 178 may be electrically connected to a source region of the bias transistor T7 through a contact hole 65 passing through the insulating layers thereunder. The connection electrode 178 may be electrically connected to the bias voltage line VBL through a contact hole 66 passing through the insulating layers thereunder.

The first source-drain layer SD1 may include metal, an alloy, a conductive metal oxide, or a transparent conductive material and the like. For example, the first source-drain layer SD1 may include silver (Ag), an alloy containing silver, molybdenum (Mo), an alloy containing molybdenum, aluminum (Al), an alloy containing aluminum, aluminum nitride (AIN), and tungsten (W ), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The first source-drain layer SD1 may have a multi-layered structure. For example, the first source-drain layer SD1 may have a two-layered structure of Ti/Al or a three-layered structure of Ti/Al/Ti.

A first planarization insulating layer 107 (see FIG. 24) may be disposed on the second interlayer insulating layer 106 to cover the first source-drain layer SD1. The first planarization insulating layer 107 may include an organic insulating material. For example, the first planarization insulating layer 107 may each include benzocyclobutene (BCB), polyimide, hexamethyldisiloxane (HMDSO), polymethylmethacrylate (PMMA), polystyrene, polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a mixture thereof. The first planarization insulating layer 107 may include an inorganic insulating material, and for example, the upper surface thereof may not be flat.

As shown in FIG. 21, a second source-drain layer SD2 may be disposed on the first planarization insulating layer 107. The second source-drain layer SD2 may include the data line DL, the first driving voltage line PL1, the second driving voltage line PL2, the vertical connection line BRSV, and connection electrodes 181, 182, and 183. The data line DL, the first driving voltage line PL1, the second driving voltage line PL2, and the vertical connection line BRSV may have a shape extending in the second direction (e.g., y-axis direction). The first driving voltage line PL1 and the second driving voltage line PL2 may be alternately arranged in the first direction (e.g., x-axis direction).

The data line DL may be electrically connected to the connection electrode 173 included in the first source-drain layer SD1 through the contact hole 81 passing through the first planarization insulating layer 107. As described above, because the connection electrode 173 is connected to a source region of the switching transistor T2 through the contact hole 55 passing through the insulating layers thereunder, consequently, the data line DL may be electrically connected to the source region of the switching transistor T2.

In the second pixel area PXA2 in a second area among the third pixel area PXA3, the second pixel area PXA2, the first pixel area PXA1, and the second pixel area PXA2 sequentially disposed in the first direction (e.g., x-axis direction), the first driving voltage line PL1 extending in the second direction (e.g., y-axis direction) may be electrically connected to the connection electrode 174a included in the first source-drain layer SD1 in the second pixel area PXA2 through a contact hole 82a passing through the first planarization insulating layer 107 thereunder. The first driving voltage line PL1 extending in the second direction (e.g., y-axis direction) to pass across the second pixel area PXA2, which is a fourth area, may be electrically connected to the connection electrode 174d included in the first source-drain layer SD1 in the second pixel area PXA2 through the contact hole 82a' passing through the first planarization insulating layer 107 thereunder. As described above, the connection electrode 174a may be connected to the electrode voltage line HL included in the second gate layer GTL2 and extending in the first direction (e.g., x-axis direction) through the contact hole 57a passing through the insulating layers thereunder, and the connection electrode 174d may be connected to the electrode voltage line HL included in the second gate layer GTL2 and extending in the first direction (e.g., x-axis direction) through the contact hole 57 passing through the insulating layers thereunder. Accordingly, the first driving voltage lines PL1 and the electrode voltage lines HL electrically connected to each other may have (or entirely have) a mesh structure. Accordingly, a voltage drop (IR drop) of the first driving voltage ELVDD1 in the display area DA may be prevented or reduced.

In the third pixel area PXA3, the second driving voltage line PL2 extending in the second direction (e.g., y-axis direction) may be electrically connected to the connection electrode 174b included in the first source-drain layer SD1 in the third pixel area PXA3 through a contact hole 82b passing through the first planarization insulating layer 107 thereunder. The second driving voltage line PL2 extending in the second direction (e.g., y-axis direction) may pass across even the first pixel area PXA1. However, although, in the first pixel area PXA1, the second driving voltage line PL2 may be connected to the connection electrode 174c in the first pixel area PXA1 through a contact hole 82b' passing through the first planarization insulating layer 107 thereunder, the connection electrode 174c may have an isolated shape and may not be electrically connected to the other elements other than the second driving voltage line PL2.

The vertical connection line BRSV may correspond to a portion of the data transfer line DTL described with reference to FIG. 7 or 8, for example, one of the first vertical connection line DVL1, the second vertical connection line DVL2, the third vertical connection line DVL3, a first additional vertical connection line DVL1', a second additional vertical connection line DVL2', and a third additional vertical connection line DVL3'. Because it is shown in FIG. 21 that the vertical connection line BRSV is electrically connected to an element thereunder through a contact hole, in the case where elements shown in FIG. 21 are disposed near the corner of the display area DA, the vertical connection line BRSV is electrically connected to the horizontal connection line BRSH thereunder through a contact hole and is electrically connected to the data line DL of the pixel circuit disposed in another column, and accordingly, data signals may be transferred to the pixel circuits disposed in the other columns. In another embodiment, in case that the elements shown in FIG. 21 are disposed in the center and the like of the display area DA, the vertical connection line BRSV may be a dummy line to which electrical signals are not applied, or a dummy line to which preset electrical signals are applied when needed.

Each of the connection electrode 181 of the first pixel area PXA1, the connection electrode 182 of the second pixel area PXA2, and the connection electrode 183 of the third pixel area PXA3 may be electrically connected to the corresponding connection electrode 177 included in the second source-drain layer SD2 thereunder through a contact hole 83 passing through the first planarization insulating layer 107. As described above, the connection electrode 177 may be electrically connected to a drain region of the emission control transistor T6. Accordingly, each of the connection electrode 181, the connection electrode 182, and the connection electrode 183 may be electrically connected to a drain region of the corresponding emission control transistor T6.

The second source-drain layer SD2 may include metal, an alloy, a conductive metal oxide, or a transparent conductive material and the like. For example, the second source-drain layer SD2 may include silver (Ag), an alloy containing silver, molybdenum (Mo), an alloy containing molybdenum, aluminum (Al), an alloy containing aluminum, aluminum nitride (AIN), and tungsten (W ), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The second source-drain layer SD2 may have a multi-layered structure. For example, the second source-drain layer SD2 may have a two-layered structure of Ti/Al or a three-layered structure of Ti/Al/Ti.

A second planarization insulating layer 108 (see FIG. 24) may be disposed on the first planarization insulating layer 107 to cover the second source-drain layer SD2. The second planarization insulating layer 108 may include an organic insulating material. For example, the second planarization insulating layer 108 may each include benzocyclobutene (BCB), polyimide, hexamethyldisiloxane (HMDSO), polymethylmethacrylate (PMMA), polystyrene, polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a mixture thereof.

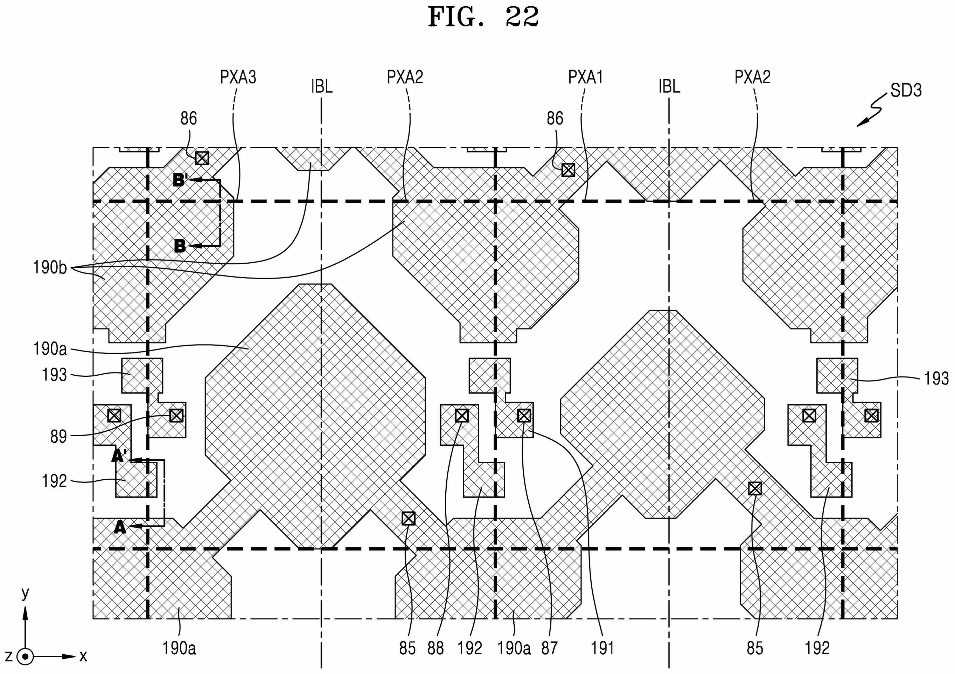

As shown in FIG. 22, a third source-drain layer SD3 may be disposed on the second planarization insulating layer 108. The third source-drain layer SD3 may include first main portions 190a apart from each other, bridge portions connecting the first main portions 190a, second main portions 190b apart from each other, bridge portions connecting the second main portions 190b, and connection electrodes 191, 192, and 193. The bridge portions connecting the first main portions 190a to the first main portions 190a may be integrally formed as a single body, may have a shape extending in the first direction (e.g., x-axis direction), and may be referred to as a second connection line. The bridge portions connecting the second main portions 190b to the second main portions 190b may be also integrally formed as a single body, may have a shape extending in the first direction (e.g., x-axis direction), and may be referred to as a first connection line. The second connection line, which is the bridge portions connecting the first main portions 190a to the first main portions 190a, and the first connection line, which is the bridge portions connecting the second main portions 190b to the second main portions 190b, may be alternately arranged in the second direction (e.g., y-axis direction).

The bridge portions connecting the first main portions 190a are electrically connected to the first driving voltage lines PL1 through a contact hole 85 passing through the second planarization insulating layer 108 thereunder. Accordingly, the first main portions 190a, the bridge portions connecting the first main portions 190a, the first driving voltage lines PL1, and the electrode voltage line HL may have a mesh structure entirely. Accordingly, a voltage drop (IR drop) of the first driving voltage ELVDD1 in the display area DA may be prevented or reduced.

Similarly, the bridge portions connecting the second main portions 190b may be electrically connected to the second driving voltage lines PL2 through a contact hole 86 passing through the second planarization insulating layer 108 thereunder. Accordingly, the second main portions 190b, the bridge portions connecting the second main portions 190b, and the second driving voltage lines PL2 may have (or entirely have) a mesh structure. Accordingly, a voltage drop (IR drop) of the second driving voltage ELVDD2 in the display area DA may be prevented or reduced.

The first main portions 190a arranged in the first direction (e.g., x-axis direction) may be regarded as extension portions. A first set of extension portions may include extension portions arranged in the first direction (e.g., x-axis direction) in the order of a third extension portion corresponding to the third pixel electrode PE3, a second extension portion corresponding to the second pixel electrode PE2, a first extension portion corresponding to the first pixel electrode PE1, and a second extension portion corresponding to the second pixel electrode PE2. Such first sets of extension portions may be repeatedly arranged in the first direction (e.g., x-axis direction) to form the first main portions 190a. Similarly, the second main portions 190b arranged in the first direction (e.g., x-axis direction) may be regarded as extension portions. A second set of extension portions may include extension portions arranged in the first direction (e.g., x-axis direction) in the order of a first extension portion corresponding to the first pixel electrode PE1, a second extension portion corresponding to the second pixel electrode PE2, a third extension portion corresponding to the third pixel electrode PE3, and a second extension portion corresponding to the second pixel electrode PE2. Such second sets of extension portions may be repeatedly arranged in the first direction (e.g., x-axis direction) to form the second main portions 190b.

The connection electrode 191 may be electrically connected to the connection electrode 181 in the first pixel area PXA1 through a contact hole 87 passing through the second planarization insulating layer 108, and consequently, be electrically connected to the driving transistor T1 in the first pixel area PXA1. The connection electrode 191 may be electrically connected to the first pixel electrode PE1 as described below. The connection electrode 192 may be electrically connected to the connection electrode 182 in the second pixel area PXA2 through a contact hole 88 passing through the second planarization insulating layer 108, and consequently, be electrically connected to the driving transistor T1 in the second pixel area PXA2. The connection electrode 192 may be electrically connected to the second pixel electrode PE2 as described below. The connection electrode 193 may be electrically connected to the connection electrode 183 in the third pixel area PXA3 through a contact hole 89 passing through the second planarization insulating layer 108, and consequently, be electrically connected to the driving transistor T1 in the third pixel area PXA3. The connection electrode 193 may be electrically connected to the third pixel electrode PE3 as described below.

The third source-drain layer SD3 may include metal, an alloy, a conductive metal oxide, or a transparent conductive material and the like. For example, the third source-drain layer SD3 may include silver (Ag), an alloy containing silver, molybdenum (Mo), an alloy containing molybdenum, aluminum (Al), an alloy containing aluminum, aluminum nitride (AIN), and tungsten (W ), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The third source-drain layer SD3 may have a multi-layered structure. For example, the third source-drain layer SD3 may have a two-layered structure of Ti/Al or a three-layered structure of Ti/Al/Ti.

A third planarization insulating layer 108' (see FIG. 24) may be disposed on the second planarization insulating layer 108 to cover the third source-drain layer SD3. The third planarization insulating layer 108' may include an organic insulating material. For example, the third planarization insulating layer 108' may each include benzocyclobutene (BCB), polyimide, hexamethyldisiloxane (HMDSO), polymethylmethacrylate (PMMA), polystyrene, polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a mixture thereof.

As shown in FIG. 23, a pixel electrode layer PXL may be disposed on the third planarization insulating layer 108'. The pixel electrode layer PXL may include multiple pixel electrodes. FIG. 23 shows the first pixel electrode PE1 of the first pixel PX1, the second pixel electrode PE2 of the second pixel PX2, and the third pixel electrode PE3 of the third pixel PX3. Each of the first pixel electrode PE1, the second pixel electrode PE2, and the third pixel electrode PE3 may include a first area PEA1 (see FIG. 9) and a second area PEA2 surrounding the first area PEA1.

The first pixel electrode PE1 may be electrically connected to a connection electrode 191 included in the third source-drain layer SD3 through a contact hole 91 passing through the third planarization insulating layer 108'. Accordingly, the first pixel electrode PE1 may be electrically connected to the driving transistor T1 to which the first driving voltage ELVDD1 is applied through the emission control transistor T6 in the first pixel area PXA1. The contact hole 91 may be disposed to correspond to the second area of the first pixel electrode PE1.

The second pixel electrode PE2 may be electrically connected to a connection electrode 192 included in the third source-drain layer SD3 through a contact hole 92 passing through the third planarization insulating layer 108'. Accordingly, the second pixel electrode PE2 may be electrically connected to the driving transistor T1 to which the first driving voltage ELVDD1 is applied through the emission control transistor T6 in the second pixel area PXA2. The contact hole 92 may be disposed to correspond to the second area of the second pixel electrode PE2.

The third pixel electrode PE3 may be electrically connected to a connection electrode 193 included in the third source-drain layer SD3 through a contact hole 93 passing through the third planarization insulating layer 108'. Accordingly, the third pixel electrode PE3 may be electrically connected to the driving transistor T1 to which the second driving voltage ELVDD2 is applied through the emission control transistor T6 in the third pixel area PXA3. The contact hole 93 may be disposed to correspond to the second area of the third pixel electrode PE3.

The pixel electrode layer PXL may be a (semi) light-transmissive conductive layer or a reflective conductive layer. For example, the pixel electrode layer PXL may include a reflective layer and a transparent or semi-transparent electrode layer on the reflective layer, where the reflective layer includes Ag, Mg, Al, Pt, Pd, Au, Ni, Nd, Ir, Cr, or compound thereof. The transparent or semi-transparent electrode layer may include at least one of indium tin oxide (ITO), indium zinc oxide (IZO), zinc oxide (ZnOx: ZnO or ZnO₂), indium oxide (In₂O₃), indium gallium oxide (IGO), or aluminum zinc oxide (AZO). For example, the pixel electrode layer PXL may have a three-layered structure of ITO/Ag/ITO.

For reference, the first pixel electrode PE1 and the third pixel electrode PE3 may be alternately arranged in the second direction (e.g., y-axis direction). The second pixel electrodes PE2 are arranged in the second direction (e.g., y-axis direction). Accordingly, the first pixel electrode PE1 and the third pixel electrode PE3 are alternately arranged in the second driving voltage line PL2, and the second pixel electrodes PE2 are arranged in the first driving voltage line PL1. Consequently, this may be understood that the first-color pixel circuits and the third-color pixel circuits are alternately arranged in the second driving voltage line PL2, and the second-color pixel circuits are arranged in the first driving voltage line PL1.

A pixel-defining layer 109 may be disposed on the third planarization insulating layer 108' to cover the edges of each of the first pixel electrode PE1, the second pixel electrode PE2, and the third pixel electrode PE3. The pixel-defining layer 109 may define a pixel by including an opening corresponding to an emission area of each pixel. For reference, in FIG. 24, the opening of the pixel-defining layer 109 is not shown due to the location of the cross-sectional view. An emission layer may be disposed in the opening of the pixel-defining layer 109, and the common electrode CAT may be disposed on the emission layer. The first pixel electrode PE1, the second pixel electrode PE2, the third pixel electrode PE3, the emission layer, and the common electrode CAT may configure organic light-emitting diodes. The common electrode CAT may be integrally formed as a single body throughout multiple organic light-emitting diodes to correspond to multiple pixel electrodes. For reference, a layer configuration between the first pixel electrode PE1 or the second pixel electrode PE2 and the common electrode CAT, and a layer configuration between the third pixel electrode PE3 and the common electrode CAT may be the same as those described with reference to FIGS. 10 and 11. For convenience, FIG. 24 does not show a layer between the pixel electrode and the common electrode CAT.

The common electrode CAT may be a light-transmissive electrode or a reflective electrode. For example, the common electrode CAT may be a transparent or semi-transparent electrode and may include a metal thin film including Li, Ca, Al, Ag, Mg, or compound (e.g., LiF) thereof and having a small work function. The common electrode CAT may further include a transparent conductive oxide (TCO) layer such as ITO, indium zinc oxide (IZO), ZnO, ZnO₂, or In₂O₃ disposed on the metal thin film. The common electrode CAT may be integrally formed as a single body throughout the entire surface of the display area DA to cover the display area DA.

When needed, an encapsulation layer may be disposed on the common electrode CAT. The encapsulation layer may include a first inorganic encapsulation layer, a second inorganic encapsulation layer, and an organic encapsulation layer therebetween.

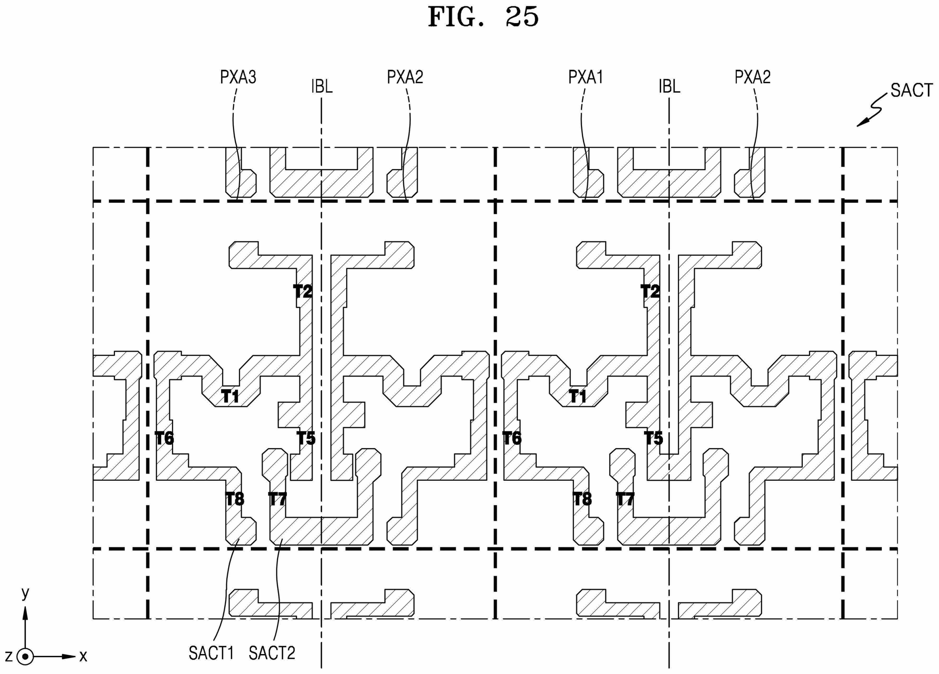

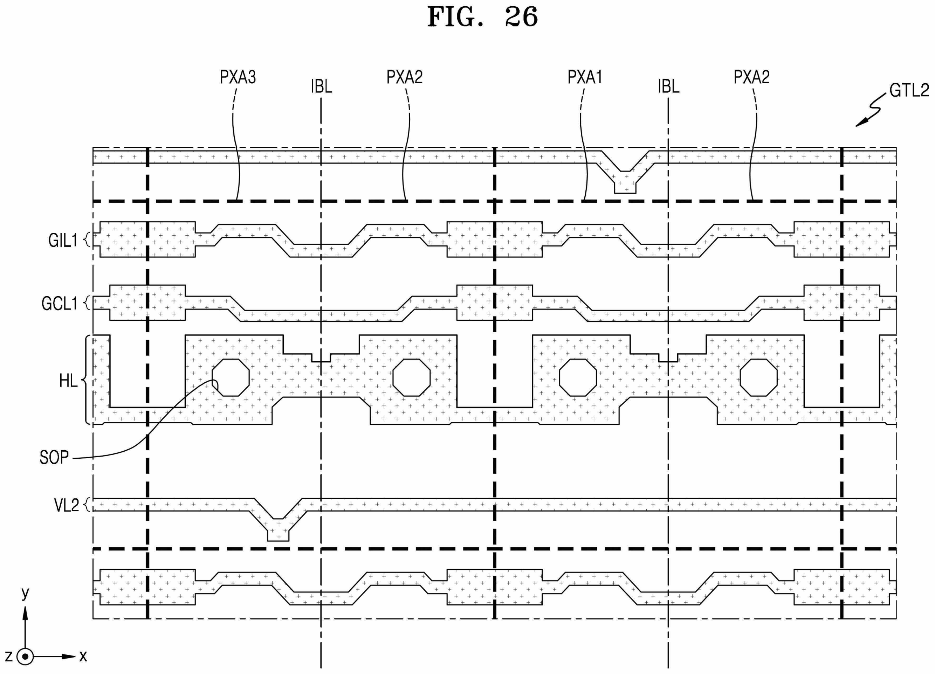

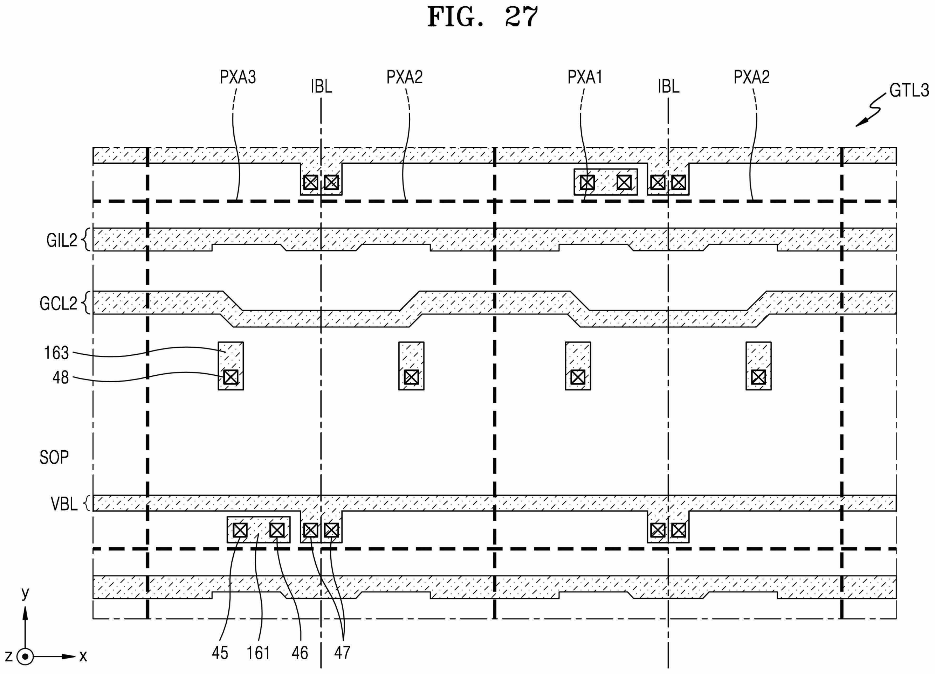

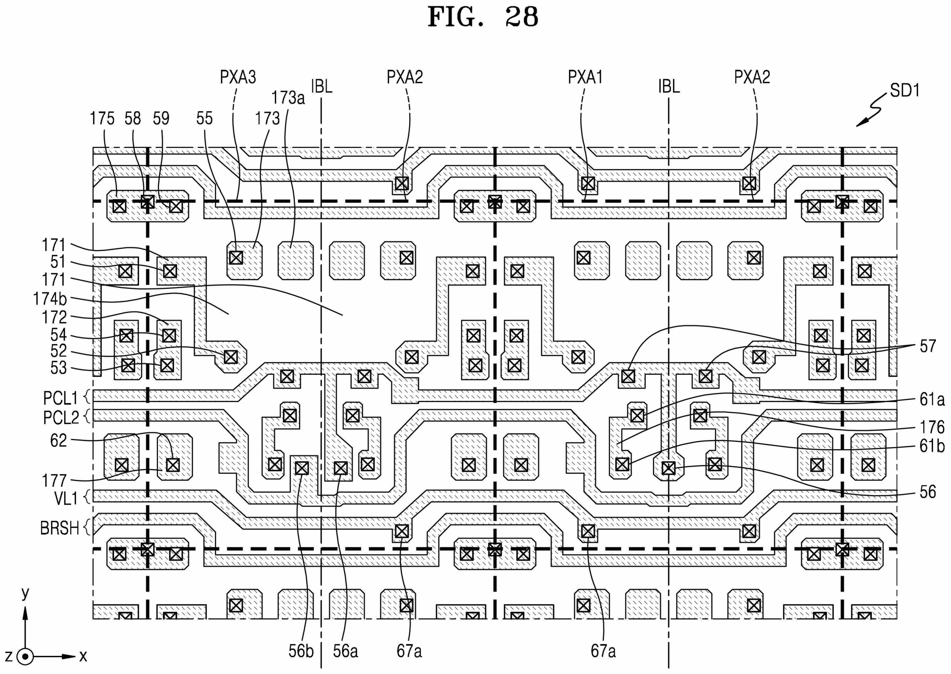

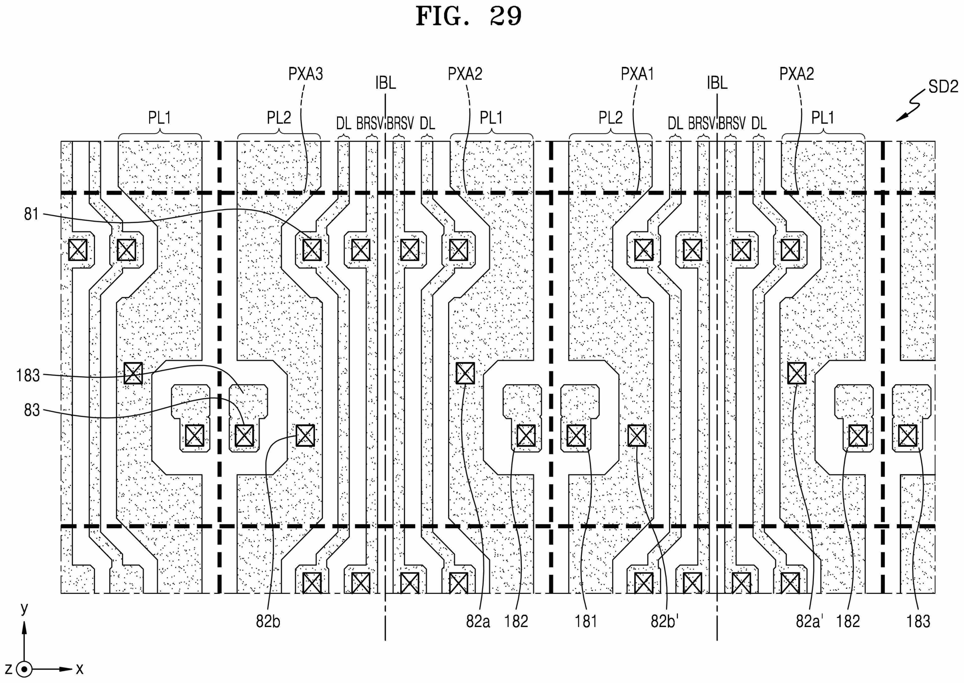

FIGS. 25 to 29 are schematic arrangement views of elements such as transistors and capacitors, for each layer, of the display panel 10 and the electronic apparatus 1 including the same according to an embodiment. The display panel 10 according to the embodiment may include the first semiconductor layer SACT disposed on the buffer layer of the substrate 100 and shown in FIG. 25, the first gate layer GTL1 disposed thereon and shown in FIG. 16, the second gate layer GTL2 disposed thereon and shown in FIG. 26, the second semiconductor layer OACT disposed thereon and shown in FIG. 18, the third gate layer GTL3 disposed thereon and shown in FIG. 27, the first source-drain layer SD1 disposed thereon and shown in FIG. 28, the second source-drain layer SD2 disposed thereon and shown in FIG. 29, and the pixel electrode layer PXL disposed thereon and shown in FIG. 23. As described above, the insulating layer, planarization layer, or the like may be disposed therebetween.

The first semiconductor layer SACT shown in FIG. 25 may be disposed on the buffer layer 101. The first semiconductor layer SACT may include a silicon semiconductor. Like the description in the above embodiment, the first semiconductor layer SACT may include the first sub-semiconductor layer SACT1 and the second sub-semiconductor layer SACT2 separated from the first sub-semiconductor layer SACT1. In the display panel 10 and the electronic apparatus 1 including the same according to the embodiment, the second sub-semiconductor layer SACT2 in the third pixel area PXA3 and the second sub-semiconductor layer SACT2 in the second pixel area PXA2 disposed adjacent thereto in the +x direction may be integrally formed as a single body. Likewise, the first sub-semiconductor layer SACT1 of the first pixel area PXA1 and the second sub-semiconductor layer SACT2 in the second pixel area PXA2 disposed adjacent thereto in the +x direction may be integrally formed as a single body. The above description with reference to FIG. 15 is directly applicable to the first semiconductor layer SACT shown in FIG. 25.

As described above, the first gate insulating layer 102 may cover the first semiconductor layer SACT. The first gate layer GTL1 described above and shown in FIG. 16 may be disposed on the first gate insulating layer 102, and the second gate insulating layer 103 may cover the first gate layer GTL1.

As shown in FIG. 26, the second gate layer GTL2 may be disposed on the second gate insulating layer 103. A difference between the second gate layer GTL2 of the display panel 10 and the electronic apparatus 1 including the same according to the embodiment and the second gate layer GTL2 described with reference to FIG. 17 is that the second gate layer GTL2 further includes the second electrode initialization voltage line VL2 extending in the first direction (e.g., x-axis direction) between the lower gate line GIL1 and the electrode voltage line HL also serving as the upper electrode of the storage capacitor Cst.

The first interlayer insulating layer 104 may be disposed on the second gate layer GTL2, and the second semiconductor layer OACT shown in FIG. 18 may be disposed on the first interlayer insulating layer 104. The third gate insulating layer 105 may be disposed on the second semiconductor layer OACT.

As shown in FIG. 27, the third gate layer GTL3 may be disposed on the third gate insulating layer 105. A difference between the third gate layer GTL3 of the display panel 10 and the electronic apparatus 1 including the same according to the embodiment and the third gate layer GTL3 described with reference to FIG. 19 may be that the third gate layer GTL3 includes a connection electrode 161 and a connection electrode 163, and does not include the second electrode initialization voltage line VL2, and some elements included in the third gate layer GTL3 are electrically connected to elements thereunder through contact holes 45, 47, and 48.

The connection electrode 161 may be disposed in the third pixel area PXA3. The connection electrode 161 may be electrically connected to a source region of the electrode initialization transistor T8 in the third pixel area PXA3 through the contact hole 45 formed in the insulating layers thereunder, and simultaneously, be electrically connected to the second electrode initialization voltage line VL2 through the contact hole 46 formed in the third gate insulating layer 105. Accordingly, the second electrode initialization voltage Vaint2 from the second electrode initialization voltage line VL2 may be applied to the electrode initialization transistor T8 in the third pixel area PXA.

The connection electrode 163 may be electrically connected to the driving gate electrode 131a included in the first gate layer GTL1 through the contact hole 48 formed in the insulating layers thereunder. The connection electrode 163 is electrically connected to the connection electrode 171 included in the first source-drain layer SD1. This is described below.

The bias voltage line VBL extending in the first direction (e.g., x-axis direction) at a protrusion portion protruding in the second direction (e.g., y-axis direction) may be electrically connected to a source region of the bias transistor T7 through the contact holes 47 formed in the insulating layers thereunder. Accordingly, the bias voltage VOBS from the bias voltage line VBL may be applied to the bias transistor T7. For reference, because the second sub-semiconductor layer SACT2 in the third pixel area PXA3 and the second sub-semiconductor layer SACT2 in the second pixel area PXA2 disposed adjacent thereto in the +x direction are integrally formed as a single body, the contact holes 47 in the third pixel area PXA3 and the second pixel area PXA2 disposed adjacent thereto in the +x direction may be disposed to correspond to a portion between the second sub-semiconductor layer SACT2 in the third pixel area PXA3 and the second sub-semiconductor layer SACT2 in the second pixel area PXA2. Likewise, because the second sub-semiconductor layer SACT2 in the first pixel area PXA1 and the second sub-semiconductor layer SACT2 in the second pixel area PXA2 disposed adjacent thereto in the +x direction are integrally formed as a single body, the contact holes 47 in the first pixel area PXA1 and the second pixel area PXA2 disposed adjacent thereto in the +x direction may be disposed to correspond to a portion between the second sub-semiconductor layer SACT2 in the third pixel area PXA3 and the second sub-semiconductor layer SACT2 in the second pixel area PXA2.

As described above with reference to FIG. 26, because the second gate layer GTL2 includes the second electrode initialization voltage line VL2, the third gate layer GTL3 may not include the second electrode initialization voltage line VL2.

As described above, the second interlayer insulating layer 106 may cover the third gate layer GTL3.

The first source-drain layer SD1 shown in FIG. 28 may be disposed on the second interlayer insulating layer 106. A difference between the first source-drain layer SD1 of the display panel 10 and the electronic apparatus 1 including the same according to the embodiment and the first source-drain layer SD1 described with reference to FIG. 20 is that the first source-drain layer SD1 does not include connection electrodes 174a, 174b, 174c, 174d, 178, and 179, and instead, further includes a first connection line PCL1 and a second connection line PCL2, and the shapes of some connection electrodes other than that are transformed. For other matters, the above description with reference to FIG. 20 may also be applied to the first source-drain layer SD1 shown in FIG. 28.

One end of the connection electrode 171 may be electrically connected to the second semiconductor layer OACT by being in contact with the second semiconductor layer OACT through a contact hole 51. For example, one end of the connection electrode 171 may be electrically connected to the compensation transistor T3 and the initialization transistor T4 through the contact hole 51 passing through the insulating layers thereunder. Another end of the connection electrode 171 may be electrically connected to the connection electrode 163 through the contact hole 52 passing through the second interlayer insulating layer 106 thereunder. As described above, the connection electrode 163 may be electrically connected to the driving gate electrode 131a included in the first gate layer GTL1 through the contact hole 48 formed in the insulating layers thereunder. Accordingly, the compensation transistor T3 and the initialization transistor T4 may be electrically connected to the driving gate electrode 131a by the connection electrode 171 and the connection electrode 163.

The first connection line PCL1 may extend in the first direction (e.g., x-axis direction). The first connection line PCL1 may be electrically connected to the electrode voltage line HL also serving as the upper electrode of the storage capacitor Cst through the contact hole 57 formed in the insulating layers thereunder.

In the second pixel area PXA2 of a second area among the third pixel area PXA3, the second pixel area PXA2, the first pixel area PXA1, and the second pixel area PXA2 sequentially arranged in the first direction (e.g., x-axis direction), the first connection line PCL1 may include a protrusion portion protruding in the second direction (e.g., y-axis direction) and be electrically connected, at the end of the protrusion portion, to a source region of the operation control transistor T5 in the second pixel area PXA2 through a contact hole 56a passing through the insulating layers thereunder. In the first pixel area PXA1 and the second pixel area PXA2 in the fourth area among the third pixel area PXA3, the second pixel area PXA2, the first pixel area PXA1, and the second pixel area PXA2 sequentially arranged in the first direction (e.g., x-axis direction), the first connection line PCL1 may have a protrusion portion extending in the boundary between the first pixel area PXA1 and the second pixel area PXA2 and be electrically connected, at the end of the protrusion portion, to the first sub-semiconductor layer SACT1 which is integrally formed as a single body in the first pixel area PXA1 and the second pixel area PXA2 through the contact hole 56 formed in the insulating layers thereunder, and consequently, be electrically connected to a source region of the operation control transistor T5 in the first pixel area PXA1 and a source region of the operation control transistor T5 in the second pixel area PXA2.

As described below, the first connection line PCL1 may be electrically connected to the first driving voltage line PL1 thereabove. Accordingly, the first driving voltage ELVDD1 of the first driving voltage line PL1 may be transferred to the operation control transistor T5 in the first pixel PX1, the operation control transistor T5 in the second pixel PX2, and the electrode voltage line HL may also serve as the upper electrode of the storage capacitor Cst of all the pixels.

The second connection line PCL2 may also extend in the first direction (e.g., x-axis direction). The second connection line PCL2 may have a protrusion portion protruding in the second direction (e.g., y-axis direction) in the third pixel area PXA3, and be electrically connected, at this protrusion portion, to a source region of the operation control transistor T5 in the third pixel area PXA3 through the contact hole 56b formed in the insulating layers thereunder.

As described below, the second connection line PCL2 may be electrically connected to the second driving voltage line PL2 thereabove. Accordingly, the second driving voltage ELVDD2 of the second driving voltage line PL2 may be transferred to the operation control transistor T5 in the third pixel PX3, and accordingly, be applied to the third pixel electrode PE3 of the third light-emitting element OLED3 through the driving transistor T1 and the like.

As described above, the first planarization insulating layer 107 may cover the first source-drain layer SD1.

As shown in FIG. 29, a second source-drain layer SD2 may be disposed on the first planarization insulating layer 107. A difference between the second source-drain layer SD2 of the display panel 10 and the electronic apparatus 1 including the same according to the embodiment and the second source-drain layer SD2 described with reference to FIG. 21 may be positions of the contact holes 82a, 82a', 82b, and 82b'.

In the second pixel area PXA2 in a second area among the third pixel area PXA3, the second pixel area PXA2, the first pixel area PXA1, and the second pixel area PXA2 sequentially arranged in the first direction (e.g., x-axis direction), the first driving voltage line PL1 extending in the second direction (e.g., y-axis direction) may be electrically connected to the first connection line PCL1 in the second pixel area PXA2 through the contact hole 82a passing through the first planarization insulating layer 107 thereunder. Likewise, the first driving voltage line PL1 extending in the second direction (e.g., y-axis direction) to pass across the second pixel area PXA2, which is a fourth area, may be electrically connected to the first connection line PCL1 in the second pixel area PXA2 through the contact hole 82a' passing through the first planarization insulating layer 107 thereunder.

As described above, the first connection line PCL1 may be electrically connected to the electrode voltage line HL also serving as the upper electrode of the storage capacitor Cst through the contact hole 57 formed in the insulating layers thereunder. Accordingly, the electrode voltage lines HL and the first connection lines PCL1 extending in the first direction (e.g., x-axis direction) and the first driving voltage lines PL1 extending in the second direction (e.g., y-axis direction) may be electrically connected to each other to form a mesh structure entirely. Accordingly, a voltage drop (IR drop) of the first driving voltage ELVDD1 in the display area DA may be prevented or reduced.

In the third pixel area PXA3, the second driving voltage line PL2 extending in the second direction (e.g., y-axis direction) may be electrically connected to the second connection line PCL2 in the third pixel area PXA3 through the contact hole 82b passing through the first planarization insulating layer 107 thereunder. In the first pixel area PXA1, the second driving voltage line PL2 extending in the second direction (e.g., y-axis direction) may be electrically connected to the second connection line PCL2 in the third pixel area PXA3 through the contact hole 82b' passing through the first planarization insulating layer 107 thereunder. Accordingly, the second connection lines PCL2 extending in the first direction (e.g., x-axis direction) and the second driving voltage lines PL2 extending in the second direction (e.g., y-axis direction) may be electrically connected to each other to form a mesh structure entirely. Accordingly, a voltage drop (IR drop) of the second driving voltage ELVDD2 in the display area DA may be prevented or reduced.

The second planarization insulating layer 108 may cover the second source-drain layer SD2 shown in FIG. 29. The pixel electrode layer PXL shown in FIG. 23 may be disposed on the second planarization insulating layer 108. For example, the display panel 10 and the electronic apparatus 1 including the same according to the embodiment may not include the third source-drain layer SD3. Accordingly, the display panel 10 displaying high-quality images, and the electronic apparatus 1 including the same with even a simple structure may be implemented.

For reference, unlike FIG. 23, the position of the contact hole 91 may be changed to correspond to the connection electrode 181 included in the second source-drain layer SD2. Likewise, the position of the contact hole 92 may be changed to correspond to the connection electrode 182 included in the second source-drain layer SD2, and the position of the contact hole 93 may be changed to correspond to the connection electrode 183 included in the second source-drain layer SD2.

The first pixel electrode PE1 may be electrically connected to the connection electrode 181 included in the second source-drain layer SD2 through the contact hole 91 passing through the second planarization insulating layer 108. Accordingly, the first pixel electrode PE1 may be electrically connected to the driving transistor T1 to which the first driving voltage ELVDD1 is applied through the emission control transistor T6 in the first pixel area PXA1.

The second pixel electrode PE2 may be electrically connected to the connection electrode 182 included in the second source-drain layer SD2 through the contact hole 92 passing through the second planarization insulating layer 108. Accordingly, the second pixel electrode PE2 may be electrically connected to the driving transistor T1 to which the first driving voltage ELVDD1 is applied through the emission control transistor T6 in the second pixel area PXA2.

The third pixel electrode PE3 may be electrically connected to the connection electrode 183 included in the second source-drain layer SD2 through the contact hole 93 passing through the second planarization insulating layer 108. Accordingly, the third pixel electrode PE3 may be electrically connected to the driving transistor T1 to which the second driving voltage ELVDD2 is applied through the emission control transistor T6 in the third pixel area PXA3.

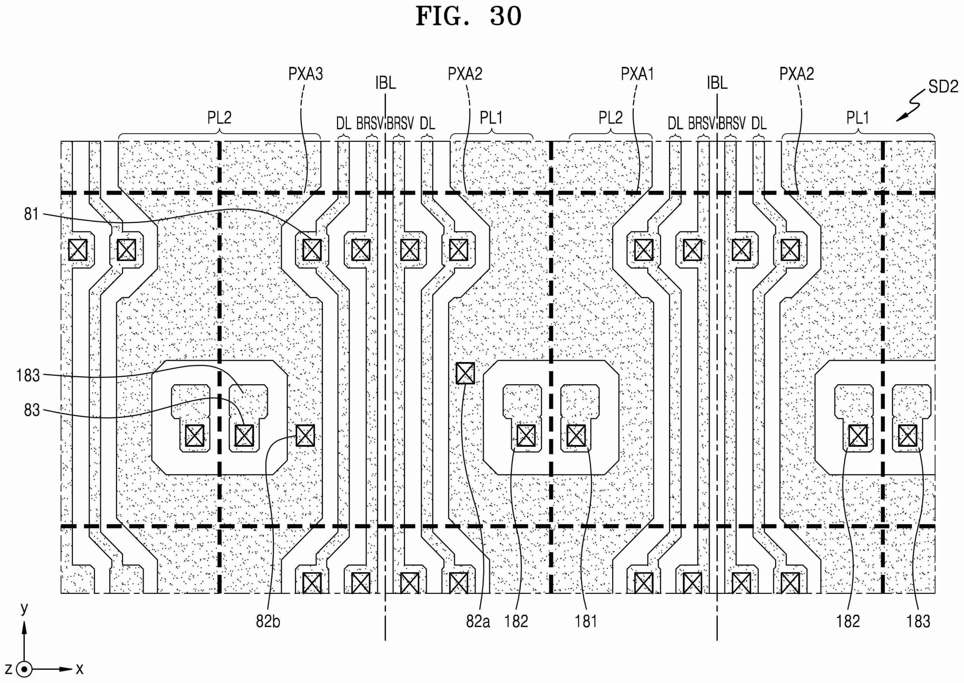

The second source-drain layer SD2 may be transformed in other ways. For example, as shown in FIG. 30 which is a schematic arrangement view of the second source-drain layer SD2 of the display panel 10 and the electronic apparatus 1 including the same, in a structure in which a set of the third pixel area PXA3, the second pixel area PXA2, the first pixel area PXA1, and the second pixel area PXA2 sequentially arranged in the first direction (e.g., x-axis direction) is repeatedly positioned, the second driving voltage line PL2 may be disposed over the third pixel area PXA3 and the second pixel area PXA2 disposed adjacent thereto in the -x direction, and the first driving voltage line PL1 may be disposed over the first pixel area PXA1 and the second pixel area PXA2 disposed adjacent thereto in the -x direction.

For example, the first driving voltage line PL1 may be electrically connected to the first connection line PCL1 therebelow through the contact hole 82a in the second pixel area PXA2 adjacent in the -x direction to the first pixel area PXA1, and the second driving voltage line PL2 may be electrically connected to the second connection line PCL2 therebelow through the contact hole 82b in the third pixel area PXA3. The first driving voltage line PL1 may include an opening in an intermediate portion thereof, and the connection electrode 181 in the first pixel area PXA1 and the connection electrode 182 in the second pixel area PXA2 disposed adjacent thereto in the -x direction may be disposed in the opening. Likewise, the second driving voltage line PL2 may include an opening in an intermediate portion thereof, and the connection electrode 183 in the third pixel area PXA3 and the connection electrode 182 in the second pixel area PXA2 disposed adjacent thereto in the -x direction may be disposed in the opening.

Up to this point, although description has been made to the case where the display panel 10 and the electronic apparatus 1 including the same include the second semiconductor layer OACT, which is an oxide semiconductor layer, the invention is not limited thereto. Hereinafter, the case where the display panel 10 and the electronic apparatus 1 including the same include only the first semiconductor layer SACT is described. For example, the first light-emitting element OLED1 that may emit red light and the second light-emitting element OLED2 that may emit green light may have a layered structure shown in FIG. 10, and the third light-emitting element OLED3 that may emit blue light may have a layered structure shown in FIG. 11.

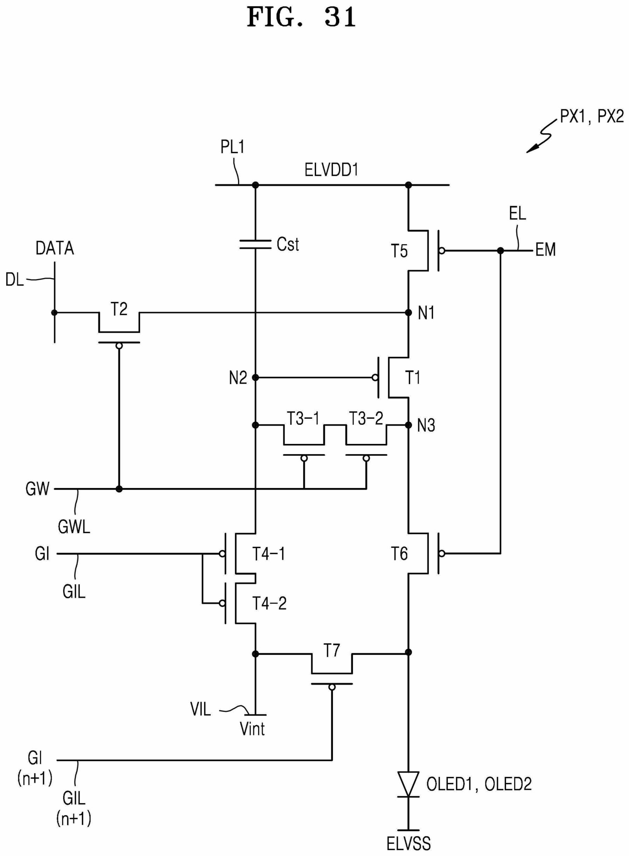

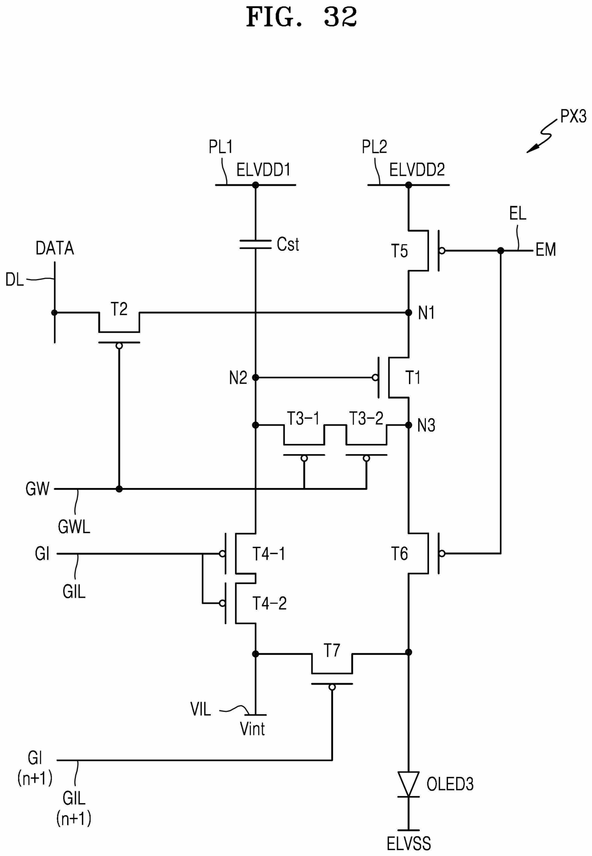

FIG. 31 is a schematic diagram of an equivalent circuit PC that may be electrically connected to the first light-emitting element OLED1 or the second light-emitting element OLED2, and FIG. 32 is a schematic diagram of an equivalent circuit PC that may be electrically connected to the third light-emitting element OLED3. First, the pixel circuit PC represented as the equivalent circuit diagram shown in FIG. 31 is described, and a portion represented as the equivalent circuit diagram shown in FIG. 32 having different points from those of FIG. 31 is described.

As shown in FIG. 31, the pixel circuit PC may include multiple thin-film transistors T1, T2, T3, T4, T5, T6, and T7, and the storage capacitor Cst. Multiple thin-film transistors T1, T2, T3, T4, T5, T6, and T7 and the storage capacitor Cst may be connected to signal lines GWL, GIL, EL, and DL, the initialization voltage line VIL, and the first driving voltage line PL1. At least one of the lines, for example, the first driving voltage line PL1 may be shared by pixels disposed adjacent to each other.

Multiple thin-film transistors T1, T2, T3, T4, T5, T6, and T7 may include the driving transistor T1, the switching transistor T2, the compensation transistor T3, the initialization transistor T4, the operation control transistor T5, the emission control transistor T6, and the electrode initialization transistor T7. The compensation transistor T3 may include a first compensation transistor T3-1 and a second compensation transistor T3-2. For example, the first compensation transistor T3-1 and the second compensation transistor T3-2 may be serially connected each other. The initialization transistor T4 may include a first initialization transistor T4-1 and a second initialization transistor T4-2. For example, the first initialization transistor T4-1 and the second initialization transistor T4-2 may be serially connected each other.

The first light-emitting element OLED1 and/or the second light-emitting element OLED2 may include the pixel electrode and the common electrode. The pixel electrode may be connected to the driving transistor T1 through the emission control transistor T6, and the common electrode may receive the common voltage ELVSS. The first light-emitting element OLED1 and/or the second light-emitting element OLED2 may generate light of a brightness corresponding to a driving current.

Multiple thin-film transistors T1, T2, T3, T4, T5, T6, and T7 may be p-channel metal oxide semiconductor field-effect transistors (MOSFETs). When needed, multiple thin-film transistors T1, T2, T3, T4, T5, T6, and T7 may be n-channel metal oxide semiconductor field-effect transistors (MOSFETs). Hereinafter, for convenience, the case where multiple thin-film transistors T1, T2, T3, T4, T5, T6, and T7 are p-channel metal oxide semiconductor field-effect transistors (MOSFETs) including amorphous silicon or polycrystalline silicon is described.

Signal lines may include the first scan line GWL, the third scan line GIL, a fifth scan line GIL (n+1), the emission control line EL, and the data line DL, where the first scan line GWL transfers a first scan signal GW, the third scan line GIL transfers an initialization scan signal GI to the initialization transistor T4, the fifth scan line GIL (n+1) transfers an electrode initialization scan signal GI (n+1) to the electrode initialization transistor T7, the emission control line EL transfers an emission control signal EM to the operation control transistor T5 and the emission control transistor T6, and the data line DL crosses the first scan line GWL and transfers a data signal DATA.

The first driving voltage line PL1 may transfer the first driving voltage ELVDD1 to the driving transistor T1, and the initialization voltage line VIL may transfer the initialization voltage Vint initializing the driving transistor T1. The initialization voltage Vint of the initialization voltage line VIL may be used for the purpose of initializing the pixel electrode of the first light-emitting element OLED1 and/or the second light-emitting element OLED2.

A driving gate electrode of the driving transistor T1 may be connected to the storage capacitor Cst through a second node N2, one of a source region and a drain region of the driving transistor T1 may be connected to the first driving voltage line PL1 through the operation control transistor T5 via a first node N1, and the other of the source region and the drain region of the driving transistor T1 may be electrically connected to the pixel electrode of the first light-emitting element OLED1 and/or the second light-emitting element OLED2 through the emission control transistor T6 via a third node N3. The driving transistor T1 may receive a data signal DATA and supply the driving current to the first light-emitting element OLED1 and/or the second light-emitting element OLED2 according to a switching operation of the switching transistor T2.

A switching gate electrode of the switching transistor T2 may be connected to the first scan line GWL which transfers a first scan signal GW, one of a source region and a drain region of the switching transistor T2 may be connected to the data line DL, and the other of the source region and the drain region of the switching transistor T2 may be connected to the driving transistor T1 through the first node N1 and connected to the first driving voltage line PL1 through the operation control transistor T5. The switching transistor T2 may transfer a data signal DATA from the data line DL to the first node N1 in response to a voltage applied to the first scan line GWL. For example, the switching transistor T2 may perform a switching operation of being turned on according to a first scan signal GW transferred through the first scan line GWL and transferring a data signal DATA to the driving transistor T1 through the first node N1, the data signal DATA being transferred through the data line DL.

A compensation gate electrode of the compensation transistor T3 may also be connected to the first scan line GWL. One of a source region and a drain region of the compensation transistor T3 may be connected to the pixel electrode of the first light-emitting element OLED1 and/or the second light-emitting element OLED2 through the emission control transistor T6 via the third node N3. Another of the source region and the drain region of the compensation transistor T3 may be connected to a first capacitor electrode of the storage capacitor Cst, and the driving gate electrode of the driving transistor T1 through the second node N2. The compensation transistor T3 may diode-connect the driving transistor T1 by being turned on according to a first scan signal GW received through the first scan line GWL.

An initialization gate electrode of the initialization transistor T4 may be connected to the third scan line GIL. One of a source region and a drain region of the initialization transistor T4 may be connected to the initialization voltage line VIL. Another of the source region and the drain region of the initialization transistor T4 may be connected to the first capacitor electrode of the storage capacitor Cst, and the driving gate electrode of the driving transistor T1 through the second node N2. The initialization transistor T4 may apply the initialization voltage Vint from the initialization voltage line VIL to the second node N2 according to a voltage applied to the third scan line GIL, which is a previous scan line. For example, the initialization transistor T4 may be turned on according to an initialization scan signal GI received through the third scan line GIL and may perform an initialization operation of initializing the voltage of the driving gate voltage of the driving transistor T1 by transferring the initialization voltage Vint to the driving gate electrode of the driving transistor T1.

An operation control gate electrode of the operation control transistor T5 may be connected to the emission control line EL, one of a source region and a drain region of the operation control transistor T5 may be connected to the first driving voltage line PL1, and another of the source region and the drain region of the operation control transistor T5 may be connected to the driving transistor T1 and the switching transistor T2 through the first node N1.

An emission control gate electrode of the emission control transistor T6 may be connected to the emission control line EL, one of a source region and a drain region of the emission control transistor T6 may be connected to the driving transistor T1 and the compensation transistor T3 through the third node N3, and the other of the source region and the drain region of the emission control transistor T6 may be electrically connected to the pixel electrode of the first light-emitting element OLED1 and/or the second light-emitting element OLED2.

The operation control transistor T5 and the emission control transistor T6 may be simultaneously turned on according to an emission control signal EM transferred through the emission control line EL to allow an electrical signal from the first driving voltage line PL1 to be transferred to the first light-emitting element OLED1 and/or the second light-emitting element OLED2, thereby allowing the driving current to flow through the first light-emitting element OLED1 and/or the second light-emitting element OLED2.

The electrode initialization gate electrode of the electrode initialization transistor T7 may be connected to the fifth scan line GIL (n+1), which is a next scan line, one of a source region and a drain region of the electrode initialization transistor T7 may be connected to the first light-emitting element OLED1 and/or the second light-emitting element OLED2, and another of the source region and the drain region of the electrode initialization transistor T7 may be connected to the initialization voltage line VIL to receive the initialization voltage Vint. The electrode initialization transistor T7 may be turned on according to an electrode initialization scan signal GI (n+1) transferred through the fifth scan line GIL (n+1), and may initialize the pixel electrodes of the first light-emitting element OLED1 and/or the second light-emitting element OLED2.

The storage capacitor Cst may include the first capacitor electrode and the second capacitor electrode. The first capacitor electrode of the storage capacitor Cst may be connected to the driving gate electrode of the driving transistor T1 through the second node N2, and the second capacitor electrode of the storage capacitor Cst may be connected to the first driving voltage line PL1. The storage capacitor Cst may store charge corresponding to a difference between a voltage of the driving gate electrode of the driving transistor T1 and the first driving voltage ELVDD1.

Because a specific operation of each pixel according to an embodiment is similar to an operation described with reference to FIG. 12, description thereof is omitted.

Unlike the pixel circuit described above with reference to FIG. 31, the pixel circuit PC shown in FIG. 32 that may be electrically connected to the third light-emitting element OLED3 included in the third pixel PX3 may also include the second driving voltage line PL2 in addition to the first driving voltage line PL1.

Even in case of the pixel circuit electrically connected to the third light-emitting element OLED3, the first capacitor electrode of the storage capacitor Cst is connected to the driving gate electrode of the driving transistor T1 through the second node N2, and the second capacitor electrode of the storage capacitor Cst is connected to the first driving voltage line PL1. Accordingly, In case that the same data signal as a data signal applied to the pixel circuit electrically connected to the first light-emitting element OLED1 is applied to the pixel circuit electrically connected to the third light-emitting element OLED3, the same electrical potential as an electrical potential between the source electrode and the gate electrode of the driving transistor T1 of the pixel circuit electrically connected to the first light-emitting element OLED1 may be applied between the source electrode and the gate electrode of the driving transistor T1 of the pixel circuit electrically connected to the third light-emitting element OLED3. Accordingly, in case that the same brightness data is applied, the driving transistor T1 of the pixel circuit electrically connected to the first light-emitting element OLED1, and the driving transistor T1 of the pixel circuit electrically connected to the third light-emitting element OLED3 may operate in the same manner.

However, in the pixel circuit electrically connected to the third light-emitting element OLED3, the driving transistor T1 may receive a second driving voltage ELVDD2 through the second driving voltage line PL2 instead of the first driving voltage line PL1. For example, the driving gate electrode of the driving transistor T1 may be connected to the storage capacitor Cst through the second node N2, one of the source region and the drain region of the driving transistor T1 may be connected to the second driving voltage line PL2 through the operation control transistor T5 via the first node N1, and another of the source region and the drain region of the driving transistor T1 may be electrically connected to the pixel electrode of the third light-emitting element OLED3 through the emission control transistor T6 via the third node N3. The driving transistor T1 may receive a data signal DATA and supply the driving current to the third light-emitting element OLED3 according to a switching operation of the switching transistor T2.

As described above, unlike the first light-emitting element OLED1 and/or the second light-emitting element OLED2, because the third light-emitting element OLED3 includes the electron generation layer 341, the hole generation layer 343, multiple emission layers 333 and 333, and the like, an electrical potential between the third pixel electrode PE3 of the third light-emitting element OLED3 and the common electrode CAT needs to be adjusted to be different from an electrical potential between the first pixel electrode PE1 of the first light-emitting element OLED1 and the common electrode CAT, or an electrical potential between the second pixel electrode PE2 of the second light-emitting element OLED2 and the common electrode CAT. In the display panel 10 and the electronic apparatus 1 including the display panel 10 according to the embodiment, as shown in FIGS. 31 and 32, an electrical potential between the first pixel electrode PE1 of the first light-emitting element OLED1 and the common electrode CAT, or an electrical potential between the second pixel electrode PE2 of the second light-emitting element OLED2 and the common electrode CAT may be maintained at about a difference between the first driving voltage ELVDD1 and the common voltage ELVSS, while an electrical potential between the third pixel electrode PE3 of the third light-emitting element OLED3 and the common electrode CAT may be maintained at about a difference between the second driving voltage ELVDD2 and the common voltage ELVSS. Accordingly, the display panel 10 displaying high-quality images, and the electronic apparatus 1 including the same may be implemented.

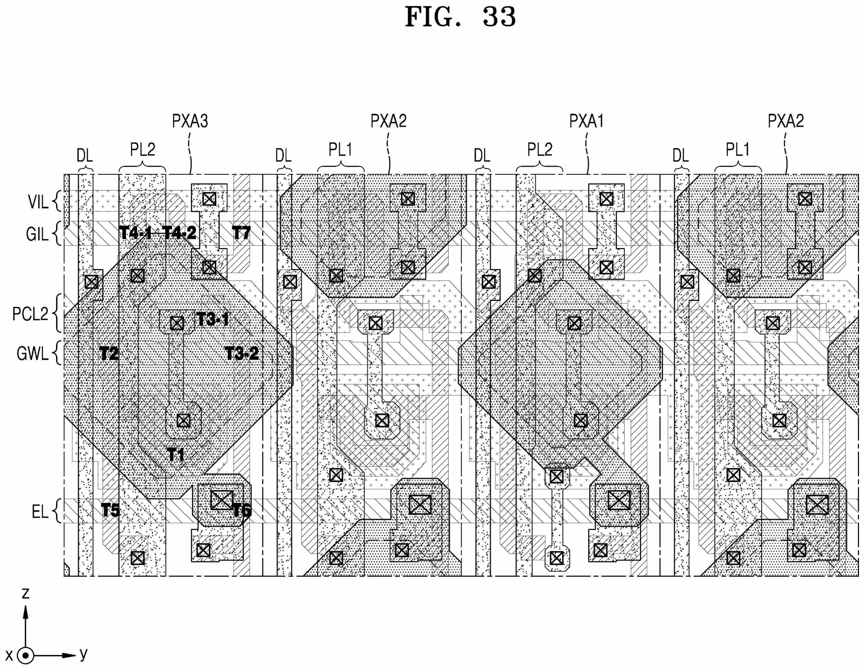

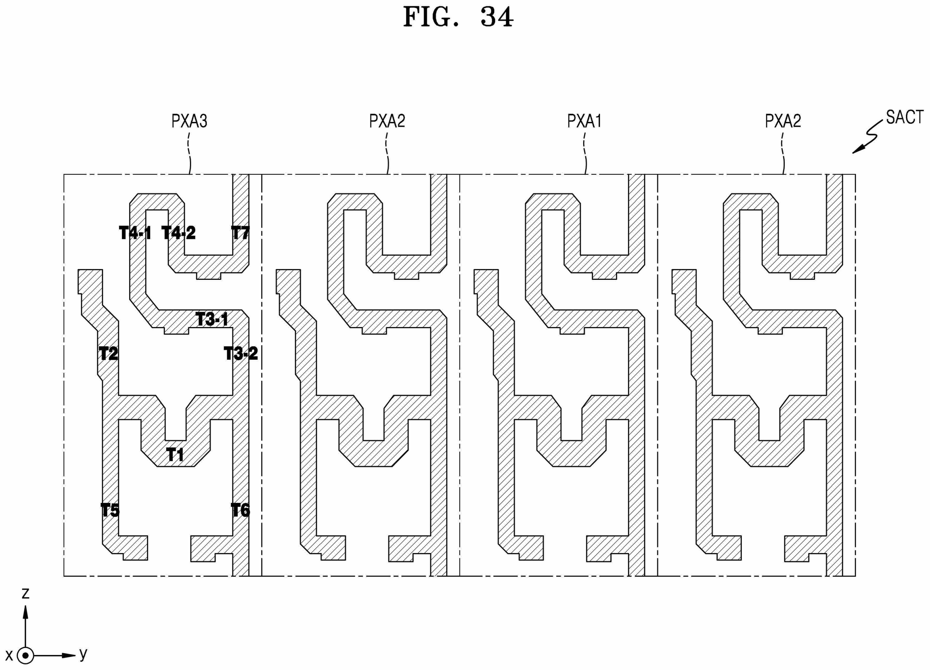

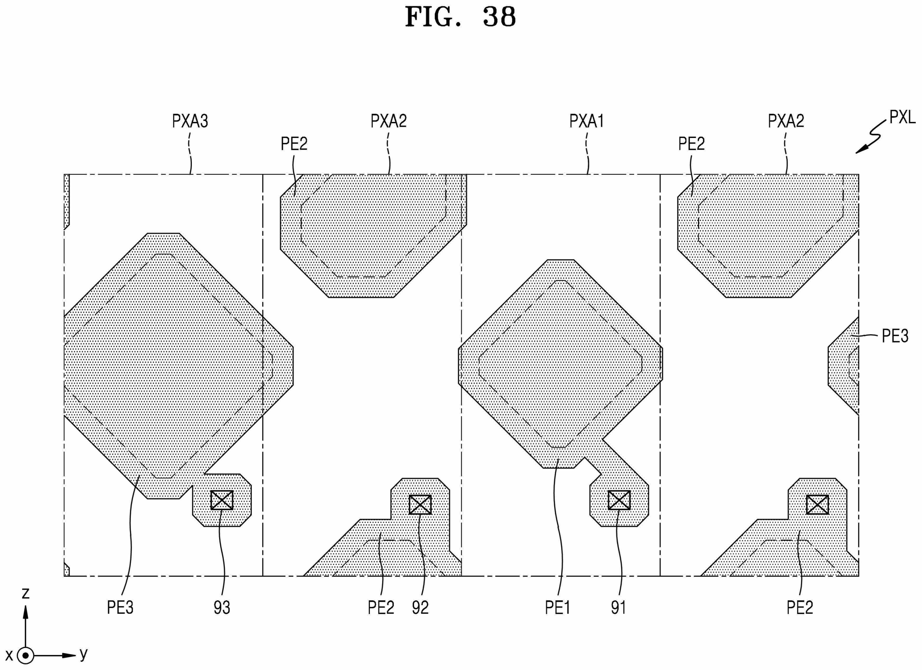

FIG. 33 is a schematic arrangement view of the positions of the transistors, capacitors, and the like in the pixels included in the display panel 10 including the pixel circuits of FIGS. 31 and 32, and the electronic apparatus 1 including the same. FIGS. 34 to 37 are schematic arrangement views of elements such as transistors and capacitors, for each layer, of the display panel 10 shown in FIG. 33. FIG. 38 is a schematic arrangement view of pixel electrodes of the display panel 10 having the arrangement view of FIG. 33.

The display panel 10 and the electronic apparatus 1 including the same may have a structure in which a set of the third pixel area PXA3, the second pixel area PXA2, the first pixel area PXA1, and the second pixel area PXA2 sequentially arranged in the first direction (e.g., x-axis direction) is repeatedly disposed in the first direction (e.g., x-axis direction). For reference, a region disposed adjacent to each of the +y direction and -y direction of the third pixel area PXA3 may be the first pixel area PXA1, a region disposed adjacent to each of the +y direction and -y direction of the first pixel area PXA1 may be the third pixel area PXA3, and a region disposed adjacent to each of the +y direction and -y direction of the second pixel area PXA2 may be the second pixel area PXA2.

The pixel circuit of the first pixel PX1 may be disposed in the first pixel area PXA1, the pixel circuit of the second pixel PX2 may be disposed in the second pixel area PXA2, and the pixel circuit of the third pixel PX3 may be disposed in the third pixel area PXA3. The third pixel area PXA3 and second pixel area PX2 disposed adjacent to each other may have a same shape with respect to an imaginary boundary line IBL as shown in FIG. 33 and the like. The first pixel area PXA1 and second pixel area PXA2 may have a similar shape with respect to an imaginary boundary line IBL as shown in FIG. 33 and the like. Unlike this, the pixel areas may have a symmetrical shape. However, various modifications may be made.

Hereinafter, for convenience of description, although some conductive patterns are described based on the pixel circuit disposed in the third pixel area PXA3, these conductive patterns may also be disposed in the first pixel area PXA1 and/or second pixel area PXA2 in a similar way.

The buffer layer may be disposed on the substrate 100, where the buffer layer 110 may include silicon oxide, silicon nitride, or silicon oxynitride. The buffer layer may prevent metal atoms or impurities and the like from the substrate 100 from diffusing to a first semiconductor layer SACT disposed thereon. The buffer layer may allow the first semiconductor layer SACT to be uniformly crystallized by adjusting a providing speed of heat during a crystallization process for forming the first semiconductor layer SACT.

The first semiconductor layer SACT shown in FIG. 34 may be disposed on the buffer layer. The first semiconductor layer SACT may include a silicon semiconductor. For example, the first semiconductor layer SACT may include amorphous silicon or polycrystalline silicon. For example, the first semiconductor layer SACT may include polycrystalline silicon crystallized at low temperature. When needed, ions may be implanted in at least a portion of the first semiconductor layer SACT. When needed, a lower metal layer corresponding to the shape of the first semiconductor layer SACT may be disposed under the first semiconductor layer SACT to protect the first semiconductor layer SACT. For example, an insulating layer may be disposed between the lower metal layer and the first semiconductor layer SACT.

The first semiconductor layer SACT may have a shape curved in various shapes. The driving transistor T1, the switching transistor T2, the compensation transistor T3, the initialization transistor T4, the operation control transistor T5, the emission control transistor T6, and the electrode initialization transistor T7 may be disposed in the first semiconductor layer SACT. For example, the first semiconductor layer SAC may include a channel region, a source region and a drain region on two opposite sides of the channel region of each of the driving transistor T1, the switching transistor T2, the compensation transistor T3, the initialization transistor T4, the operation control transistor T5, the emission control transistor T6, and the electrode initialization transistor T7.

The first gate insulating layer may cover the first semiconductor layer SACT and be disposed on the substrate 100. The first gate insulating layer may include an insulating material. For example, the first gate insulating layer may include silicon oxide, silicon nitride, silicon oxynitride, or aluminum oxide.

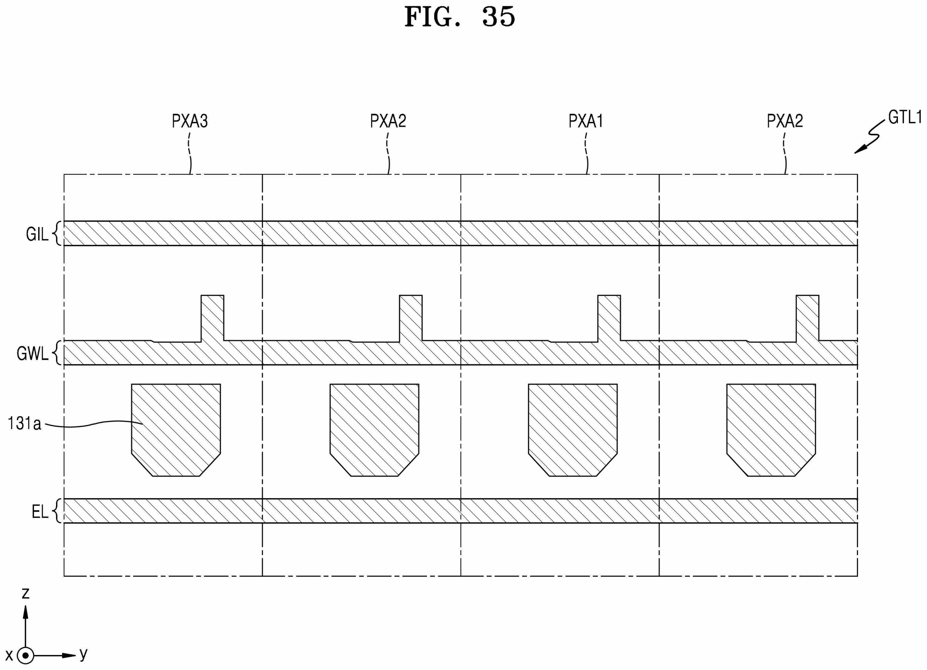

As shown in FIG. 35, the first gate layer GTL1 may be disposed on the first gate insulating layer. The first gate layer GTL1 may include the first scan line GWL transferring a first scan signal GW, the third scan line GIL transferring an initialization scan signal GI to the initialization transistor T4, the emission control line EL transferring an emission control signal EM to the operation control transistor T5 and the emission control transistor T6, and the driving gate electrode 131a of the driving transistor T1 having an isolated shape. The driving gate electrode 131a may also serve as a lower electrode, which is the first electrode of the capacitor Cst. A material and a layered structure of the first gate layer GTL1 are the same as those described above.

The first scan line GWL, the third scan line GIL, and the emission control line EL may have a shape extending in the first direction (e.g., x-axis direction). Portions of the first semiconductor layer SACT overlapping the first scan line GWL, the third scan line GIL, and the emission control line EL may serve as gate electrodes of the transistors. For example, a portion of the first scan line GWL overlapping the first semiconductor layer SACT may be a switching gate electrode of the switching transistor T2 and a compensation gate electrode of the compensation transistor T3, a portion of the third scan line GIL overlapping the first semiconductor layer SACT may be an initialization gate electrode of the initialization transistor T4 and an electrode initialization gate electrode of the electrode initialization transistor T7, and a portion of the emission control line EL overlapping the first semiconductor layer SACT may be an operation control gate electrode of the operation control transistor T5 and the emission control gate electrode of the emission control transistor T6.

For reference, the first scan line GWL extending in the first direction (e.g., x-axis direction) has a protrusion portion protruding in the second direction (e.g., y-axis direction) and overlaps twice the first semiconductor layer SACT at a portion corresponding to the compensation transistor T3. Accordingly, the compensation transistor T3 may be a double-gate transistor having two channel regions. Because the first semiconductor layer SACT has a curved shape, the third scan line GIL extending in the first direction (e.g., x-axis direction) overlaps twice the first semiconductor layer SACT at a portion corresponding to the initialization transistor T4. Accordingly, the initialization transistor T4 may be also a double-gate transistor having two channel regions.

The second gate insulating layer may be disposed on the first gate insulating layer to cover the first gate layer GTL1. The second gate insulating layer may include an insulating material equal/similar to an insulating material of the first gate insulating layer.

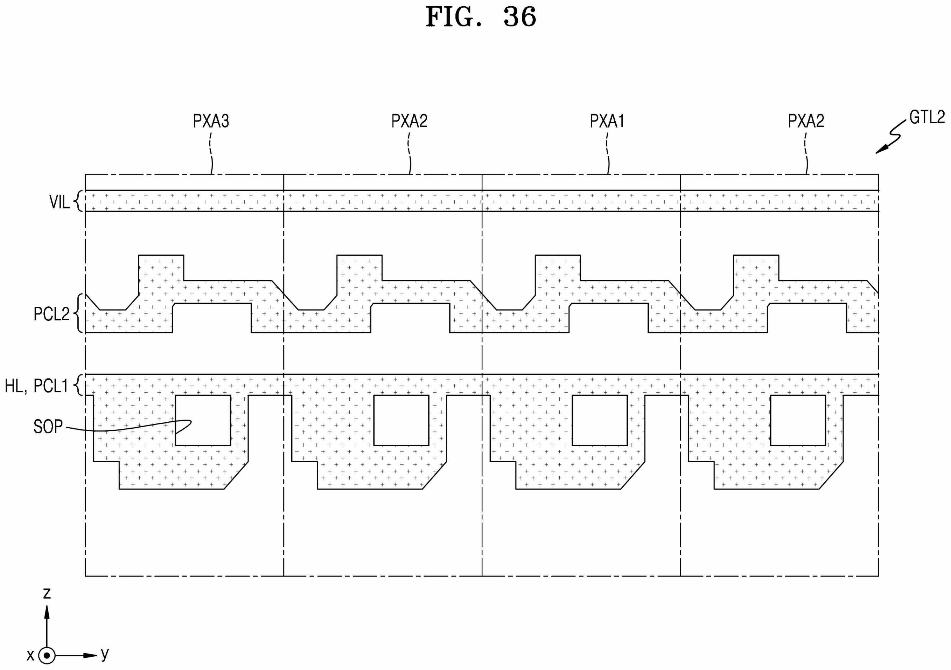

As shown in FIG. 36, the second gate layer GTL2 may be disposed on the first gate insulating layer. The second gate layer GTL2 may include the electrode voltage line HL which may be the first connection line PCL1, the second connection line PCL2, and the initialization voltage line VIL. The electrode voltage line HL, the second connection line PCL2, and the initialization voltage line VIL may extend in the first direction (e.g., x-axis direction). A material and a layered structure of the second gate layer GTL2 are the same as those described above.

A portion of the electrode voltage line HL is an upper electrode, which is a second electrode of the capacitor Cst, and may overlap the driving gate electrode 131a, which is the lower electrode of the capacitor Cst. Upper electrodes of the capacitors Cst of the pixel circuits in the same row may be integrally formed as a single body extending in the first direction (e.g., x-axis direction) by the electrode voltage line HL. Accordingly, the electrode voltage line HL may be the second connection line PCL2. As described below, the first driving voltage ELVDD1 may be applied to the electrode voltage line HL. For example, the first driving voltage ELVDD1 may be applied to the upper electrode of the capacitor Cst. The opening SOP may be formed in the upper electrode of the capacitor Cst, and at least a portion of the driving gate electrode 131a may overlap the opening.

As described below, the second driving voltage ELVDD2 may be applied to the second connection line PCL2. The initialization voltage line VIL may transfer the initialization voltage Vint.

The first interlayer insulating layer may cover the second gate layer GTL2 and be disposed on the second gate insulating layer. The first interlayer insulating layer may include an insulating material. For example, the first interlayer insulating layer may include silicon oxide, silicon nitride, silicon oxynitride, or aluminum oxide.

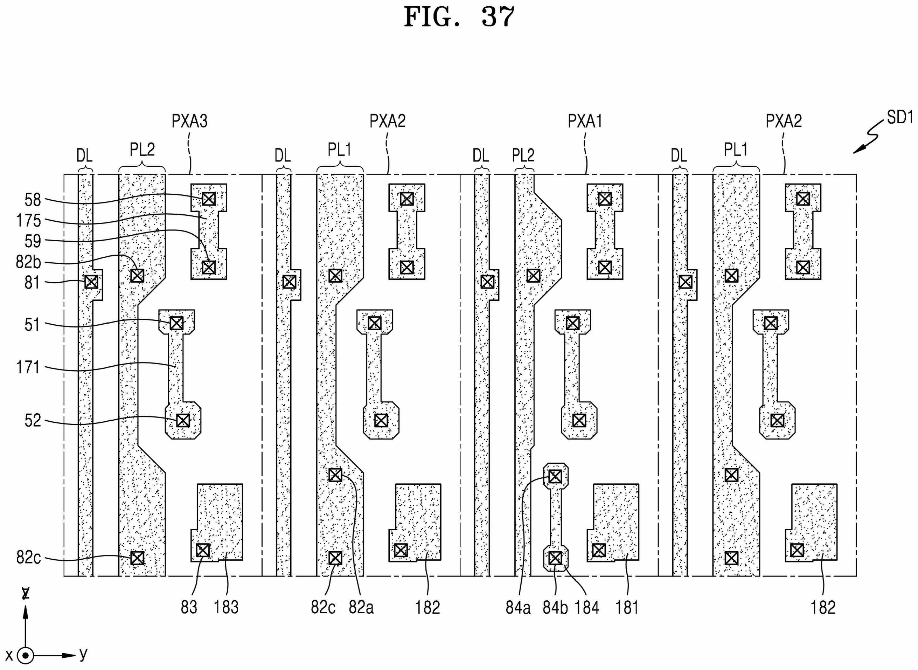

The first source-drain layer SD1 shown in FIG. 37 may be disposed on the first interlayer insulating layer. The first source-drain layer SD1 may include the data line DL, the first driving voltage line PL1, the second driving voltage line PL2, and the connection electrodes 171, 175, 181, and 183. The data line DL, the first driving voltage line PL1, and the second driving voltage line PL2, may have a shape extending in the second direction (e.g., y-axis direction). The connection electrodes 171, 175, 181, 182, 183, and 184 may have an isolated shape. A material and a layered structure of the first source-drain layer SD1 may be the same as those described above.

The data line DL may be electrically connected to a source region of the switching transistor T2 through the contact hole 81 passing through the insulating layers thereunder.

In the second pixel area PXA2 in a second area and the second pixel area PXA2 in the fourth area among the third pixel area PXA3, the second pixel area PXA2, the first pixel area PXA1, and the second pixel area PXA2 sequentially arranged in the first direction (e.g., x-axis direction), the first driving voltage line PL1 extending in the second direction (e.g., y-axis direction) may be electrically connected to the electrode voltage line HL, which is the first connection line PCL1, included in the second gate layer GTL2 in the second pixel area PXA2 and extending in the first direction (e.g., x-axis direction) through the contact hole 82a passing through the first interlayer insulating layer thereunder. Accordingly, the first driving voltage lines PL1 and the electrode voltage lines HL electrically connected to each other may have (or entirely have) a mesh structure. Accordingly, a voltage drop (IR drop) of the first driving voltage ELVDD1 in the display area DA may be prevented or reduced.

In the third pixel area PXA3 and the first pixel area PXA1, the second driving voltage line PL2 extending in the second direction (e.g., y-axis direction) may be electrically connected to the second connection line PCL2 included in the second gate layer GTL2 and extending in the first direction (e.g., x-axis direction) in the third pixel area PXA3 through the contact hole 82a passing through the first interlayer insulating layer thereunder. Accordingly, the second driving voltage lines PL2 and the second connection lines PCL2 electrically connected to each other may have (or entirely have) a mesh structure. Accordingly, a voltage drop (IR drop) of the second driving voltage ELVDD2 in the display area DA may be prevented or reduced.

In the second pixel area PXA2, the first driving voltage line PL1 may be electrically connected to the emission control transistor T6 in the second pixel area PXA2 through a contact hole 82c formed in the insulating layers thereunder. Accordingly, the first driving voltage ELVDD1 may be applied to the emission control transistor T6 in the second pixel area PXA2. Because the second driving voltage line PL2 instead of the first driving voltage line PL1 passes across the first pixel area PXA1, the emission control transistor T6 in the first pixel area PXA1 may not be connected to the second driving voltage line PL2. Instead, the connection electrode 184 in the first pixel area PXA1 electrically may connect the first driving voltage line PL1 to the emission control transistor T6 in the first pixel area PXA1. For example, one end of the connection electrode 184 in the first pixel area PXA1 may be electrically connected to the electrode voltage line HL, which is the first connection line PCL1, through the contact hole 84a passing through the first interlayer insulating layer thereunder, and another end may be electrically connected to the emission control transistor T6 in the first pixel area PXA1 through the contact hole 84b formed in the insulating layers thereunder. Accordingly, the first driving voltage ELVDD1 may be applied to the emission control transistor T6 in the first pixel area PXA1. For this purpose, as shown in FIG. 34, a portion of the first semiconductor layer SACT corresponding to the emission control transistor T6 in the first pixel area PXA1 may protrude more in the +x direction than a portion of the first semiconductor layer SACT corresponding to the emission control transistor T6 in another pixel area.

In the third pixel area PXA3, the second driving voltage line PL2 may be electrically connected to the emission control transistor T6 in the third pixel area PXA3 through a contact hole 82c formed in the insulating layers thereunder. Accordingly, the second driving voltage ELVDD2 may be applied to the emission control transistor T6 in the third pixel area PXA3.

One end of the connection electrode 171 may be electrically connected to the first semiconductor layer SACT by being in contact with the first semiconductor layer SACT through the contact hole 51. For example, one end of the connection electrode 171 may be electrically connected to the compensation transistor T3 and the initialization transistor T4 through the contact hole 51 passing through the insulating layers thereunder. Another end of the connection electrode 171 may be electrically connected to the driving gate electrode 131a of the driving transistor T1 also serving as the lower electrode of the capacitor Cst through the contact hole 52 passing through the insulating layers thereunder. The contact hole 52 may pass through the opening SOP of the upper electrode of the capacitor Cst.

The connection electrode 175 may be electrically connected to the initialization voltage line VIL through the contact hole 58 passing through the first interlayer insulating layer thereunder. The connection electrode 175 may be electrically connected to the first semiconductor layer SACT by being in contact with the first semiconductor layer SACT through the contact hole 59 passing through the insulating layers thereunder. For example, the connection electrode 175 may be electrically connected to the initialization transistor T4 and the electrode initialization transistor T7 through the contact hole 59 passing through the insulating layers thereunder.

Each of the connection electrode 181 in the first pixel area PXA1, the connection electrode 182 in the second pixel area PXA2, and the connection electrode 183 in the third pixel area PXA3 may be electrically connected to a drain region of the emission control transistor T6 through the contact hole 83 passing through the insulating layers thereunder.

The first planarization insulating layer may be disposed on the first interlayer insulating layer to cover the first source-drain layer SD1. A material that may be included by the first planarization insulating layer is the same as that described above.

As shown in FIG. 38, the pixel electrode layer PXL may be disposed on the first planarization insulating layer. The pixel electrode layer PXL may include multiple pixel electrodes. FIG. 38 shows the first pixel electrode PE1 of the first pixel PX1, the second pixel electrode PE2 of the second pixel PX2, and the third pixel electrode PE3 of the third pixel PX3. Each of the first pixel electrode PE1, the second pixel electrode PE2, and the third pixel electrode PE3 may include the first area PEA1 (see FIG. 9) and the second area PEA2 surrounding the first area PEA1. A material and a layered structure that may be included by the pixel electrode layer PXL are the same as those described above.

The first pixel electrode PE1 may be electrically connected to the connection electrode 181 included in the first source-drain layer SD1 through the contact hole 91 passing through the first planarization insulating layer. Accordingly, the first pixel electrode PE1 may be electrically connected to the driving transistor T1 to which the first driving voltage ELVDD1 is applied through the emission control transistor T6 in the first pixel area PXA1. The contact hole 91 may be disposed to correspond to the second area of the first pixel electrode PE1.

The second pixel electrode PE2 may be electrically connected to the connection electrode 182 included in the first source-drain layer SD1 through the contact hole 92 passing through the first planarization insulating layer. Accordingly, the second pixel electrode PE2 may be electrically connected to the driving transistor T1 to which the first driving voltage ELVDD1 is applied through the emission control transistor T6 in the second pixel area PXA2. The contact hole 92 may be disposed to correspond to the second area of the second pixel electrode PE2.

The third pixel electrode PE3 may be electrically connected to the connection electrode 183 included in the first source-drain layer SD1 through the contact hole 93 passing through the first planarization insulating layer. Accordingly, the third pixel electrode PE3 may be electrically connected to the driving transistor T1 to which the second driving voltage ELVDD2 is applied through the emission control transistor T6 in the third pixel area PXA3. The contact hole 93 may be disposed to correspond to the second area of the third pixel electrode PE3.

Descriptions of the pixel-defining layer, the emission layer, the common electrode CAT, and the like are the same as those described above.

The invention is applicable to various pixel circuits in addition to the pixel circuit described up to this point.

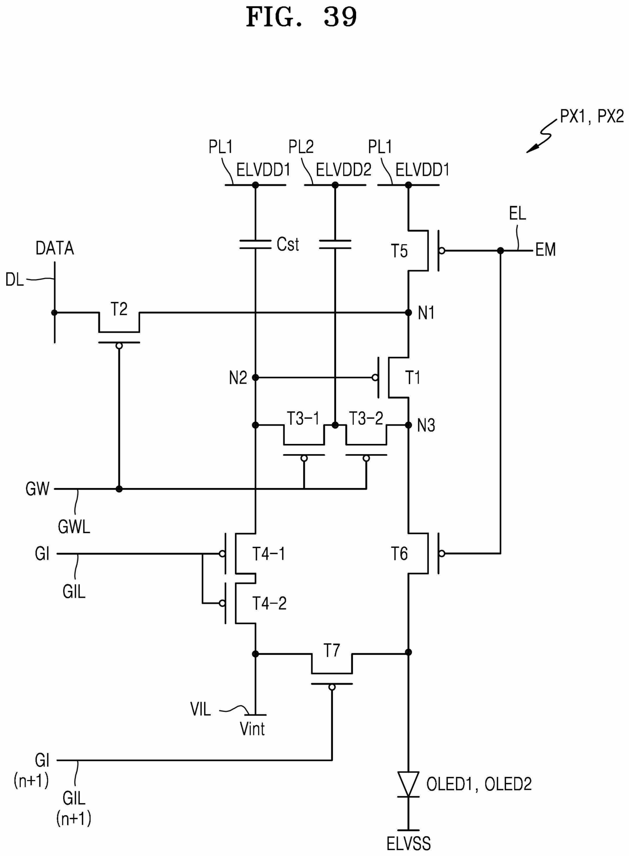

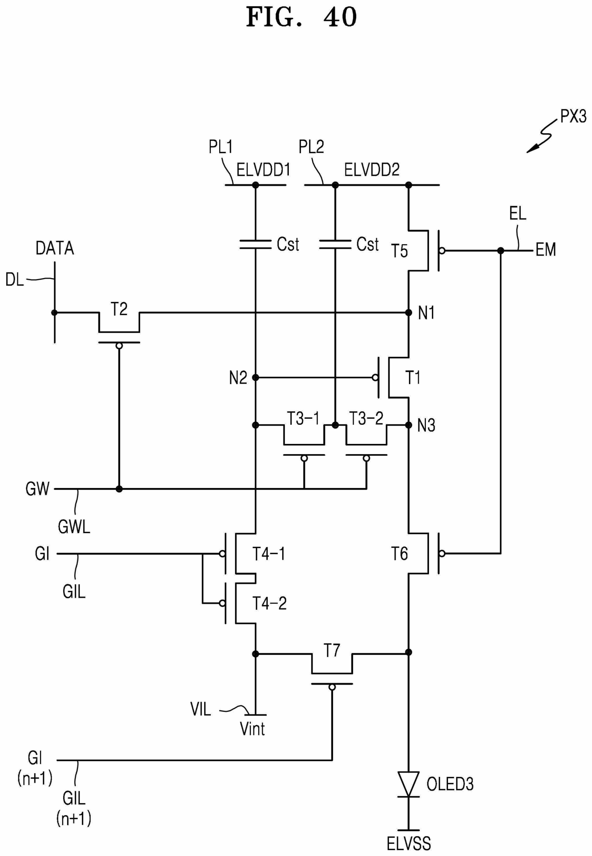

For example, as shown in FIGS. 39 and 40, which illustrate that the pixel circuits may be electrically connected to the light-emitting elements included by the display panel 10 and the electronic apparatus 1 including the same according to an embodiment, the pixel circuit in the third pixel PX3 as well as the pixel circuit in the first pixel PX1 and the pixel circuit in the second pixel PX2 may be electrically connected to the second driving voltage line PL2. For example, unlike FIG. 31, in the pixel circuit in the first pixel PX1 and the pixel circuit in the second pixel PX2, the second driving voltage line PL2 may overlap a portion between two gate electrodes of the compensation transistor T3, which has a dual gate structure, to form a transistor.

For example, as described above with reference to FIG. 31, in the pixel circuit in the first pixel PX1 and the pixel circuit in the second pixel PX2, the operation control transistor T5 may be electrically connected to the first driving voltage line PL1. Unlike this, as shown in FIG. 40, in the pixel circuit in the third pixel PX3, the second driving voltage line PL2 may overlap a portion between two gate electrodes of the compensation transistor T3, which has a dual gate structure, to form a transistor, and simultaneously, be electrically connected to the operation control transistor T5 of the pixel circuit in the third pixel PX3. Through this, an electrical potential between the third pixel electrode PE3 of the third light-emitting element OLED3 and the common electrode CAT may be adjusted to be different from an electrical potential between the first pixel electrode PE1 of the first light-emitting element OLED1 and the common electrode CAT, and an electrical potential between the second pixel electrode PE2 of the second light-emitting element OLED2 and the common electrode CAT.

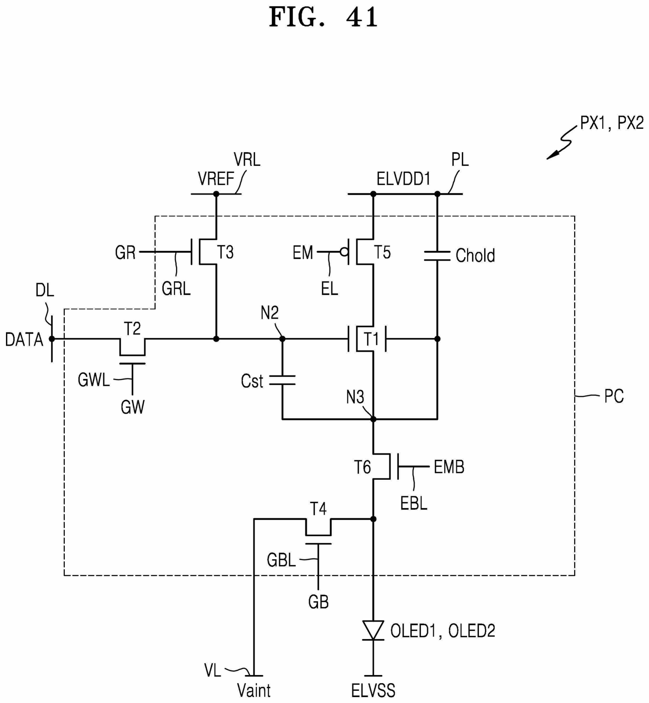

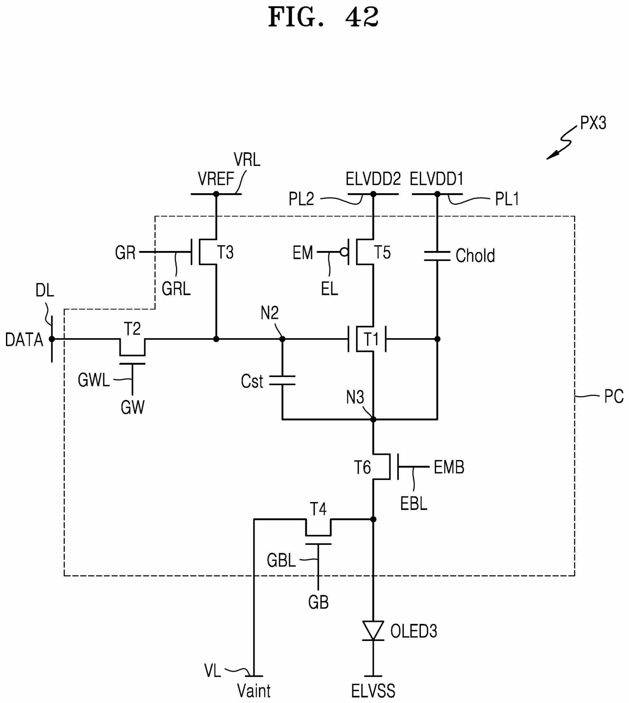

FIGS. 41 and 42 are pixel circuits PC that may be electrically connected to the light-emitting elements included in the display panel 10 and the electronic apparatus 1 including the same according to an embodiment. It is shown in FIGS. 41 and 42 that the pixel circuit PC includes the driving transistor T1, the switching transistor T2, the initialization transistor T3, the initialization transistor T4, the operation control transistor T5, the emission control transistor T6, the storage capacitor Cst, and a hold capacitor Chold. It is shown in FIGS. 41 and 42 that the operation control transistor T5 is a p-channel metal oxide semiconductor field-effect transistors (MOSFET), and the rest are n-channel metal oxide semiconductor field-effect transistors (MOSFETs).

The initialization transistor T3 may be electrically connected between a reference voltage line VRL and the second node N2 corresponding to the driving gate electrode of the driving transistor T1. The initialization transistor T3 may be turned on according to a reference signal GR transferred through a reference gate line GRL, and may transfer a reference voltage VREF from the reference voltage line VRL to the second node, thereby initializing an electrical potential of the driving gate electrode of the driving transistor T1.

The initialization transistor T4 may correspond to the electrode initialization transistor T8 of FIG. 12, and one of a source region and a drain region of the initialization transistor T4 may be electrically connected to the electrode initialization voltage line VL providing an electrode initialization voltage Vaint, and another may be electrically connected to the pixel electrode of the first light-emitting element OLED1 and/or the second light-emitting element OLED2.

The storage capacitor Cst may be electrically connected between the second node N2 corresponding to the driving gate electrode of the driving transistor T1 and the third node N3 corresponding to a portion of the source region and the drain region of the driving transistor T1 that is connected to the emission control transistor T6. For example, the pixel circuit PC shown in FIG. 41 may be a source follower type circuit. The storage capacitor Cst may store a threshold voltage of the driving transistor T1 and a voltage corresponding to a data signal DATA.

The hold capacitor Chold may be connected between the first driving voltage line PL1 and the third node N3. The hold capacitor Chold may ensure that a voltage of the third node N3 of the driving transistor T1 does not fluctuate and has a constant voltage in case that a surrounding signal fluctuates.

The driving transistor T1, the switching transistor T2, and the operation control transistor T5 are the same as those described above. However, the emission control transistor T6 may be an n-channel MOSFETs (NMOS). The emission control transistor T6 may be turned on according to an inverted emission control signal EMB supplied from an inverted emission control line EBL.

For example, in the pixel circuit in the first pixel PX1 and the pixel circuit in the second pixel PX2, the operation control transistor T5 may be electrically connected to the first driving voltage line PL1. Unlike this, in the pixel circuit in the third pixel PX3, the operation control transistor T5 may be electrically connected to the second driving voltage line PL2. Through this, an electrical potential between the third pixel electrode PE3 of the third light-emitting element OLED3 and the common electrode CAT may be adjusted to be different from an electrical potential between the first pixel electrode PE1 of the first light-emitting element OLED1 and the common electrode CAT, and an electrical potential between the second pixel electrode PE2 of the second light-emitting element OLED2 and the common electrode CAT.

According to an embodiment, the display panel that may display high-quality images and the electronic apparatus including the same may be implemented. However, the scope of the invention is not limited by this effect.

It should be understood that embodiments described herein should be considered in a descriptive sense only and not for purposes of limitation. Descriptions of features or aspects in each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display panel (10) comprising:
first driving voltage lines (PL1) and second driving voltage lines (PL2) alternately arranged in a first direction in a display area (DA) and extending in a second direction intersecting the first direction;
first-color pixel circuits and third-color pixel circuits alternately arranged along the second driving voltage lines (PL2); and
second-color pixel circuits arranged along the first driving voltage lines (PL1),
wherein the first-color pixel circuits and the second-color pixel circuits are electrically connected to the first driving voltage lines (PL1), and the third-color pixel circuits are electrically connected to the second driving voltage lines (PL2).

2. The display panel (10) of claim 1, wherein an electrical potential of a second driving voltage supplied through the second driving voltage lines (PL2) is different from an electrical potential of a first driving voltage supplied through the first driving voltage lines (PL1).

3. The display panel (10) of claim 1, wherein an electrical potential of a second driving voltage supplied through the second driving voltage lines (PL2) is greater than an electrical potential of a first driving voltage supplied through the first driving voltage lines (PL1).

4. The display panel (10) of at least one of claims 1 to 3, wherein each of the first-color pixel circuits is electrically connected to a corresponding one of the first driving voltage lines (PL1) through an adjacent one of the second-color pixel circuits disposed in a same row.

5. The display panel (10) of at least one of claims 1 to 4, wherein a set including pixel circuits arranged in the first direction in an order of a third-color pixel circuit, a second-color pixel circuit, a first-color pixel circuit, and a second-color pixel circuit is repeatedly arranged in the first direction, and
the first-color pixel circuit in the set is electrically connected to a corresponding one of the first driving voltage lines (PL1) through the second-color pixel circuit disposed in an opposite side of the third-color pixel circuit with respect to the first-color pixel circuit in the set.

6. The display panel (10) of at least one of claims 1 to 5, wherein emission control transistors (T6) of the first-color pixel circuits and emission control transistors (T6) of the second-color pixel circuits are electrically connected to the first driving voltage lines (PL1), and emission control transistors (T5) of the third-color pixel circuits are electrically connected to the second driving voltage lines (PL2).

7. The display panel (10) of at least one of claims 1 to 6, wherein an emission control transistor (T6) of each of the first-color pixel circuits is electrically connected to an adjacent one of the second-color pixel circuits disposed in a same row, and accordingly, electrically connected to a corresponding one of the first driving voltage lines (PL1).

8. The display panel (10) of at least one of claims 1 to 7, wherein a set including pixel circuits arranged in the first direction in an order of a third-color pixel circuit, a second-color pixel circuit, a first-color pixel circuit, and a second-color pixel circuit is repeatedly arranged in the first direction, and
wherein an emission control transistor (T6) of the first-color pixel circuit in the set is electrically connected to an emission control transistor (T6) of the second-color pixel circuit disposed in an opposite side of the third-color pixel circuit with respect to the first-color pixel circuit in the set, and accordingly, electrically connected to a corresponding one of the first driving voltage lines (PL1).

9. The display panel (10) of at least one of claims 1 to 8, wherein driving transistors (T1) of the first-color pixel circuits and driving transistors (T1) of the second-color pixel circuits are electrically connected to the first driving voltage lines (PL1), and driving transistors (T1) of the third-color pixel circuits are electrically connected to the second driving voltage lines (PL2).

10. The display panel (10) of at least one of claims 1 to 9, wherein a driving transistor (T1) of each of the first-color pixel circuits is electrically connected to a driving transistor (T1) of an adjacent one of the second-color pixel circuits disposed in a same row, and accordingly, electrically connected to a corresponding one of the first driving voltage lines (PL1).

11. The display panel (10) of at least one of claims 1 to 10, wherein a set including pixel circuits arranged in the first direction in an order of a third-color pixel circuit, a second-color pixel circuit, a first-color pixel circuit, and a second-color pixel circuit is repeatedly arranged in the first direction, and
a driving transistor (T1) of the first-color pixel circuit in the set is electrically connected to a driving transistor (T1) of the second-color pixel circuit disposed in an opposite side of the third-color pixel circuit with respect to the first-color pixel circuit in the set, and accordingly, electrically connected to a corresponding one of the first driving voltage lines (PL1).

12. The display panel (10) of at least one of claims 1 to 11, further comprising
first connection lines (PCL1) and second connection lines (PCL2) alternately arranged in the second direction and extending in the first direction,
wherein each of the first connection lines (PCL1) is electrically connected to the first driving voltage lines (PL1), and each of the second connection lines (PCL2) is electrically connected to the second driving voltage lines (PL2), and
the first connection lines (PCL1) and the second connection lines (PCL2) are disposed over the first driving voltage lines (PL1) and the second driving voltage lines (PL2).

13. The display panel (10) of claim 12, wherein each of the first connection lines (PCL1) has sets repeatedly arranged in the first direction, wherein each of the sets includes extension portions arranged in the first direction in an order of a first extension portion corresponding to a first-color pixel electrode (PE1), a second extension portion corresponding to a second-color pixel electrode (PE2), a third extension portion corresponding to a third-color pixel electrode (PE3), and a second extension portion corresponding to a second-color pixel electrode (PE2), and
each of the second connection lines (PCL2) has sets repeatedly arranged in the first direction, wherein each of the sets includes extension portions disposed in the first direction in an order of a third extension portion corresponding to a third-color pixel electrode (PE3), a second extension portion corresponding to a second-color pixel electrode (PE2), a first extension portion corresponding to a first-color pixel electrode (PE1), and a second extension portion corresponding to a second-color pixel electrode (PE2).

14. The display panel (10) of claim 12 or 13, wherein the first connection lines (PCL1) and the second connection lines (PCL2) are disposed below the first driving voltage lines (PL1) and the second driving voltage lines (PL2).

15. The display panel (10) of at least one of claims 1 to 14, wherein each of the third-color pixel circuits includes:
an initialization transistor (T8) having one end electrically connected to a pixel electrode; and
a connection electrode (161) electrically connecting another end of the initialization transistor (T8) to an initialization voltage line (VL2) and disposed below the first connection lines (PCL1) and the second connection lines (PCL2).

16. The display panel (10) of at least one of claims 1 to 15, wherein each of the first-color pixel circuits is electrically connected to a corresponding one of the first connection lines (PCL1).

17. The display panel (10) of at least one of claims 1 to 16, wherein each of the first-color pixel circuits includes an emission control transistor (T6) and a connection electrode (183) electrically connecting the emission control transistor (T6) to a corresponding one of the first connection lines (PCL1), and
the connection electrode (183), the first driving voltage lines (PL1), and the second driving voltage lines (PL2) are disposed on a same layer.

18. The display panel (10) of at least one of claims 1 to 17, further comprising:
a first-color pixel electrode (PE1) electrically connected to each of the first-color pixel circuits;
a second-color pixel electrode (PE2) electrically connected to each of the second-color pixel circuits;
a third-color pixel electrode (PE3) electrically connected to each of the third-color pixel circuits; and
a common electrode (CAT) disposed over a first-color electrode, a second-color electrode, and a third-color electrode, the common electrode (CAT) being integrally formed as a single body,
wherein a first-color emission layer (331) is disposed between the first-color pixel electrode (PE1) and the common electrode (CAT), a second-color emission layer (332) is disposed between the second-color pixel electrode (PE2) and the common electrode (CAT), and a plurality of third-color emission layers (333) and a charge generation layer (341, 343) disposed between the plurality of third-color emission layers (333) are disposed between the third-color pixel electrode (PE3) and a common layer.

19. A display panel (10) comprising:
a light-emitting diode (LED);
a first driving voltage line (PL1) transferring a first driving voltage;
a second driving voltage line (PL2) transferring a second driving voltage which is different from the first driving voltage;
a storage capacitor (Cst) including a first capacitor electrode and a second capacitor electrode, the second capacitor electrode being electrically connected to the first driving voltage line (PL1); and
a driving transistor (T1) controlling an amount of driving current flowing to the light-emitting diode (LED) from a first node (N1) electrically connected to the second driving voltage line (PL2), in response to a voltage applied to a second node (N2) electrically connected to the first capacitor electrode.

20. An electronic apparatus (1) comprising:
the display panel (10) of at least one of claims 1 to 19; and
a lower cover (90) forming an exterior of the electronic apparatus (1) and having an opening exposing a portion of the display panel (10).
